(19) **Europäisches Patentamt**
**European Patent Office**
**Office européen des brevets**

(11) **EP 4 528 377 A1**

(12) **EUROPEAN PATENT APPLICATION**
published in accordance with Art. 153(4) EPC

(43) Date of publication:
**26.03.2025 Bulletin 2025/13**

(21) Application number: **23807523.8**

(22) Date of filing: **10.05.2023**

(51) International Patent Classification (IPC):
*G03F 7/004* (2006.01)          *B41C 1/00* (2006.01)
*B41M 1/04* (2006.01)          *B41N 1/00* (2006.01)
*G03F 7/032* (2006.01)

(52) Cooperative Patent Classification (CPC):
**B41C 1/00; B41M 1/04; B41N 1/00; G03F 7/004;
G03F 7/032**

(86) International application number:
**PCT/JP2023/017607**

(87) International publication number:
**WO 2023/223919 (23.11.2023 Gazette 2023/47)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **18.05.2022 JP 2022081755**

(71) Applicant: **Asahi Kasei Kabushiki Kaisha
Tokyo 1000006 (JP)**

(72) Inventors:
• **TOYOOKA, Sota**
  **Tokyo 100-0006 (JP)**
• **SAITO, Hideo**
  **Tokyo 100-0006 (JP)**
• **SUEZAKI, Masahiro**
  **Tokyo 100-0006 (JP)**

(74) Representative: **Strehl & Partner mbB
Maximilianstrasse 54
80538 München (DE)**

(54) **PHOTOSENSITIVE RESIN COMPOSITION, FLEXOGRAPHIC PRINTING ORIGINAL PLATE,
AND METHOD FOR PRODUCING FLEXOGRAPHIC PRINTING PLATE**

(57)    The present disclosure provides a flexographic printing plate containing at least: a support; and a relief layer sequentially stacked, wherein in dynamic elasticity mapping measurement by AFM on a cross section obtained by cutting 1 $\mu$m from a surface layer of a face on the side opposite to a face where the relief layer is in contact with the support,
the cross section has at least: a region (A1) having a storage modulus of 100 MPa or more and 500 MPa or less at a frequency of 2,000 Hz; and a region (B1) having a storage modulus of 3 MPa or more and 15 MPa or less at a frequency of 2,000 Hz.

[Figure 8]

EP 4 528 377 A1

10

13 — 14
12
11

Back exposure step S1

13 — 14
12a — 12
11

UV

Infrared irradiation step S2

14a
13 — 12
12a — 11

UV

Pattern exposure step S3

14a
13 — 12a
11

100

Development step S4

12a — 11

**Description**

Technical Field

The present invention relates to a photosensitive resin composition, a flexographic printing raw plate and a manufacturing method of a flexographic printing plate.

Background Art

Flexographic printing is one type of letterpress printing and is advantageously applicable to various printing objects as soft materials such as rubber and synthetic resin are used for printing plates.

Manufacturing of a flexographic printing plate is carried out in the following manner, for example. Firstly, a uniform cured layer is formed by performing back exposure in which the entire surface of a photosensitive resin composition layer is irradiated with ultraviolet light through a substrate of a film of PET resin or the like. Then, relief exposure in which the photosensitive resin composition layer is selectively irradiated with ultraviolet light through an arbitrary negative pattern is performed. Thereafter, the unexposed part (that is, the part not photocured) of the photosensitive resin composition layer is dissolved or swollen in a developer and removed by the application of external force with a brush or the like to form a relief image, which is a desired image, and a flexographic printing plate is thus obtained.

There is a recent movement to reduce use of organic solvents in view of improvement in working environment or protection of global environment. Hence, a developer containing water as a main component (water developer) is increasingly used for removing the uncured part in the manufacturing step of the flexographic printing plate mentioned above. A water development plate that forms relief images is thereby increasingly used.

Examples of the base material for flexographic printing include plastic packages such as packaging films, and paper packages such as paperware and cardboard. Among them, there is a growing demand for paper packages in response to an escalating global plastic-free movement.

However, a problem of printing on a paper package having rough surface is that ink is difficult to fix thereon due to a concave-convex shape on the print side, as compared with other base materials. A method of using a plate having low hardness, and elevating a printing pressure so that ink is allowed to follow the concave-convex shape on the print side to thereby improve ink lay down is generally used as one method for improving ink lay down.

However, formation of the plate having low hardness requires keeping the degree of resin cross-linking low and might therefore impair the mechanical characteristics of the flexographic printing plate. Furthermore, the elevated printing pressure applies strong stress to the flexographic printing plate. As a result, poor printing might occur due to collapse or chipping of a micropattern such as halftone.

In this respect, for example, Patent Literature 1 has proposed a technique of achieving both ink lay down of a solid pattern and halftone quality by adjusting a composite elastic modulus of a halftone part and a solid part.

Patent Literature 2 has proposed a technique of achieving both ink lay down of a solid pattern and halftone quality by preparing a hard layer and a soft layer as a multilayer structure.

Meanwhile, as for techniques of improving wear resistance by use of a resin composition that permits water development, for example, Patent Literature 3 has proposed a flexographic printing raw plate containing a water-dispersion latex, an elastomer, a polymerizable unsaturated monomer, and a photopolymerization initiator, wherein the water-dispersion latex is finely dispersed in a resin composition.

Patent Literature 4 has proposed a technique of suppressing relief chipping by containing a water-dispersion latex, a millable rubber, a surfactant, a photopolymerizable compound, and a photopolymerization initiator, and focusing on the structure of the photopolymerizable compound.

Citation List

Patent Literature

Patent Literature 1: WO2021/039106
Patent Literature 2: WO2017/135118
Patent Literature 3: WO2017/057086
Patent Literature 4: WO2019/130784

Summary of Invention

Technical Problem

The composite elastic modulus described in Patent Literature 1 is an elastic modulus measured at room temperature and therefore, is not regarded as a parameter in line with actual printing conditions. Hence, wear resistance is not sufficient for printing under a printing pressure.

Since the printing plate described in Patent Literature 2 has a multilayer structure, chipping might occur in the printing plate due to delamination. Furthermore, another problem of the multilayer structure is high cost.

For the flexographic printing raw plate described in Patent Literature 3, wear resistance is improved by dispersing a phase containing a water-dispersion latex and a phase containing an elastomer. However, both the phase containing a water-dispersion latex and the phase containing an elastomer are highly flexible and are therefore influenced by a printing pressure so that halftone collapses easily.

The flexographic printing raw plate described in Patent Literature 4 has low following properties for a concave-convex base material such as a paper package and is not suitable for printing on a paper package, because a photocured product has high Shore A hardness.

Therefore, giving consideration to the problems in conventional techniques, the present invention aims at providing a flexographic printing plate and a flexographic printing raw plate that permit printing with good ink lay down even on a paper package and can achieve stable quality even under a printing pressure, manufacturing methods of the flexographic printing plate and the flexographic printing raw plate, and a printing method using the flexographic printing plate.

Solution to Problem

The present inventors have made intensive studies to solve the above-described problems, and as a result, found that the problems can be solved by a flexographic printing plate, wherein in dynamic elasticity mapping measurement by atomic force microscope (hereinafter, also referred to as AFM) for a surface layer of a relief layer, having at least a region (A1) having a storage modulus of 100 MPa or more and 500 MPa or less at 2,000 Hz, and a region (B1) having a storage modulus of 3 MPa or more and 15 MPa or less at 2,000 Hz; thus, the present invention has been accomplished.

Specifically, the present invention is as follows.

[1] A flexographic printing plate

comprising at least: a support; and a relief layer sequentially stacked, wherein in dynamic elasticity mapping measurement by AFM on a cross section obtained by cutting 1 $\mu$m from a surface layer of a face on the side opposite to a face where the relief layer is in contact with the support,
the cross section has at least:

a region (A1) having a storage modulus of 100 MPa or more and 500 MPa or less at a frequency of 2,000 Hz; and
a region (B1) having a storage modulus of 3 MPa or more and 15 MPa or less at a frequency of 2,000 Hz.

[2] The flexographic printing plate according to [1], wherein

an area ratio of the region (A1) is 3 area% or more and 3 area% or less based on the total area of the cross section, and
an area ratio of the region (B1) is 35 area% or more and 65% area% or less based on the total area of the cross section.

[3] The flexographic printing plate according to [1] or [2], wherein

in a region (a1) obtained by subjecting the region (A1) to opening treatment by morphological operation,
a ratio (a1'/a1) of an area of a region (a1') that is constituted by data on continuously adjacent pixels and has an area of 0.1 $\mu$m$^2$ or larger and 10 $\mu$m$^2$ or smaller per region to an area of the region (a1) is 90 area% or more and 100 area% or less.

[4] The flexographic printing plate according to any of [1] to [3], wherein

a ratio (A1/B1) of the area ratio of the region (A1) to the area ratio of the region (B1) is 0.1 or more and 0.8 or less.

[5] The flexographic printing plate according to any of [1] to [4], wherein

in the region (A1),
a ratio (A1'/A1) of an area of a region (A1') having a storage modulus of 100 MPa or more and 250 MPa or less at a frequency of 2,000 Hz to an area of the region (A1) is 50 area% or more and 100 area% or less.

[6] The flexographic printing plate according to any of [1] to [5], wherein

in the region (B1),
a ratio (B1'/B1) of an area of a region (B1') having a storage modulus of 10 MPa or more and 15 MPa or less at a frequency of 2,000 Hz to an area of the region (B1) is 50 area% or more and 100 area% or less.

[7] The flexographic printing plate according to any of [1] to [6], wherein

an average loss modulus at a frequency of 2,000 Hz in the region (A1) is 50 MPa or more and 250 MPa or less;
tanδ ([average loss modulus] / [average storage modulus]) of the region (A1) at the frequency is 0.5 or more and 0.8 or less;
an average loss modulus at a frequency of 2,000 Hz in the region (B1) is 2 MPa or more and 10 MPa or less; and
tanδ ([average loss modulus] / [average storage modulus]) of the region (B1) at the frequency is 0.4 or more and 0.7 or less.

[8] The flexographic printing plate according to any of [1] to [7], wherein in the dynamic elasticity mapping measurement by AFM, the flexographic printing plate, further having

a region (C1) having a storage modulus of more than 15 MPa and less than 100 MPa at a frequency of 2,000 Hz, and
an area ratio of the region (C1) is 25 area% or more and 55 area% or less based on the total area of the cross section.

[9] The flexographic printing plate according to [8], wherein
a ratio (C1/B1) of the area ratio of the region (C1) to the area ratio of the region (B1) is 0.3 or more and 1.0 or less.

[10] The flexographic printing plate according to [8] or [9], wherein

an average loss modulus at a frequency of 2,000 Hz in the region (C1) is 10 MPa or more and 50 MPa or less, and
tanδ ([average loss modulus] / [average storage modulus]) of the region (C1) at the frequency is 0.45 or more and 0.75 or less.

[11] A flexographic printing method comprising a step of performing printing using the flexographic printing plate according to any of [1] to [10].

[12] A flexographic printing raw plate comprising at least: a support; and a photosensitive resin composition layer sequentially stacked, wherein under the following <Measurement condition 1>,
the photosensitive resin composition layer has at least a region (A2) having a storage modulus of 100 MPa or more and 500 MPa or less at a frequency of 2,000 Hz and a region (B2) having a storage modulus of 3 MPa or more and 15 MPa or less at 2,000 Hz.

<Measurement condition 1>
the photosensitive resin composition layer is isolated from the stack, molded into a thickness of 1.5 mm, and irradiated with ultraviolet light of 3000 mJ both from an upper face and from a lower face, and dynamic elasticity mapping measurement by AFM is performed on a cross section obtained by cutting 1 μm of a surface layer of the resulting cured product.

[13] The flexographic printing raw plate according to [12], wherein

an area ratio of the region (A2) is 3 area% or more and 30 area% or less based on the total area of the cross section, and
an area ratio of the region (B2) is 35 area% or more and 70 area% or less based on the total area of the cross section.

[14] The flexographic printing raw plate according to [12] or [13], wherein in dynamic viscoelasticity measurement at -30°C and 2.5 Hz,

the cured product has
a storage modulus G' (MPa) of 2.0 or more and 18.0 or less.

[15] The flexographic printing raw plate according to any of [12] to [14], wherein in dynamic viscoelasticity measurement at -30°C and 2.5 Hz,

the cured product has
a storage modulus G' (MPa) and a loss modulus G" (MPa) that satisfy the following expressions (1) and (2):

$$2.0 \leq G' + G'' \leq 25.0 \text{ expression (1)}$$

$$0.4 \leq G'' \leq 7.0 \text{ expression (2).}$$

[16] The flexographic printing raw plate according to any of [12] to [15], wherein

the photosensitive resin composition layer comprises at least: polymer particles (i) having a glass transition temperature of -45°C or higher and - 10°C or lower; a thermoplastic elastomer (ii) having a glass transition temperature of -95°C or higher and -60°C or lower; a photopolymerizable compound (iii); and a photopolymerization initiator (iv), wherein
the polymer particles (i) comprise: an aromatic vinyl compound; and a conjugated diene compound, as monomer units constituting the polymer particles (i), and
the thermoplastic elastomer (ii) comprises: an aromatic vinyl compound; and a conjugated diene compound, as monomer units constituting the thermoplastic elastomer (ii).

[17] The flexographic printing raw plate according to [16], wherein

the photosensitive resin composition layer comprises
a photopolymerizable compound having a number average molecular weight of 2,000 or more and 8,000 or less.

[18] The flexographic printing raw plate according to [17], wherein

when the total amount of the photosensitive resin composition layer is defined as 100% by mass,
a content of the polymer particles (i) is 3% by mass or more and 30% by mass or less,
a content of the thermoplastic elastomer (ii) is 25% by mass or more and 55% by mass or less, and
a content of the photopolymerizable compound having a number average molecular weight of 2,000 or more and 8,000 or less is 1% by mass or more and 20% by mass or less.

[19] The flexographic printing raw plate according to any of [12] to [18], wherein in the dynamic elasticity mapping measurement by AFM,
the cured product further has a region (C2) having a storage modulus of more than 15 MPa and less than 100 MPa at 2,000 Hz.
[20] The flexographic printing raw plate according to [19], wherein

in the dynamic elasticity mapping measurement by AFM, in the cured product,
an area ratio of the region (C2) is 20 area% or more and 40 area% or less based on the total area of the cross section.

[21] The flexographic printing raw plate according to any of [16] to [20], wherein

in the photosensitive resin composition layer,
a mass ratio of the polymer particles (i) to the thermoplastic elastomer (ii) is 0.1 or more and 1.0 or less.

[22] The flexographic printing plate according to any of [12] to [21], wherein
a ratio (A2/B2) of the area ratio of the region (A2) to the area ratio of the region (B2) is 0.05 or more and 0.7 or less.

[23] The flexographic printing raw plate according to any of [16] to [22], wherein based on 100 parts by mass of the conjugated diene compound monomer unit as monomer units constituting the polymer particles (i),
the polymer particles (i) comprise:

40 parts by mass or more and 120 parts by mass or less of an aromatic vinyl compound monomer unit and
25 parts by mass or more and 140 parts by mass or less of a (meth)acrylic acid ester monomer unit.

[24] The flexographic printing raw plate according to any of [16] to [23], wherein as a monomer unit constituting the polymer particles (i),

the polymer particles (i) comprise
a (meth)acrylic acid ester monomer unit having a number average molecular weight of 150 or more and 500 or less.

[25] A manufacturing method of the flexographic printing raw plate according to any of [12] to [24], comprising the following steps 1 to 4 in the presented order:

step 1; a step of adding at least a photopolymerizable compound (iii) to an aqueous dispersion containing polymer particles (i) to obtain an aqueous dispersion containing polymer particles (i);
step 2; a step of removing water from the aqueous dispersion containing polymer particles (i) obtained in the step 1 to obtain a mixture comprising the polymer particles (i) and the photopolymerizable compound (iii);
step 3; a step of adding at least a thermoplastic elastomer (ii) to the mixture obtained in the step 2 to obtain a photosensitive resin composition; and
step 4; a step of stacking the photosensitive resin composition obtained in the step 3 on a support to obtain a flexographic printing raw plate.

[26] A manufacturing method of the flexographic printing plate according to any of [1] to [11], comprising the following steps 1 and 2 in the presented order:

step 1; a step of partially and selectively exposing the photosensitive resin composition layer according to any of [12] to [24] through a negative pattern to obtain a partially cured product; and
step 2; a step of removing an unexposed part of the photosensitive resin composition layer from the partially cured product obtained in the step 1.

[27] A printing method comprising:

a printing plate manufacturing step of manufacturing a printing plate by the manufacturing method of a flexographic printing plate according to [26]; and
a printing step of performing printing using the flexographic printing plate obtained in the printing plate manufacturing step.

Advantageous Effects of Invention

The present invention can provide a flexographic printing plate and a flexographic printing raw plate that permit printing with good ink lay down even on a paper package and can achieve stable quality even under a printing pressure, manufacturing methods of the flexographic printing plate and the flexographic printing raw plate, and a printing method using the flexographic printing plate.

Brief Description of Drawings

[Figure 1] Figure 1 is a schematic cross-sectional view of the flexographic printing plate of the present embodiment.
[Figure 2] Figure 2 is a binarized mapping image of a region (A1) in a mapping image obtained by dynamic elasticity mapping measurement by AFM in Example 1.
[Figure 3] Figure 3 is a binarized mapping image of a region (B1) in the mapping image obtained by dynamic elasticity mapping measurement by AFM in Example 1.
[Figure 4] Figure 4 is a binarized mapping image of a region (C1) in the mapping image obtained by dynamic elasticity mapping measurement by AFM in Example 1.

[Figure 5] Figure 5 is a mapping image of a region (a1) obtained by the opening treatment of the binarized mapping image of a region (A1) in the mapping image obtained by dynamic elasticity mapping measurement by AFM in Example 1.

[Figure 6] Figure 6 is a schematic cross-sectional view of the flexographic printing raw plate of the present embodiment.

[Figure 7] Figure 7 is a schematic cross-sectional view showing another form of the flexographic printing raw plate of the present embodiment.

[Figure 8] Figure 8 is a schematic view showing a manufacturing method of a flexographic printing plate using the flexographic printing raw plate of the present embodiment.

[Figure 9] Figure 9 is a schematic view showing another form of a manufacturing method of a flexographic printing plate using the flexographic printing raw plate of the present embodiment.

Description of Embodiments

Hereinafter, a mode for carrying out the present invention (hereinafter, referred to as the "present embodiment") will be described in detail with reference to the drawings as needed. However, the present invention is not limited thereto, and various modifications can be made without departing from the spirit of the present invention. Hereinafter, the flexographic printing plate of the first embodiment and the flexographic printing raw plate of the second embodiment will be described. These embodiments, if not particularly distinguished, are referred to as the "present embodiment".

In the present embodiment, the storage modulus means a storage modulus at a frequency of 2,000 Hz unless otherwise specified. The loss modulus means a loss modulus at a frequency of 2,000 Hz unless otherwise specified.

[First embodiment: flexographic printing plate]

The flexographic printing plate of the first embodiment comprises: a support; and a relief layer sequentially stacked, wherein in dynamic elasticity mapping measurement by AFM on a cross section obtained by cutting 1 $\mu$m from a surface layer of a face on the side opposite to a face where the relief layer is in contact with the support, the cross section has at least: a region (A1) having a storage modulus of 100 MPa or more and 500 MPa or less at a frequency of 2,000 Hz; and a region (B1) having a storage modulus of 3 MPa or more and 15 MPa or less at a frequency of 2,000 Hz

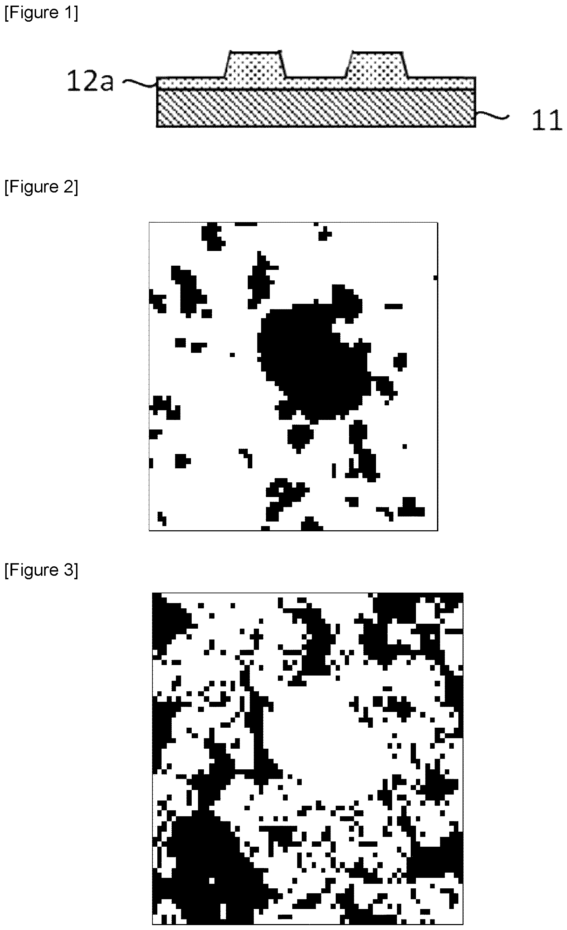

Figure 1 shows a schematic cross-sectional view of the flexographic printing plate of the present embodiment. In the flexographic printing plate of the present embodiment, a support and a relief layer having a formed concave-convex pattern of the flexographic printing plate are sequentially stacked. A functional layer such as an adhesive layer may be provided between these layers as needed. Hereinafter, the configuration of the flexographic printing plate of the present embodiment will be described in detail.

(Support)

The support used for the flexographic printing plate of the present embodiment is not particularly limited, and examples thereof include a polypropylene film, a polyethylene film, a film of a polyester such as polyethylene terephthalate and polyethylene naphthalate, and a polyamide film. Among them, a polyester film is preferable as the support.

The thickness of the support is preferably 50 $\mu$m or larger and 300 $\mu$m or smaller.

In addition, an adhesive layer may be provided between the support and the relief layer for the purpose of increasing adhesive strength between the support and the relief layer.

The material for the adhesive layer is not particularly limited, and examples thereof include a composition having a binder polymer such as polyurethane, polyester, polyamide, and a thermoplastic elastomer and an adhesive active ingredient such as an isocyanate compound and an ethylenically unsaturated compound.

Furthermore, various auxiliary additive components, for example, but not particularly limited to, a plasticizer, a thermal-polymerization preventing agent, an ultraviolet absorber, a halation preventing agent, a photostabilizer, a photopolymerization initiator, a photopolymerizable monomer, and a dye can be added to the adhesive layer.

At least one or more undercoating layers may be provided between the adhesive layer and the support for the purpose of further increasing adhesive strength between the adhesive layer and the support.

(Relief layer)

The relief layer used for the flexographic printing plate of the first embodiment is not particularly limited, and a layer obtained by the exposure and development of a photosensitive resin composition layer in a flexographic printing raw plate described later can be used, for example. The relief layer can have an arbitrary pattern such as a solid part, a floor part, a halftone part, a line part, or an open part according to a pattern to be printed.

(Dynamic elasticity mapping measurement by AFM)

The dynamic elasticity mapping measurement by AFM of the present embodiment is an evaluation method of mechanical characteristics using AFM having nanometer-scale spatial resolution. Specifically, periodic stress is applied to a measurement sample in contact with a cantilever, and a storage modulus and a loss modulus can be obtained from a response waveform thereof.

The dynamic elasticity mapping measurement by AFM of the present embodiment can be performed as follows.

The flexographic printing plate is frozen at -180°C, and about 1 $\mu$m of the surface layer of the relief layer in the flexographic printing plate is cut with an ultramicrotome (manufactured by Leica) to expose a smooth cross section of the surface layer of the relief layer. From the smooth cross section, mapping data on dynamic viscoelasticity is obtained at a total of 4096 points (64 lengthwise $\times$ 64 crosswise) in the range of a 10 $\mu$m square field of view in an AFM-DMA mode using NanoScope V / Dimension Icon manufactured by Bruker AXS. The measurement temperature is set to 25°C, and the measurement frequency is set to 2,000 Hz. Measurement probes need to be appropriately selected depending on the numeric values of storage modulus to be measured. In the present embodiment, RTESPA-150-30 and RTESPA-300-30 are used.

The obtained mapping data is subjected to image processing as follows. First, the region (A1) is extracted by binarization in which a data point for a storage modulus of 100 MPa or more and 500 MPa or less is defined as "1" and other data points are defined as "0". Figure 2 is a mapping image indicating data points of "1" in black as to the binarized region (A1) in mapping data obtained in Example 1.

The area ratio of the region (A1) is calculated by dividing the number of data points of the extracted region (A1) by the total number of measurement data. The average storage modulus and the average loss modulus of the region (A1) are determined by dividing the respective sums of the storage modulus and the loss modulus, respectively, of the extracted region (A1) by the number of data points of the extracted region (A1).

In the present embodiment, the values obtained by the calculation method described above are referred to as an average storage modulus and an average loss modulus, respectively. Simple terms "storage modulus" and "loss modulus" refer to each individual data point in the mapping data on dynamic viscoelasticity.

The region (B1) is extracted by binarization in which a data point for a storage modulus of 3 MPa or more and 15 MPa or less is defined as "1" and other data points are defined as "0" in the same manner as in the operation of extracting the region (A1). Figure 3 is a mapping image of the region (B1) extracted by binarization in the mapping data obtained in Example 1.

The area ratio of the region (B1) was calculated by dividing the number of data points of the extracted region (B1) by the total number of measurement data. The average storage modulus and the average loss modulus of the region (B1) were determined by dividing the respective sums of the storage modulus and the loss modulus, respectively, of the extracted region (B1) by the number of data points of the extracted region (B1).

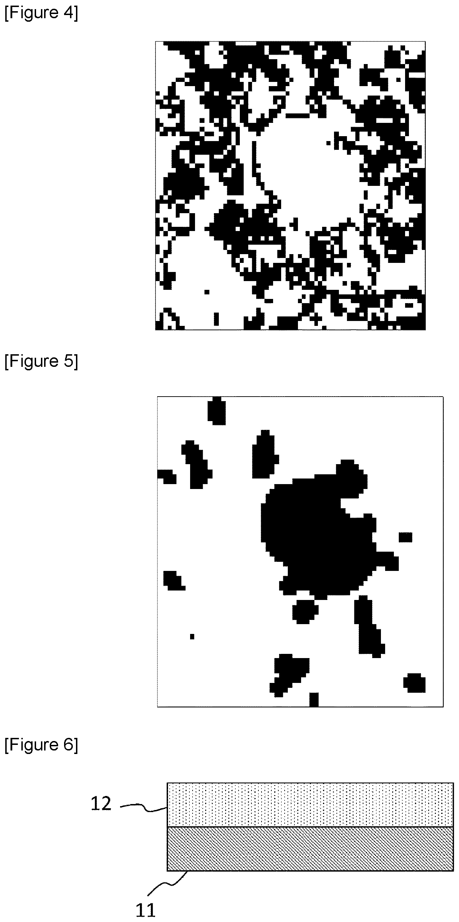

Likewise, the region (C1) is extracted by binarization using a data point for a storage modulus of more than 15 MPa and less than 100 MPa and other data points. Figure 4 is a mapping image of the region (C1) extracted by binarization in the mapping data obtained in Example 1.

The area ratio of the region (C1) was calculated by dividing the number of data points of the extracted region (C1) by the total number of measurement data. The average storage modulus and the average loss modulus of the region (C1) were determined by dividing the respective sums of the storage modulus and the loss modulus, respectively, of the extracted region (C1) by the number of data points of the extracted region (C1).

The flexographic printing plate of the first embodiment, by having the region (A1), is capable of providing stable halftone quality even in long-run printing without halftone chipping and slur even under excessive printing pressure conditions. Although the detailed technical mechanism thereof is not clear, the inventors surmise the following.

The compression frequency of the plate during printing depends on a printing rate and a plate cylinder size. A larger printing rate increases the frequency at which the printing plate is subjected to stress. A larger plate cylinder size decreases the frequency because the number of times of contact between the plate and a printing base material is decreased. The inventors have assumed that the frequency widely used in printing sites for paper packages is around 2,000 Hz, and found a tendency that dynamic viscoelasticity at this measurement frequency correlates with printing quality or wear resistance.

Specifically, in the presence of a region having a storage modulus of 100 MPa or more and 500 MPa or less at a frequency of 2,000 Hz, this region functions as a core material. This elevates a printing pressure and can thereby suppress halftone chipping and slur even if stress is applied.

In the presence of a region having a storage modulus of 3 MPa or more and 15 MPa or less at a frequency of 2,000 Hz, the plate can maintain softness and following properties for a rough face as a whole and improves ink lay down on a paper package.

The region (A1) having a larger area ratio is more effective as a core material and can suppress halftone chipping and slur. On the other hand, a smaller area ratio of the region (A1) enhances following properties for a printing base material and improves ink lay down on a paper package.

From these viewpoints, the area ratio of the region (A1) is preferably 3 area% or more and 35 area% or less, more preferably 10 area% or more and 33 area% or less, still more preferably 15 area% or more and 30 area% or less, and especially preferably 18 area% or more and 28 area% or less, based on the total area of the cross section.

A larger area ratio of the region (B1) enhances following properties for a printing base material and improves ink lay down on a paper package. On the other hand, the region (B1) having a smaller area ratio can suppress halftone chipping and slur.

From these viewpoints, the area ratio of the region (B1) is preferably 35 area% or more and 65 area% or less, more preferably 38 area% or more and 63 area% or less, still more preferably 40 area% or more and 60 area% or less, and especially preferably 45 area% or more and 60 area% or less, based on the total area of the cross section.

A larger ratio (A1/B1) of the area ratio of the region (A1) to the area ratio of the region (B1) of the present embodiment increases the proportion of a core material and can therefore suppress halftone chipping and slur. A smaller ratio enhances following properties for a printing base material and improves ink lay down.

From these viewpoints, the ratio (A1/B1) of the area ratio of the region (A1) to the area ratio of the region (B1) is preferably 0.1 or more and 0.8 or less, more preferably 0.2 or more and 0.7 or less, and still more preferably 0.3 or more and 0.6 or less.

The binarized mapping data of the region (A1) of the present embodiment is subjected to opening treatment by morphological operation as described below. Specific contents of the treatment are as follows.

First, erosion treatment is performed as follows. The target pixel data and its 8-neighbor data are summed. The target data is given "1" when the sum is 6 or more, and given "0" when the sum is 5 or less (erosion treatment using 8 neighbors and a threshold of 3).

Subsequently, dilation treatment is performed as follows. The target pixel data and its 8-neighbor data are summed. The target data is given "1" when the sum is 3 or more, and given "0" when the sum is 2 or less (dilation treatment using 8 neighbors and a threshold of 3).

In the present embodiment, the new data point of "1" obtained by the image processing operation described above is defined as a region (a1). The region (a1) is data from which small particles of the region (A1) have been removed, and as such, is suitable for evaluating dispersity.

Figure 5 is a binarized mapping image of the region (a1) obtained by the opening treatment of the mapping data of the region (A1) extracted by binarization in Example 1.

In the flexographic printing plate of the present embodiment, the area per region constituted by data on continuously adjacent pixels in the region (a1) is preferably 0.1 $\mu$m$^2$ or larger. The region (a1) can thereby function as a core material and can suppress halftone chipping and slur. In the present embodiment, this area also means that the number of continuously adjacent data is 5 or more.

On the other hand, the area per continuously adjacent region in the region (a1) is preferably 10 $\mu$m$^2$ or smaller. This can maintain following properties for a printing base material and can improve ink lay down on a paper package. In the present embodiment, the area of 10 $\mu$m$^2$ or smaller per continuously adjacent region in the region (a1) also means that the number of continuously adjacent data is 409 or less.

From these viewpoints, the region (a1) preferably has a larger ratio (a1'/a1) of the area of a region (a1') that is constituted by data on continuously adjacent pixels and has an area of 0.1 $\mu$m$^2$ or larger and 10 $\mu$m$^2$ or smaller per region to the area of the region (a1). The ratio is preferably 90 area% or more, more preferably 95 area% or more, and still more preferably 97 area% or more. The ratio may be 100 area%.

The region (A1) having a storge modulus of 100 MPa or more exerts a sufficient role as a core material. From such viewpoints, the average storage modulus at a frequency of 2,000 Hz in the region (A1) is preferably 100 MPa or more, more preferably 125 MPa or more, and especially preferably 150 MPa or more.

On the other hand, a smaller average storage modulus can improve ink lay down on a paper package. From such viewpoints, the average storage modulus at a frequency of 2,000 Hz in the region (A1) is preferably 400 MPa or less, more preferably 300 MPa or less, and especially preferably 250 MPa or less.

When a region having a storage modulus of 100 MPa or more and 250 MPa or less, which is an especially preferable region, is designated as a region (A1'), a larger ratio (A1'/A1) of the area of the region (A1') to the area of the region (A1) is preferable in view of enhancing ink lay down on a paper package. The ratio is preferably 50 area% or more, more preferably 60 area% or more, and still more preferably 70 area% or more. The ratio may be 100 area%.

The region (B1) having a storge modulus of 15 MPa or less at a frequency of 2,000 Hz can sufficiently follow a paper package and can improve ink lay down on a paper package while printing quality can be maintained during long-run printing. From such viewpoints, the average storage modulus of the region (B1) is preferably 5 MPa or more and 15 MPa or less, more preferably 8 MPa or more and 15 MPa or less, and especially preferably 10 MPa or more and 15 MPa or less.

When a region having a storage modulus of 10 MPa or more and 15 MPa or less, which is an especially preferable region, is designated as a region (B1'), a larger ratio (B1'/B1) of the area of the region (B1') to the area of the region (B1) is preferable in view of improvement in quality during long-run printing. The ratio is preferably 50 area% or more, more preferably 60 area% or more, and still more preferably 70 area% or more. The ratio may be 100 area%.

A larger loss modulus of the flexographic printing plate of the present embodiment at a frequency of 2,000 Hz facilitates deformation and improves ink lay down on a paper package by enhancing following properties for a printing base material. On the other hand, a smaller loss modulus facilitates energy release to the outside under a printing pressure and improves wear resistance.

From such viewpoints, the average loss modulus at a frequency of 2,000 Hz in the region (A1) is preferably 50 MPa or more and 250 MPa or less, more preferably 75 MPa or more and 175 MPa or less, and especially preferably 100 MPa or more and 150 MPa or less.

The average loss modulus at a frequency of 2,000 Hz in the region (B1) is preferably 1 MPa or more and 10 MPa or less, more preferably 2 MPa or more and 8 MPa or less, and especially preferably 2 MPa or more and 6 MPa or less.

Larger $\tan\delta$ ([average loss modulus] / [average storage modulus]) of the flexographic printing plate of the present embodiment at 2,000 Hz increases the contribution of a viscous term and therefore facilitates deformation, and improves ink lay down on a paper package by enhancing following properties for a printing base material. On the other hand, smaller $\tan\delta$ increases the contribution of an elastic term and therefore facilitates energy release to the outside under a printing pressure and improves wear resistance.

From such viewpoints, the $\tan\delta$ of the region (A1) is preferably 0.5 or more and 0.8 or less, more preferably 0.55 or more and 0.75 or less, and especially preferably 0.6 or more and 0.7 or less.

The $\tan\delta$ of the region (B1) is preferably 0.4 or more and 0.7 or less, more preferably 0.45 or more and 0.65 or less, and especially preferably 0.5 or more and 0.6 or less.

The flexographic printing plate of the present embodiment preferably further has a region (C1) having a storage modulus of more than 15 MPa and less than 100 MPa at a frequency of 2,000 Hz. This can suppress local concentration of stress ascribable to sharp difference in elastic modulus between the region (A1) and the region (B1), and produces effects of stabilizing quality during long-run printing and improving wear resistance.

From such viewpoints, a larger area ratio of the region (C1) produces effects of stabilizing quality during long-run printing and improving wear resistance. On the other hand, a smaller area ratio can achieve both halftone quality and solid quality because the region (A1) and the region (B1) relatively get larger. The area ratio of the region (C1) is preferably 25 area% or more and 55 area% or less, more preferably 30 area% or more and 50 area% or less, and still more preferably 35 area% or more and 45 area% or less, based on the total area of the cross section of the relief layer.

A larger ratio (C1/B1) of the area ratio of the region (C1) to the area ratio of the region (B1) of the present embodiment produces effects of stabilizing quality during long-run printing and improving wear resistance. On the other hand, a smaller ratio enhances following properties for a printing base material and improves ink lay down on a paper package.

From these viewpoints, the ratio (C1/B1) of the area ratio of the region (C1) to the area ratio of the region (B1) is preferably 0.3 or more and 1.0 or less, more preferably 0.4 or more and 0.9 or less, and still more preferably 0.5 or more and 0.8 or less.

The average loss modulus at a frequency of 2,000 Hz in the region (C1) of the present embodiment is preferably 5 MPa or more and 50 MPa or less, and more preferably 10 MPa or more and 40 MPa or less.

The $\tan\delta$ of the region (C1) at the frequency is preferably 0.45 or more and 0.75 or less, more preferably 0.5 or more and 0.7 or less, and especially preferably 0.55 or more and 0.65 or less.

[Flexographic printing method]

The flexographic printing method of the present embodiment preferably comprises a step of performing printing using the flexographic printing plate. The method is not particularly limited as long as the method involves allowing ink to attach to a convex part of the relief layer in the flexographic printing plate, and transferring the ink to a base material.

[Second embodiment: flexographic printing raw plate]

The flexographic printing raw plate of the second embodiment comprises at least a support and a photosensitive resin composition layer sequentially stacked, wherein under the following <Measurement condition 1>, the photosensitive resin composition layer has at least a region (A2) having a storage modulus of 100 MPa or more and 500 MPa or less at a frequency of 2,000 Hz and a region (B2) having a storage modulus of 3 MPa or more and 15 MPa or less at 2,000 Hz.

<Measurement condition 1>

the photosensitive resin composition layer is isolated from the stack, molded into a thickness of 1.5 mm, and irradiated with ultraviolet light of 3000 mJ both from an upper face and from a lower face, and dynamic elasticity mapping measurement by AFM is performed on a cross section obtained by cutting 1 μm of a surface layer of the resulting cured product.

The flexographic printing raw plate may further have an adhesive layer between the support and the photosensitive resin composition layer, an infrared ablation layer stacked on the photosensitive resin composition layer, a cover film stacked on the infrared ablation layer, and an intermediate layer between the infrared ablation layer and the photosensitive resin composition layer.

Figure 6 shows a schematic cross-sectional view of the flexographic printing raw plate of the present embodiment. In the flexographic printing raw plate 10 of the present embodiment, support 11 and photosensitive resin composition layer 12 on which a relief layer of a flexographic printing plate is formed are sequentially stacked. An infrared ablation layer which functions as a mask at the time of forming a concave-convex pattern of a flexographic printing plate, a functional layer such as an adhesive layer, a cover film aimed at protecting the infrared ablation layer, and the like may be provided between these layers or on each of the layers as needed. Hereinafter, the configuration of the flexographic printing raw plate of the second embodiment will be described in detail.

(Support)

The same support as that of the first embodiment can be used for the flexographic printing raw plate of the second embodiment.

(Photosensitive resin composition)

The photosensitive resin composition layer of the second embodiment preferably comprises at least polymer particles (i) having a glass transition temperature of -50°C or higher and -10°C or lower, a thermoplastic elastomer (ii) having Tg of -95°C or higher and -60°C or lower, a photopolymerizable compound (iii), and a photopolymerization initiator (iv).

The glass transition temperature (Tg) according to the present embodiment can be determined by a method described in Examples described later using a dynamic viscoelasticity measurement apparatus.

In the case of using a commercially available product as the polymer particles (i) or the thermoplastic elastomer (ii), catalog data or data described in a known literature may be adopted to the Tg according to the present embodiment.

The polymer particles (i) having Tg of -50°C or higher and -10°C or lower preferably contain an aromatic vinyl compound and a conjugated diene compound as monomer units constituting the polymer particles (i).

The thermoplastic elastomer (ii) having Tg of -95°C or higher and -60°C or lower preferably contains an aromatic vinyl compound and a conjugated diene compound as monomer units constituting the thermoplastic elastomer (ii).

This can finely disperse the polymer particles (i) and the thermoplastic elastomer (ii), enables a flexographic printing plate obtained from the flexographic printing raw plate of the second embodiment to be designed so as to have the region (A1) and the region (B1), and can achieve both ink lay down and printing quality of a halftone part.

The photosensitive resin composition of the second embodiment may optionally contain a plasticizer (v), an antioxidant (vi), a detergent builder (vii), a silicone compound (viii), other compounds, and the like.

The photosensitive resin composition layer of the second embodiment satisfies the following <Measurement condition 1>.

<Measurement condition 1>

The photosensitive resin composition layer has at least a region (A2) having a storage modulus of 100 MPa or more and 500 MPa or less at 2,000 Hz and a region (B2) having a storage modulus of 3 MPa or more and 15 MPa or less at 2,000 Hz when the photosensitive resin composition layer is isolated from the stack, molded into a thickness of 1.5 mm, and irradiated with ultraviolet light of 3000 mJ both from an upper face and from a lower face, and dynamic elasticity mapping measurement by AFM is performed on a cross section obtained by cutting 1 μm of a surface layer of the resulting cured product.

This can achieve both the printing quality of a solid part and the printing quality of a halftone part in a flexographic printing plate obtained from the flexographic printing raw plate of the second embodiment.

(Dynamic elasticity mapping measurement by AFM)

The dynamic elasticity mapping measurement by AFM of the second embodiment can be performed as follows.

The photosensitive resin composition layer constituting the flexographic printing raw plate is isolated from the flexographic printing raw plate, molded into a thickness of 1.5 mm, and irradiated with ultraviolet light of 3000 mJ both from an upper face and from a lower face to obtain a cured product.

Then, the obtained cured product of the photosensitive resin composition is frozen at -180°C, and about 1 $\mu$m of the surface layer of the cured product of the photosensitive resin composition is cut with an ultramicrotome (manufactured by Leica) to expose a smooth cross section. From the smooth cross section, an AFM image of 10 $\mu$m square is obtained using NanoScope V / Dimension Icon manufactured by Bruker AXS. Then, mapping data on dynamic viscoelasticity is obtained at a total of 4096 points (64 lengthwise $\times$ 64 crosswise) in the same measurement range as above in an AFM-DMA mode. The measurement temperature is set to 25°C, and the measurement frequency is set to 2,000 Hz. Measurement probes need to be appropriately selected depending on the numeric values of storage modulus to be measured. In the present embodiment, RTESPA-150-30 and RTESPA-300-30 are used.

The description about the dynamic elasticity mapping measurement of the first embodiment can be applied to the detailed description about the dynamic elasticity mapping measurement by AFM of the second embodiment. The region (A1) according to the first embodiment can be applied to the region (A2) of the second embodiment, the region (B1) according to the first embodiment can be applied to the region (B2) of the second embodiment, and the region (C1) according to the first embodiment can be applied to the region (C2) of the second embodiment.

Hence, for the same reason as in the first embodiment, in dynamic elasticity mapping measurement by AFM, the cured product preferably further has a region (C2) having a storage modulus of more than 15 MPa and less than 100 MPa at 2,000 Hz.

In the cured product, preferably, in dynamic elasticity mapping measurement by AFM, the area ratio of the region (A2) is 3 area% or more and 30 area% or less based on the total area of the cross section, the area ratio of the region (B2) is 35 area% or more and 70 area% or less based on the total area of the cross section, and the area ratio of the region (C2) is 20 area% or more and 40 area% or less based on the total area of the cross section.

A larger ratio (A2/B2) of the area ratio of the region (A2) to the area ratio of the region (B2) of the present embodiment increases the proportion of a core material and can therefore suppress halftone chipping and slur. A smaller ratio enhances following properties for a printing base material and improves ink lay down.

From these viewpoints, the ratio (A2/B2) of the area ratio of the region (A2) to the area ratio of the region (B2) is preferably 0.05 or more and 1.0 or less, more preferably 0.1 or more and 1.0 or less, still more preferably 0.2 or more and 0.9 or less, further preferably 0.3 or more and 0.8 or less, and especially preferably 0.3 or more and 0.7 or less.

Hereinafter, the configuration of the photosensitive resin composition of the second embodiment will be described in detail.

<Polymer particles (i)>

The polymer particles (i) are internally-crosslinked polymer particles of a monomer. Such polymer particles are not particularly limited, and examples thereof include those obtained by preparing a water-dispersion latex in which polymer particles as a dispersoid are dispersed in water by emulsion polymerization, and removing water from the obtained water-dispersion latex.

The polymer particles (i) are particles having a relatively large storage modulus and therefore play a role as a core material in the photosensitive resin composition by forming the regions (A1) and (A2). This can suppress halftone chipping and slur even during long-run printing or under excessive printing pressure conditions.

The glass transition temperature of the polymer particles (i) is preferably -50°C or higher and -10°C or lower. This can increase a storage modulus at a frequency band of 2,000 Hz owing to a peak of tan$\delta$ that appears near the frequency band in the dynamic elasticity mapping measurement by AFM, and can form the regions (A1) and (A2).

Larger Tg of the polymer particles (i) tends to increase the storage modulus and area ratios of the regions (A1) and (A2) and can suppress halftone chipping and slur. From such viewpoints, the Tg of the polymer particles (i) is -50°C or higher, preferably -45°C or higher, and still more preferably -40°C or higher.

On the other hand, smaller Tg of the polymer particles (i) tends to decrease the storage modulus and area ratios of the regions (A1) and (A2) and can enhance following properties for a printing base material and improve ink lay down on a paper package. From such viewpoints, the Tg of the polymer particles (i) is -10°C or lower, preferably -15°C or lower, and still more preferably -20°C or lower.

The Tg of the polymer particles (i) can be determined by dynamic viscoelasticity measurement. A detailed measurement method is as described in Examples described later. If a test specimen cannot be prepared by the method described in Examples due to the properties of a sample, Tg may be determined by thermal analysis.

A commercially available product can be used as the polymer particles (i). In the case of a commercially available product, catalog data or a known literature can be adopted to the Tg.

A larger amount of the polymer particles (i) added in the photosensitive resin composition is preferable in view of increasing the area ratios of the regions (A1) and (A2) and suppressing halftone chipping and slur. Specifically, the amount is preferably 3% by mass or more, more preferably 10% by mass or more, and especially preferably 15% by mass or more based on 100% by mass in total of the photosensitive resin composition layer.

On the other hand, a smaller amount of the polymer particles (i) added in the photosensitive resin composition is preferable in view of decreasing the area ratios of the regions (A1) and (A2) and improving ink lay down on a paper package. Specifically, the amount is preferably 35% by mass or less, more preferably 33% by mass or less, and especially preferably 30% by mass or less based on 100% by mass in total of the photosensitive resin composition layer.

The monomer that constitutes the polymer particles (i) is not particularly limited as long as it has a polymerizable double bond. Examples thereof include monobasic acid monomers, polybasic acid monomers, conjugated dienes, aromatic vinyl compounds, (meth)acrylic acid esters, monomers having a hydroxy group, unsaturated dibasic acid alkyl esters, maleic anhydride, vinyl cyanide compounds, (meth)acrylamides and derivatives thereof, vinyl esters, vinyl ethers, vinyl halides, basic monomers having an amino group, vinylpyridine, olefins, silicon-containing $\alpha,\beta$-ethylenically un-saturated monomers, and aryl compounds. The monomer that constitutes the polymer particles (i) may include a reactive emulsifier for use in emulsion polymerization described later.

Among these monomers constituting the polymer particles (i), an aromatic vinyl compound, a conjugated diene compound, and a (meth)acrylic acid ester are preferable for constitution.

The aromatic vinyl compound contained therein forms a physical crosslinking point in the polymer particles and can thereby form the regions (A1) and (A2) with their storage modulus elevated, and can suppress halftone chipping and slur.

The conjugated diene contained therein facilitates design that decreases the Tg of the polymer particles. The conjugated diene reacts through its unsaturated bond with the photopolymerizable compound in the photosensitive resin composition and can thereby elevate the storage modulus of the region (A1) and the region (A2) and suppress halftone chipping and slur.

The (meth)acrylic acid ester contained therein facilitates designing the Tg of the polymer particles within the intended numeric range.

The aromatic vinyl compounds are not particularly limited, and examples thereof include styrene, $\alpha$-methyl-styrene, o-methylstyrene, m-methylstyrene, p-methylstyrene, ethylstyrene, vinyltoluene, vinylxylene, bromostyrene, vinylbenzyl chloride, p-t-butylstyrene, chrolostyrene, alkylstyrene, divinylbenzene, and trivinylbenzene.

Among these aromatic vinyl compounds, styrene is especially preferable in view of compatibility with the thermoplastic elastomer (ii).

A larger content of the aromatic vinyl compound is preferable in view of elevating Tg and thereby increasing the area ratios of the regions (A1) and (A2), and suppressing halftone slur. The content is preferably 12% by mass or more, more preferably 15% by mass or more, and still more preferably 20% by mass or more based on the total amount of the polymer particles (i). On the other hand, a smaller content is preferable in view of enhancing softness. The content is preferably 40% by mass or less, more preferably 35% by mass or less, and still more preferably 30% by mass or less based on the total amount of the polymer particles (i).

The conjugated diene is not particularly limited, and examples thereof include 1,3-butadiene, isoprene, 2,3-dimethyl-1,3-butadiene, 2-ethyl-1,3-butadiene, 2-methyl-1,3-butadiene, 1,3-pentadiene, chloroprene, 2-chloro-1,3-butadiene, and cyclopentadiene.

Among these aromatic vinyl compounds, 1,3-butadiene is especially preferable in view of compatibility with the thermoplastic elastomer (ii).

A larger content of the conjugated diene is preferable in view of enhancing softness. A smaller content is preferable in view of suppressing halftone chipping and slur. Taking the balance among them into consideration, the content is preferably 25% by mass or more and 60% by mass or less, more preferably 30% by mass or more and 55% by mass or less, and still more preferably 35% by mass or more and 50% by mass or less based on the total amount of the polymer particles (i).

Examples of the (meth)acrylic acid esters include, but not particularly limited to, methyl (meth)acrylate, ethyl (meth)acrylate, propyl (meth)acrylate, n-butyl (meth)acrylate, t-butyl (meth)acrylate, isobutyl (meth)acrylate, n-amyl (meth)acrylate, isoamylhexyl (meth)acrylate, octyl (meth)acrylate, nonyl (meth)acrylate, decyl (meth)acrylate, dodecyl (meth)acrylate, octadecyl (meth)acrylate, cyclohexyl (meth)acrylate, phenyl (meth)acrylate, benzyl (meth)acrylate, 2-ethyl-hexyl (meth)acrylate, glycidyl (meth)acrylate, ethylene glycol di(meth)acrylate, ethylene glycol di(meth)acrylate, 1,3-butylene glycol di(meth)acrylate, 1,4-butylene glycol di(meth)acrylate, propylene glycol di(meth)acrylate, 1,5-pentanediol di(meth)acrylate, neopentyl glycol di(meth)acrylate, 1,6-hexanediol di(meth)acrylate, diethylene glycol di(meth)acrylate, triethylene glycol di(meth)acrylate, tetraethylene glycol di(meth)acrylate, polyethylene glycol di(meth)acrylate, polypropylene glycol di(meth)acrylate, pentaerythritol tri(meth)acrylate, trimethylolpropane tri(meth)acrylate, tetramethylolmethane tetra(meth)acrylate, aryl (meth)acrylate, bis(4-acryloxypolyethoxyphenyl)propane, methoxy polyethylene glycol (meth)acrylate, $\beta$-(meth)acryloyloxy ethyl hydrogen phthalate, $\beta$-(meth)acryloyloxy ethylhydrogensuccinate, 3-chloro-2-hydroxypropyl (meth)acrylate, stearyl (meth)acrylate, phenoxyethyl (meth)acrylate, phenoxypolyethyleneglycol (meth)acrylate, 2-hydroxy-1,3-di(meth)acryloxypropane, 2,2-bis[4-((meth)acryloxyethoxy)phenyl]propane, 2,2-bis [4-((meth)acryloxy-diethoxy)phenyl]propane, 2,2-bis[4-((meth)acryloxy-polyethoxy)phenyl]propane, and isobornyl (meth)acrylate.

A number average molecular weight of the (meth)acrylic acid ester is preferably 100 or more and 1000 or less, and more preferably 150 or more and 500 or less in view of adjusting Tg to the intended numeric range.

On the other hand, a smaller number average molecular weight of the (meth)acrylic acid ester is preferable in view of compatibility and reactivity in a mixture liquid during emulsion polymerization. The number average molecular weight is preferably 1000 or less, more preferably 500 or less, still more preferably 400 or less, and especially preferably 300 or less.

The ester moiety of the (meth)acrylic acid ester is preferably constituted by hydrocarbon having a chain structure in view of adjusting Tg to the intended numeric range. The ester moiety may have a linear or branched structure.

The content of the (meth)acrylic acid ester is preferably 10% by mass or more and 45% by mass or less, more preferably 15% by mass or more and 40% by mass or less, and still more preferably 20% by mass or more and 36% by mass or less based on the total amount of the polymer particles (i).

The monomer units constituting the polymer particles (i) preferably include 40 parts by mass or more and 120 parts by mass or less of the aromatic vinyl compound monomer unit and 25 parts by mass or more and 140 parts by mass or less of the (meth)acrylic acid ester monomer unit based on 100 parts by mass of the conjugated diene compound monomer unit. This enables Tg and a storage modulus to be designed in the intended numeric ranges.

The content of the aromatic vinyl compound monomer unit is preferably 40 parts by mass or more and 160 parts by mass or less, and more preferably 80 parts by mass or more and 160 parts by mass or less in view of more facilitating design in the intended numeric range. The content of the (meth)acrylic acid ester monomer unit is preferably 25 parts by mass or more and 140 parts by mass or less, more preferably 60 parts by mass or more and 135 parts by mass or less, and especially preferably 65 parts by mass or more and 130 parts by mass or less.

The monobasic acid monomers are not particularly limited, and examples thereof include monomers having a carboxyl group, such as acrylic acid, methacrylic acid, crotonic acid, vinylbenzoic acid, and cinnamic acid; and monomers having a sulfonic acid group, such as styrenesulfonic acid.

The content of the monobasic acid monomer is preferably 1% by mass or more and 30% by mass or less, more preferably 2% by mass or more and 20% by mass or less, still more preferably 3% by mass or more and 15% by mass or less, and further preferably 5% by mass or more and 10% by mass or less based on the total amount of the polymer particles (i).

The polybasic acid monomers are not particularly limited, and examples thereof include monomers having two or more carboxyl groups, such as itaconic acid, fumaric acid, maleic acid, citraconic acid, and muconic acid; monomers having an acid anhydride group; and monomers having a polybasic acid group of a phosphoric acid group.

The monomers having a hydroxy group are not particularly limited, and examples thereof include ethylene-based monocarboxylic acid alkyl ester monomers such as 2-hydroxyethyl acrylate, 2-hydroxyethyl methacrylate, 2-hydroxypropyl acrylate, 2-hydroxypropyl methacrylate, 1-hydroxypropyl acrylate, 1-hydroxypropyl methacrylate, and hydroxycyclohexyl (meth)acrylate.

Examples of the unsaturated dibasic acid alkyl esters include, but not particularly limited to, alkyl crotonates, alkyl itaconates, alkyl fumarates, and alkyl maleates.

Examples of the vinyl cyanide compounds include, but not particularly limited to, acrylonitrile and methacrylonitrile.

Examples of the (meth)acrylamides and derivatives thereof include, but not particularly limited to, (meth)acrylamide, N-methylol (meth)acrylamide, and N-alkoxy (meth)acrylamide.

Examples of the vinyl esters include, but not particularly limited to, vinyl acetate, vinyl butyrate, vinyl stearate, vinyl laurate, vinyl myristate, vinyl propionate, and vinyl ester of versatic acid.

Examples of the vinyl ethers include, but not particularly limited to, methyl vinyl ether, ethyl vinyl ether, propyl vinyl ether, butyl vinyl ether, amyl vinyl ether, and hexyl vinyl ether.

Examples of the vinyl halides include, but not particularly limited to, vinyl chloride, vinyl bromide, vinyl fluoride, vinylidene chloride, and vinylidene fluoride.

Examples of the basic monomers having an amino group include, but not particularly limited to, aminoethyl (meth)acrylate, dimethylaminoethyl (meth)acrylate, and diethylaminoethyl (meth)acrylate.

Examples of the olefins include, but not particularly limited to, ethylene.

Examples of the silicon-containing $\alpha,\beta$-ethylenically unsaturated monomers include, but not particularly limited to, vinyltrichlorosilane and vinyltriethoxysilane.

Examples of the aryl compounds include, but not particularly limited to, allyl esters and diallyl phthalates.

Besides, a monomer having three or more double bonds such as triallyl isocyanurate can be also used.

These monomers may be used singly, or two or more thereof may be mixed and used. In particular, it is preferable to include a monomer having an acidic group (hereinafter, also simply referred to as an "acidic monomer") such as a monobasic acid monomer or a polybasic acid monomer, and a monomer having a hydrophobic group (hereinafter, also simply referred to as a "hydrophobic monomer") such as conjugated diene, an aromatic vinyl compound, or a (meth)acrylic acid ester. The conjugated diene, the aromatic vinyl compound, and the (meth)acrylic acid ester that correspond to the hydrophobic monomer have a hydrocarbon group, and those having a hydrophilic group such as a hydroxy group are excluded from the hydrophobic monomer even if they are a (meth)acrylic acid ester or the like.

The content of the acidic monomer is preferably 1% by mass or more and 30% by mass or less, more preferably 2% by mass or more and 20% by mass or less, still more preferably 3% by mass or more and 15% by mass or less, and further preferably 5% by mass or more and 10% by mass or less based on the total amount of the polymer particles (i). When the content of the acidic monomer is 1% by mass or more, aqueous developing performance tends to more improve. When the content is 30% by mass or less, an increase in swelling of the photosensitive resin composition by water-based ink can be prevented and quality during long-run printing can be stabilized.

The content of the monomer having a hydrophobic group is preferably 70% by mass or more and 99% by mass or less, more preferably 80% by mass or more and 98% by mass or less, still more preferably 85% by mass or more and 97% by mass or less, and further preferably 90% by mass or more and 95% by mass or less. When the polymer particles (i) has such composition, rubber elasticity of the photosensitive resin composition tends to more improve and printing is achieved with good ink lay down on a paper package.

The polymer included in the polymer particles (i) is not particularly limited, and examples thereof include polymers having a butadiene skeleton, such as polybutadiene, an acrylonitrile-butadiene copolymer, a styrene-butadiene copolymer, and a (meth)acrylate-butadiene copolymer; polymers having an isoprene skeleton, such as polyisoprene and polychloroprene; polymers obtained by further polymerizing a monomer having a carboxyl group and/or a hydroxy group with the polymers having butadiene skeleton or an isoprene skeleton; polymers obtained by further polymerizing a (meth)acrylic acid ester with the polymers having butadiene skeleton or an isoprene skeleton; polymers obtained by further polymerizing a (meth)acrylic acid ester and a monomer having a carboxyl group and/or a hydroxy group with the polymers having butadiene skeleton or an isoprene skeleton; and polyurethane, a vinylpyridine polymer, a butyl polymer, a Thiokol polymer, an acrylate polymer, and natural rubber.

The monomer having a carboxyl group herein means the monobasic acid monomer and/or the polybasic acid monomer.

Among them, a polymer having a butadiene skeleton, a polymer having an isoprene skeleton, and a polymer obtained by further polymerizing an aromatic vinyl compound and/or a (meth)acrylic acid ester and/or a monomer having a carboxyl group and/or a hydroxy group with the polymer having a butadiene skeleton or an isoprene skeleton are preferable, and a polymer obtained by further polymerizing an aromatic vinyl compound and/or a (meth)acrylic acid ester and/or a monomer having a carboxyl group and/or a hydroxy group with the polymer having a butadiene skeleton is more preferable. The polymer particles (i) may be used singly or in combinations of two or more thereof.

The average particle diameter of the polymer particles (i) is preferably 500 nm or less and more preferably 100 nm or less. When the average particle diameter is 500 nm or less, aqueous developing performance of the flexographic printing raw plate tends to more improve.

The toluene gel fraction of the polymer particles (i) is preferably 60% or more and 99% or less. When the toluene gel fraction is 60% or more, the chipping resistance of a halftone part can be improved. When the toluene gel fraction is 99% or less, mixing properties between the polymer particles (i) and the thermoplastic elastomer (i) tend to be good.

The toluene gel fraction herein is defined as follows.

An appropriate amount of a dispersion containing 30% by mass of the polymer particles (i) is dropped on a Teflon (R) sheet followed by drying at 130°C for 30 minutes; 0.5 g of the polymer particles (i) is taken therefrom and immersed in 30 mL of toluene at 25°C. After subsequent shaking for three hours using a shaking device, filtration with a 320 SUS mesh was performed to obtain matter not passing through the mesh. The matter not passing through the mesh is dried at 130°C for one hour, and the mass of the dried matter is divided by 0.5 (g). The resulting mass fraction (%) is regarded as the toluene gel fraction.

(Manufacturing method of polymer particles (i))

A synthesis method of the polymer particles (i) is not particularly limited, and a polymer synthesized through emulsion polymerization is preferable, for example. Examples of the emulsion polymerization method of the polymer particles (i) include a method in which predetermined amounts of water, an emulsifier, and other additives are fed, in advance, to a reaction system having been adjusted to a temperature at which polymerization is possible, and a polymerization initiator and a monomer, an emulsifier, an adjuster, and the like are added into this reaction system by batch operation or continuous operation. In addition, predetermined amounts of a seed latex, a polymerization initiator, a monomer, and another adjuster may be added in advance to the emulsion polymerization reaction system.

The layer structure of polymer particles to be synthesized can also be changed stepwise by devising a method of adding the monomer, emulsifier, other additives, and adjuster to the reaction system. In this case, physical properties representing the structure of each layer include hydrophilicity, glass transition temperature, molecular weight, crosslinking density. The number of layers in this layer structure is not particularly limited.

Hereinafter, each component other than the above monomer will be described.

The emulsifier (surfactant) used at the time of emulsion polymerization is not particularly limited, and examples thereof include a reactive emulsifier and/or a non-reactive emulsifier. Among them, a reactive emulsifier is preferably used.

The reactive emulsifier is preferably a reactive emulsifier including a radically polymerizable double bond, a hydrophilic functional group, and a hydrophobic group in its molecular structure and having emulsifying, dispersing, and swelling functions as with common emulsifiers. Among them, a preferable reactive emulsifier (surfactant) is such that the reactive emulsifier is capable of providing a polymer particles having an average particle diameter of 5 nm or more and 500 nm or less when the reactive emulsifier is used in an amount of 0.1 parts by mass or more per 100 parts by mass of all monomers but the reactive emulsifier.

The hydrophilic functional group of the reactive emulsifier is not particularly limited, and examples thereof include anionic groups such as a sulfate group, a nitrate group, a phosphate group, a borate group, and a carboxy group; cationic groups such as an amino group; polyoxyalkylene chain structure or the like such as polyoxyethylene, polyoxymethylene, and polyoxypropylene; or hydroxy group. The reactive emulsifier can be classified into an anionic emulsifier, a nonionic emulsifier, a cationic emulsifier, or an amphoteric emulsifier, according to the type of the hydrophilic functional group.

The hydrophobic group of the reactive emulsifier is not particularly limited, and examples thereof include an alkyl group and a phenyl group. The radically polymerizable double bond of the reactive emulsifier is not particularly limited, and examples thereof include a vinyl group and an acryloyl group or a methacryloyl group. The radically polymerizable double bond, the hydrophilic functional group, and the hydrophobic group may each be included in the molecular structure in a combination of several types.

The commercially available surfactant can be used as the reactive emulsifier. The commercially available anionic surfactant is not particularly limited, and examples thereof include ADEKA REASOAP SE (manufactured by ADEKA Corporation), Aqualon HS, BC, and KH (manufactured by DKS Co. Ltd.), LATEMUL S (manufactured by Kao Corporation), Antox MS (manufactured by Nippon Nyukazai Co., Ltd.), ADEKA REASOAP SDX and PP (manufactured by ADEKA Corporation), Hightenol A (manufactured by DKS Co. Ltd.), ELEMINOL RS (manufactured by Sanyo Chemical Industries, Ltd.), and SPINOMAR (manufactured by Toyo Soda Kogyo Kabushiki Kaisha). The commercially available nonionic surfactant is not particularly limited, and examples thereof include Aqualon RN and Noigen N (manufactured by DKS Co. Ltd.) and ADEKA REASOAP NE (manufactured by ADEKA Corporation). These may be used singly, or two or more thereof may be used in combination.

The amount of the reactive emulsifier used is preferably 1 part by mass or more and 20 parts by mass or less per 100 parts by mass of the polymer particles (i) calculated from the amount of starting materials fed. When the amount of the reactive emulsifier is 1 part by mass or more, image reproducibility of a printing plate obtained tends to improve. When the amount of the reactive emulsifier is 20 parts by mass or less, wear resistance of the printing plate obtained tends to improve.

Examples of the non-reactive emulsifier include, but not particularly limited to, anionic surfactants such as fatty acid soap, rosin acid soap, a sulfonate, a sulfate, a phosphate, a polyphosphate, and an acyl sarcosinate; cationic surfactants such as a nitrilated fat or oil derivative, a fat or oil derivative, a fatty acid derivative, and an $\alpha$-olefin derivative; and nonionic surfactants such as an alcohol ethoxylate, an alkylphenol ethoxylate, a propoxylate, a fatty acid alkanolamide, an alkyl polyglycoside, a polyoxyethylene sorbitan fatty acid ester, and an oxyethylene oxypropylene block copolymer. These may be used singly, or two or more thereof may be used in combination.

Examples of the above-described sulfonate include, but not particularly limited to, an alkyl sulfonate, an alkyl sulfate, an alkyl sulfosuccinate, a polyoxyethylene alkyl sulfate, sulfonated fat or oil, an alkyldiphenylether disulfonate, an $\alpha$-olefin sulfonate, an alkyl glyceryl ether sulfonate, and an N-acylmethyltaurate. Examples of the non-reactive emulsifier other than those described above include, but are not particularly limited to, those described in "Kaimenkasseizai handobukku (Surfactant Handbook) (Takahashi, Namba, Koike, Kobayashi: Kougakutosho Ltd., 1972)".

The amount of the non-reactive emulsifier used is preferably less than 1 part by mass per 100 parts by mass of the polymer particles (i) calculated from an amount of starting material fed. When the amount of the non-reactive emulsifier used is less than 1 part by mass, a printing plate to be obtained has an appropriate water swelling ratio, and a decrease of abrasion resistance occurring when ink attaches and a decrease of image reproducibility after absorbing moisture can be thus prevented.

The polymerization initiator is not particularly limited, and examples thereof include a radical polymerization initiator. The radical polymerization initiator is not particularly limited and is, for example, radically decomposed under the presence of heat or a reducing substance to initiate addition polymerization of monomers, and both of an inorganic initiator and an organic initiator can be used.

The radical polymerization initiator is not particularly limited, and examples thereof include a water-soluble or oil-soluble peroxodisulfate, a peroxide, and an azobis compound, and specific examples thereof include potassium peroxodisulfate, sodium peroxodisulfate, ammonium peroxodisulfate, hydrogen peroxide, t-butyl hydroperoxide, benzoyl peroxide, 2,2-azobis butyronitrile, and cumene hydroperoxide. Compounds described in POLYMER HANDBOOK (3rd edition), written by J. Brandup and E.H. Immergut, published by John Willy & Sons, (1989) can also be used as the radical polymerization initiator. A so-called redox polymerization method, in which a reducing agent such as sodium acidic sulfite, ascorbic acid or a salt thereof, erythorbic acid and a salt thereof, or Rongalit is used in combination with a polymerization initiator, can also be employed. Among them, peroxodisulfate is preferable as the polymerization initiator.

The amount of the polymerization initiator used is preferably 0.1% by mass or more and 5.0% by mass or less, and more preferably 0.2% by mass or more and 3.0% by mass or less based on the total amount of monomers used for polymerization of the polymer particles (i). When the amount of the polymerization initiator used is 0.1% by mass or more, high stability can be obtained at the time of synthesizing the polymer particles (i). When the amount of the polymerization initiator used is 5.0% by mass or less, the amount of moisture absorbed by the photosensitive resin composition can be reduced so as to fall within a practically preferable range.

A known chain transfer agent can be used in the polymerization process of the polymer particles (i). A chain transfer agent including sulfur can be preferably used as the chain transfer agent. Examples of the chain transfer agent including sulfur include, but not particularly limited to, an alkanethiol such as t-dodecyl mercaptan and n-dodecyl mercaptan; a thioalkyl alcohol such as mercaptoethanol and mercaptopropanol; a thioalkyl carboxylic acid such as thioglycolic acid and thiopropionic acid; an alkyl thiocarboxylate acid such as octyl thioglycolate and octyl thiopropionate; and a sulfide such as dimethyl sulfide and diethyl sulfide.

Examples of the other chain transfer agents include, but not particularly limited to, terpinolene, dipentene, t-terpinene, and a hydrocarbon halide such as carbon tetrachloride. Among these chain transfer agents, alkanethiols are preferable because they have large chain transfer rates and give polymerization products having well-balanced physical properties. These chain transfer agents may be used singly, or two or more thereof may be used in combination.

These chain transfer agents are mixed to monomers and then supplied to a reaction system or independently added in a predetermined amount at a predetermined time. The amount of these chain transfer agents used is preferably 0.1% by mass or more and 10% by mass or less based on the total amount of monomers used for polymerization of the polymer particles (i). The amount of 0.1% by mass or more provides good processability at the time of mixing the photosensitive resin composition, and the amount of 10% by mass or less enables the number average molecular weight of the polymer particles (i) to be practically sufficient.

A polymerization reaction suppressing agent can be used for polymerization of the polymer particles (i) as needed. The polymerization reaction suppressing agent is a compound added to an emulsion polymerization system to decrease a radical polymerization rate. More specifically, the polymerization reaction suppressing agent includes a polymerization rate retardant, a polymerization inhibitor, a chain transfer agent with low radical reinitiation reactivity, and a monomer with low radical reinitiation reactivity. The polymerization reaction suppressing agent is usually used for adjusting a polymerization reaction rate and adjusting physical properties of a latex. These polymerization reaction suppressing agents are added to a reaction system by batch operation or continuous operation. When the polymerization reaction suppressing agent is used, strength of a latex coating improves, and wear resistance of the plate thus improves. While details of the reaction mechanism is unclear, the polymerization reaction suppressing agent is thought to closely relate to steric structure of a polymer, and it is assumed that the polymerization reaction suppressing agent thus has an effect of adjusting physical properties of a latex coating.

Examples of the polymerization reaction suppressing agent include, but not particularly limited to, quinones such as o-, m-, or p-benzoquinone; nitro compounds such as nitrobenzene, o-, m-, or p-dinitrobenzene; amines such as diphenylamine; catechol derivatives such as tertiary butyl catechol; 1,1-di-substituted vinyl compounds such as 1,1-diphenylethylene or $\alpha$-methylstyrene and 2,4-diphenyl-4-methyl-1-pentene; and 1,2-di-substituted vinyl compounds such as 2,4-diphenyl-4-methyl-2-pentene and cyclohexene. Besides, compounds described as a polymerization inhibitor or polymerization suppressing agent in "POLYMER HANDBOOK 3rd Ed. (J. Brandup, E.H. Immergut: John Wiley & Sons, 1989)," and "Kaitei koubunshigousei no kagaku (Chemistry of polymer synthesis revised edition) (Otsu: Kagaku-Dojin Publishing Company, INC, 1979)" are exemplified.

Among them, 2,4-diphenyl-4-methyl-1-pentene ($\alpha$-methylstyrene dimer) is especially preferable in view of reactivity. These polymerization reaction suppressing agents may be used singly, or two or more thereof may be used in combination.

The amount of these polymerization reaction suppressing agents used is preferably 10% by mass or less based on the total amount of monomers used for polymerization of the polymer particles (i). By setting the amount to 10% by mass or less, a practically sufficient polymerization rate tends to be obtained.

Various polymerization adjusters such as a pH adjuster and a chelating agent can be added at the time of synthesizing the polymer particles (i) as needed.

The pH adjuster is not particularly limited, and examples thereof include sodium hydroxide, potassium hydroxide, ammonium hydroxide, sodium hydrogen carbonate, sodium carbonate, and disodium hydrogen phosphate.

The chelating agent is not particularly limited, and examples thereof include sodium ethylenediaminetetraacetate.

Furthermore, as other additives, various additives may be added, including a viscosity reducing agent such as an alkali-sensitive latex and hexametaphosphoric acid; a water-soluble polymer such as a polyvinyl alcohol and carboxymethyl cellulose; a thickening agent; various antioxidants; an ultraviolet absorber; an antiseptic agent; a bactericidal agent; a defoaming agent; a dispersant such as sodium polyacrylate; a water resistant agent; a metal oxide such as zinc oxide; a crosslinking agent such as an epoxy compound; an isocyanate-based compound; a lubricant; and a water retaining agent.

A method for adding these additives is not particularly limited, and these additives can be added during synthesis or after synthesis of the polymer particles (i).

The polymerization temperature in the case where the polymer particles (i) are prepared through emulsion polymerization is usually 60°C or higher and 120°C or lower. Polymerization may be carried out by the above-described redox polymerization method or the like at a lower temperature. Furthermore, a metal catalyst, for example, but not particularly limited to, divalent iron ion, trivalent iron ion, and copper ion may be allowed to coexist as a redox catalyst.

<Thermoplastic elastomer (ii)>

The thermoplastic elastomer (ii) according to the second embodiment is an elastomer that exhibits rubber elasticity at ordinary temperature (25°C) and is not particularly limited, and examples thereof include a thermoplastic block copolymer having a constituent unit derived from conjugated diene and/or an aromatic vinyl compound, polybutadiene, polyacrylonitrile-butadiene, and polyurethane-based elastomers. The thermoplastic elastomer may be a homopolymer or a copolymer. In the case of a copolymer, the thermoplastic elastomer may be a random copolymer or a block copolymer. Among them, a thermoplastic elastomer containing at least one polymer block including mainly a conjugated diene and at least one polymer block including mainly an aromatic vinyl compound is preferable.

The term "including mainly" used herein means that 60% by mass or more of the polymer block is constituted by a predetermined monomer.

The thermoplastic elastomer (ii) is a soft binder having a relatively small storage modulus and can therefore form the regions (B1) and (B2). This enhances following properties for a printing base material and improves ink lay down on a paper package.

The Tg of the thermoplastic elastomer (ii) is preferably -95°C or higher and -60°C or lower. This can decrease a storage modulus near a frequency band of 2,000 Hz in the dynamic elasticity mapping measurement by AFM. The regions (B1) and (B2) can be thereby formed.

Lower Tg of the thermoplastic elastomer (ii) tends to decrease the storage modulus of the regions (B1) and (B2) and can enhance following properties for a printing base material and improve ink lay down on a paper package. From such viewpoints, the Tg of the thermoplastic elastomer (ii) is -60°C or lower, preferably -70°C or lower, and still more preferably-80°C or lower.

Higher Tg of the thermoplastic elastomer (ii) tends to increase the storage modulus of the regions (B1) and (B2) and can suppress halftone chipping. From such viewpoints, the Tg of the thermoplastic elastomer (ii) is -95°C or higher, and more preferably -90°C or higher.

The Tg of the thermoplastic elastomer (ii) can be determined by dynamic viscoelasticity measurement. A detailed measurement method is as described in Examples described later.

A commercially available product can be used as the thermoplastic elastomer (ii). In the case of a commercially available product, catalog data or a known literature can be adopted to the Tg.

A larger amount of the thermoplastic elastomer (ii) added in the photosensitive resin composition is preferable in view of increasing the area ratios of the regions (B1) and (B2) and improving ink lay down on a paper package. Specifically, the amount is preferably 20% by mass or more, more preferably 25% by mass or more, and especially preferably 30% by mass or more based on 100% by mass in total of the photosensitive resin composition layer.

On the other hand, a smaller amount of the thermoplastic elastomer (ii) added in the photosensitive resin composition is preferable in view of decreasing the area ratios of the regions (B1) and (B2) and suppressing halftone chipping and slur. Specifically, the amount is preferably 55% by mass or less, more preferably 50% by mass or less, and especially preferably 45% by mass or less based on 100% by mass in total of the photosensitive resin composition layer.

In the photosensitive resin composition layer, the mass ratio of the polymer particles (i) to the thermoplastic elastomer (ii) is preferably 0.1 or more and 1.0 or less, more preferably 0.2 or more and 0.8 or less, and especially preferably 0.3 or more and 0.7 or less.

This enables the ratio (A2/B2) of the area ratio of the region (A2) to the area ratio of the region (B2) to be designed in the intended numeric range, and can suppress halftone chipping and slur while softness is maintained.

In the polymer block including mainly a conjugated diene, the content of the conjugated diene unit is preferably 80% by mass or more and more preferably 90% by mass or more in the polymer block.

The conjugated diene is not particularly limited, and examples thereof include monomers such as 1,3-butadiene, isoprene, 2,3-dimethyl-1,3-butadiene, 2-methyl-1,3-pentadiene, 1,3-hexadiene, 4,5-diethyl-1,3-octadiene, 3-butyl-1,3-octadiene, and chloroprene. Among them, 1,3-butadiene is especially preferable in view of abrasion resistance. These monomers may be used singly or in combinations of two or more thereof.

A vinyl content in the polymer block including mainly the conjugated diene is preferably 5 mol% or more and 50 mol% or less, more preferably 8 mol% or more and 50 mol% or less, and still more preferably 10 mol% or more to 40 mol% or less based on the total amount of the conjugated diene unit in view of printing plate formability. The "vinyl content" herein is not particularly limited and refers to a content of 1,2-butadiene or 3,4-isoprene, for example.

A number average molecular weight of the polymer block including mainly the conjugated diene is preferably 20,000 or more and 250,000 or less, more preferably 30,000 or more and 200,000 or less, and still more preferably 40,000 or more and 150,000 or less in view of wear resistance.

The number average molecular weight can be determined by gel permeation column chromatography (GPC). A detailed method is as described in Examples described later.

The polymer block including mainly the conjugated diene may contain an alkylene unit. An introducing method of the alkylene unit is not particularly limited, and examples thereof include a method involving polymerization using a monoolefin such as ethylene and butylene as a starting material monomer of the polymer block including mainly the conjugated diene, and a method involving hydrogenating conjugated diene polymer block. Especially, a method involving hydrogenating polymer block including mainly the conjugated diene is preferable in view of availability.

The content of the alkylene unit in the polymer block including mainly the conjugated diene is preferably 5 mol% or more and 50 mol% or less, more preferably 10 mol% or more and 35 mol% or less, and still more preferably 10 mol% or more and 25 mol% or less based on the total amount of monomer units included in the polymer block. When the content of the alkylene unit is 5 mol% or more, solvent resistance tends to more improve. When the content of the alkylene unit is 50 mol% or less, transparency of the photosensitive resin composition layer tends to more improve.

The polymer block including mainly the conjugated diene preferably contains an alkylene unit and more preferably contains all of a 1,4-butadiene unit, a 1,2-butadiene (vinyl) unit, and a butylene (alkylene) unit. In this respect, it is further preferable that the polymer block including mainly the conjugated diene contain 25 mol% or more and 70 mol% or less of a 1,4-butadiene unit, 0 mol% or more and 50 mol% or less of a 1,2-butadiene (vinyl) unit, and 10 mol% or more and 50 mol% or less of a butylene unit. Such a polymer block can be obtained by hydrogenating the polymer block moiety including mainly butadiene.

The conjugated diene content, the vinyl content in the conjugated diene, and the content and ratio of the aromatic vinyl compound can be measured using a nuclear magnetic resonance device ($^1$H-NMR).

The aromatic vinyl compound is not particularly limited, and examples thereof include monomers such as styrene, t-butylstyrene, divinylbenzene, 1,1-diphenylstyrene, N,N-dimethyl-p-aminoethylstyrene, N,N-diethyl-p-aminoethylstyrene, vinylpyridine, p-methylstyrene, tertiary butylstyrene, α-methylstyrene, and 1,1-diphenylethylene. Especially, styrene is preferable because a flexographic printing raw plate with smoothness can be formed at a relatively low temperature (hereinafter, also referred to as "high smoothness"). These monomers may be used singly, or in combinations of two or more thereof.

A number average molecular weight of the polymer block including mainly the aromatic vinyl compound is preferably 100,000 or less in view of preventing orientation of a printing plate from being exhibited and is preferably 3,000 or more in view of chipping resistance during plate making and printing. The number average molecular weight of the polymer block including mainly the aromatic vinyl compound is more preferably 5,000 or more and 80,000 or less and still more preferably 5,000 or more and 60,000 or less.

The content of the aromatic vinyl compound in the block copolymer is preferably 13% by mass or more and 30% by mass or less, more preferably 15% by mass or more and 28% by mass or less, and still more preferably 16% by mass or more and 25% by mass or less based on the total amount of the block copolymer. When the content of the aromatic vinyl compound is 30% by mass or less, high smoothness of the photosensitive resin composition, high chipping resistance at a convex part of the printing plate, and hardness of the printing plate kept high when an ink component attaches thereto tend to be attained. On the other hand, when the content of the aromatic vinyl compound is 13% by mass or more, cold flow resistance of the flexographic printing raw plate tends to more improve.

<Photopolymerizable compound (iii)>

The photopolymerizable compound (iii) refers to a compound having a photopolymerizable reactive group. Examples of the photopolymerizable compound include, but not particularly limited to, esters of acids such as acrylic acid, methacrylic acid, fumaric acid, and maleic acid; derivatives of acrylamides and methacrylamides; allyl esters, styrene, and derivatives thereof; and N-substituted maleimide compounds.

The photopolymerizable compound (iii) is a preferable component in view of conferring photosensitivity and forming a relief layer with an arbitrary pattern to be printed.

Examples of the photopolymerizable compound (iii) can include, but not particularly limited to, diacrylates and dimethacrylates of alkanediols such as 1,6-hexanediol and 1,9-nonanediol; or (meth)acrylates and di(meth)acrylates of polybutadiene, polyisoprene, ethylene glycol, diethylene glycol, propylene glycol, dipropylene glycol, polyethylene glycol, butylene glycol, and dicyclopentadienyl; trimethylolpropane tri(meth)acrylate, dimethyloltricyclodecane di(meth)acrylate, and alkyl (meth)acrylates such as ethyl (meth)acrylate, butyl (meth)acrylate, lauryl (meth)acrylate, stearyl (meth)acrylate, tridecyl (meth)acrylate, tetradecyl (meth)acrylate, and pentadecyl (meth)acrylate; isobornyl (meth)acrylate, phenoxypolyethyleneglycol (meth)acrylate, pentaerythorit tetra(meth)acrylate, N,N'-hexamethylenebisacrylamide and N,N'-hexamethylenebismethacrylamide, styrene, vinyltoluene, divinylbenzene, diacrylphthalate, triallyl cyanurate, diethyl fumarate, dibutyl fumarate, dioctyl fumarate, distearyl fumarate, butyl octyl fumarate, diphenyl fumarate, dibenzyl fumarate, dibutyl maleate, dioctyl maleate, bis(3-phenylpropyl) fumarate, dilauryl fumarate, dibehenyl fumarate, and N-lauryl maleimide. These may be used singly, or two or more thereof may be used in combination.

The photopolymerizable compound (iii) is preferably a compound having a (meth)acryloyl group in view of reactivity. A difunctional photopolymerizable compound having two (meth)acryloyl groups in one molecule is especially preferable and is also preferably used in combination with a monofunctional or trifunctional photopolymerizable compound according to a purpose.

A larger content of the photopolymerizable compound (iii) is preferable for enhancing plate formability and chipping resistance, and a smaller content is preferable in view of maintaining softness and improving ink lay down on a paper package. Taking the balance among them into consideration, when the total amount of the photosensitive resin composition is defined as 100% by mass, the content is preferably 5% by mass or more and 30% by mass or less, more preferably 8% by mass or more and 25% by mass or less, and still more preferably 10% by mass or more and 20% by mass or less.

The photosensitive resin composition of the second embodiment preferably comprises a photopolymerizable compound having a number average molecular weight of 100 or more and 1,000 or less as the photopolymerizable compound (iii). Such a low-molecular-weight photopolymerizable compound contained therein can from dense crosslinking when photocured, and can enhance halftone chipping resistance by elevating an elastic modulus. The number average molecular weight is more preferably 150 or more and 800 or less, and still more preferably 200 or more and 600 or less.

The photosensitive resin composition of the second embodiment preferably comprises a photopolymerizable compound having a number average molecular weight of 2,000 or more and 8,000 or less as the photopolymerizable compound (iii). Such a high-molecular-weight photopolymerizable compound contained therein is capable of crosslinking the whole resin composition without elevating a crosslinking density when photocured, and can enhance chipping resistance while softness is maintained. Although the details thereof are not clear, the inventors surmise the following. However, the technical mechanism thereof is not limited by the following by any means.

First, the number average molecular weight of 2,000 or more can increase the distance between crosslinking points. This enables phase-separated structures such as the regions (A1) and (A2) or (B1) and (B2) according to the present embodiment to be crosslinked so as to span the respective regions, and presumably improves chipping resistance by suppressing an interfacial delamination phenomenon between the respective regions.

From such viewpoints, the number average molecular weight is preferably 2,000 or more, more preferably 3,000 or more, and especially preferably 4,000 or more.

An end of the molecular chain is preferably modified with a (meth)acryloyl group in view of increasing the distance between crosslinking points.

The above-described photopolymerizable compound having a number average molecular weight of 2,000 or more and 8,000 or less preferably has a conjugated diene compound in the main chain. A problem of such a high-molecular-weight photopolymerizable compound is that this compound is less compatible with other components in the photosensitive resin composition because of its high molecular weight. The photopolymerizable compound having a conjugated diene compound in the main chain is highly compatible with both the polymer particles (i) and the thermoplastic elastomer (ii) and can be uniformly dispersed or dissolved in the photosensitive resin composition. The photopolymerizable compound serves as one type of compatibilizing agent and can thereby form the regions (C1) and (C2) as regions where the polymer particles (i) having a high elastic modulus are mixed with the thermoplastic elastomer (ii) having a low elastic modulus. This can suppress local concentration of stress ascribable to sharp difference in elastic modulus between the region (A1) and the region (B1), and produces effects of stabilizing quality during long-run printing and improving wear resistance, according to the surmise of the inventors. However, the technical mechanism is not limited by the description above by any means.

From such viewpoints, the structure of the main chain especially preferably comprises polybutadiene.

A smaller number average molecular weight is preferable in view of compatibility. The number average molecular weight is preferably 8,000 or less, more preferably 7,000 or less, still more preferably 6,000 or less, and especially preferably 5,000 or less.

The number average molecular weight can be determined by gel permeation column chromatography (GPC). A detailed method is as described in Examples described later.

Examples of the above-described photopolymerizable compound having a number average molecular weight of 2,000 or more and 8,000 or less include, but are not particularly limited to, BAC-45 (manufactured by Osaka Organic Chemical Industry Ltd.), ABU-2S (manufactured by Kyoeisha Chemical Co., Ltd.), CN307 (manufactured by Sartomer USA, LLC), and CN9014NS (manufactured by Sartomer USA, LLC).

A larger amount of the photopolymerizable compound having a number average molecular weight of 2,000 or more and 8,000 or less, added in the photosensitive resin composition is preferable in view of increasing the area ratios of the regions (C1) and (C2) and improving wear resistance during long-run printing. Specifically, the amount is preferably 1% by mass or more, more preferably 3% by mass or more, and especially preferably 5% by mass or more based on 100% by mass in total of the photosensitive resin composition layer.

On the other hand, a smaller amount of the polymer particles (i) added in the photosensitive resin composition is preferable in view of decreasing the area ratios of the regions (C1) and (C2) and improving ink lay down and halftone quality. Specifically, the amount is preferably 20% by mass or less, more preferably 15% by mass or less, and especially preferably 10% by mass or less based on 100% by mass in total of the photosensitive resin composition layer.

<Photopolymerization initiator (iv)>

The photopolymerization initiator (iv) is a compound absorbing energy of light and generating a radical. Various known initiators can be used therefor, and various organic carbonyl compounds, especially aromatic carbonyl compounds are preferably used.

The photopolymerization initiator (iv) is a preferable component in view of conferring photosensitivity and forming a relief layer with an arbitrary pattern to be printed.

Examples of the photopolymerization initiator (iv) include, but not particularly limited to, benzophenone, 4,4-bis(diethylamino)benzophenone, t-butyl anthraquinone, 2-ethyl anthraquinone, thioxanthones such as 2,4-diethylthioxanthone, isopropylthioxanthone, and 2,4-dichlorothioxanthone; acetophenones such as diethoxyacetophenone, benzyl dimethyl ketal, 2,2-dimethoxy-phenylacetophenone, 2-hydroxy-2-methyl-1-phenylpropane-1-on, benzyl dimethyl ketal, 1-hydroxycyclohexyl-phenyl ketone, 2-methyl-2-morpholino(4-thiomethylphenyl)propane-1-on, and 2-benzyl-2-dimethylamino-1-(4-morpholinophenyl)-butanone; benzoin ethers such as benzoin methyl ether, benzoin ethyl ether, benzoin isopropyl ether, and benzoin isobutyl ether; acylphosphine oxides such as 2,4,6-trimethylbenzoyldiphenylphosphine oxide, bis(2,6-dimethoxybenzoyl)-2,4,4-trimethylpentylphosphine oxide, and bis(2,4,6-trimethylbenzoyl)-phenylphosphine oxide; methyl benzoylformate; and 1,7-bisacridinylheptane; 9-phenylacridine; and 2,6-di-t-butyl-p-cresol. These may be used singly, or two or more thereof may be used in combination.

A larger content of the photopolymerization initiator (iv) is preferable for enhancing plate formability and chipping resistance, and a smaller content is preferable in view of uniformly curing the plate through. Taking the balance among them into consideration, when the total amount of the photosensitive resin composition is defined as 100% by mass, the content is preferably 0.5% by mass or more and 15.0% by mass or less, more preferably 1.0% by mass or more and 10.0% by mass or less, and still more preferably 1.5% by mass or more and 8.0% by mass or less.

A cleavable photopolymerization initiator and a hydrogen-drawing type photopolymerization initiator may be used in combination as the photopolymerization initiator (iv). The amount of the hydrogen-drawing type photopolymerization initiator in the photosensitive resin composition is preferably 1.0% by mass or less and more preferably 0.5% by mass because image reproducibility of a printing plate and abrasion resistance are high.

<Plasticizer (v)>

The photosensitive resin composition of the present embodiment may contain a liquid compound having good compatibility with the thermoplastic elastomer (ii) described above as the plasticizer (v).

Examples of the plasticizer (v) include, but are not limited to, liquid 1,2 (or 1,4)-polybutadiene and 1,2 (or 1,4)-polyisoprene having a weight average molecular weight of 500 or more and 60000 or less, liquid acrylonitrile-butadiene copolymers, liquid styrene-butadiene copolymers, terminally modified products thereof, naphthene oil, paraffin oil, polystyrene having a number average molecular weight of 2,000 or less, sebacic acid ester, and phthalic acid ester.

These plasticizers (v) may be used singly, or two or more thereof may be used in combination.

Particularly, in the case of using a styrene-butadiene-styrene copolymer as the thermoplastic elastomer (ii) described above, the plasticizer is preferably liquid diene such as liquid 1,2 (or 1,4)-polybutadiene or 1,2 (or 1,4)-polyisoprene in view of miscibility with the styrene-butadiene-styrene copolymer. The liquid diene is a liquid compound having a carbon-carbon double bond and refers to a copolymer having 50% by mass or more of a diene component. The term "liquid" of the "liquid diene" used herein means a form having the property of being flow-deformable at room temperature and capable of being solidified into a deformed shape by cooling, and corresponds to an elastomer having the following property: when external force is applied, deformation occurs instantly depending on the external force, and when the external force is removed, the original shape is recovered in a short time.

The 1,2 (or 1,4)-polybutadiene as the liquid diene is not particularly limited, and examples thereof include B1000, B2000, and B3000 (manufactured by Nippon Soda Co., Ltd.), LBR-352, LBR-305, and LBR-300 (manufactured by Kuraray Co., Ltd.), POLYVEST110 and 130 (manufactured by Evonik Industries AG), and Ricon152, Ricon153, and Ricon156 (manufactured by Sartomer USA, LLC). The liquid 1,2 (or 1,4)-polyisoprene is not particularly limited, and examples thereof include LIR-30 and LIR-50 (manufactured by Kuraray Co., Ltd.).

The number average molecular weight of the plasticizer (v) is not particularly limited as long as the plasticizer is liquid at 20°C. The number average molecular weight is preferably 200 or more and 60,000 or less, more preferably 300 or more and 40,000 or less, and still more preferably 500 or more and 30,000 or less in view of the handleability of the flexographic printing raw plate of the second embodiment.

A larger content of the plasticizer (v) in the photosensitive resin composition layer is preferable in view of enhancing softness, and a smaller content is preferable in view of improving wear resistance. When the total amount of the photosensitive resin composition is defined as 100% by mass, the content is preferably 10% by mass or more and 50% by mass, more preferably 15% by mass or more and 45% by mass or less, and still more preferably 20% by mass or more and 40% by mass or less.

<Stabilizer (vi)>

The photosensitive resin composition of the present embodiment may comprise a stabilizer (vi) in order to suppress undesirable reaction during storage or during manufacturing. The stabilizer (vi) of the present embodiment is meant to include a polymerization inhibitor, an antiaging agent, an antioxidant, a photostabilizer, an ultraviolet absorber, and an ozone-proof agent, and a stabilizer usually used in the fields of resin materials or rubber materials can be used.

Specific examples thereof include, but are not limited to, phenol-based, phosphite-based, amine-based, and thioether-based heat stabilizers, benzophenone-based, salicylate-based, benzotriazole-based, acrylonitrile-based, metal complex-based, and hindered amine-based photostabilizers.

Examples of the heat stabilizer include, but are not limited to, hydroquinone, P-methoxyphenol, 2,6-di-t-butylcresol, catechol, t-butylcatechol, vitamin E, tetrakis-(methylene-3-(3',5'-di-t-butyl-4'-hydroxyphenyl)propionato) methane, 2,5-di-t-butylhydroquinone, 2-t-butyl-6-(3-t-butyl-2-hydroxy-5-methylbenzyl)-4-methylphenyl acrylate, bis(3,5-di-t-butyl-4-hydroxybenzyl) sulfide, 4,6-bis(octylthiomethyl)-o-cresol, 2,6-di-t-butyl-4-(4,6-bis(octylthio)-1,3,5-triazin-2-ylamino)phenol, ethylenebis(oxyethylene)bis[3-(5-t-butyl-4-hydroxy-m-tolyl) propionate], and tris(2,4-di-t-butylphenyl) phosphite. Among them, hydroquinone, 2,6-di-t-butylcresol, 2-t-butyl-6-(3-t-butyl-2-hydroxy-5-methylbenzyl)-4-methylphenyl acrylate, and bis(3,5-di-t-butyl-4-hydroxybenzyl) sulfide are preferable as materials that can achieve high heat stability while maintaining photoreactivity.

Examples of the photostabilizer include, but are not limited to, 2-(5-methyl-2-hydroxyphenyl)benzotriazole, 2-[2-hydroxy-3,5-bis($\alpha,\alpha$-dimethylbenzyl)phenyl]-2H-benzotriazole, 2-(3,5)-di-t-butyl-2-hydroxyphenyl)benzotriazole, 2-ethoxy-2'-ethyloxalic acid bisanilide, 2,2'-dihydroxy-4-methoxybenzophenone, tetrakis(2,2,6,6-tetramethyl-4-piperidyl) butane-1,2,3,4-tetracarboxylate, and bis(1,2,2,6,6-pentamethyl-4-piperidyl) sebacate.

The stabilizer (vi) is preferably contained at 0.05% by mass or more and 10% by mass or less, more preferably at 0.1% by mass or more and 5% by mass or less, and still more preferably at 0.3% by mass or more and 3% by mass or less based on 100% by mass of the total amount of the photosensitive resin composition of the present embodiment.

The stabilizer (vi) contained at 0.05% by mass or more in the photosensitive resin composition can prevent unscheduled polymerization reaction ascribable to heat during resin kneading. This can prevent reduction in development performance. The stabilizer (vi) contained at 10% by mass or less can prevent reduction in curing rate ascribable to exposure or enables an image of a very small size to be formed during relief formation.

The photostabilizer is added for adjusting the sensitivity of a resin, i.e., a curing reaction rate through photopolymerization reaction. The amount of such a stabilizer added differs depending on the absorbance of the substance at a certain wavelength. Therefore, a proper numeric range of the amount of the stabilizer added is selected according to the material used.

The ozone-proof agent is preferably added for suppressing ozone that is generated during exposure to a germicidal lamp in a plate making step or deterioration caused by ozone that is generated by in-line corona treatment of a raw film in printing. Since such a stabilizer also has a function of reducing the curing sensitivity of a photosensitive resin, it is preferable to adjust the amount of the stabilizer added together with the amount of the polymerization inhibitor.

<Detergent builder (vii)>

The photosensitive resin composition of the present embodiment may contain a detergent builder (vii) in order to enhance water development performance. The detergent builder (vii) according to the present embodiment refers to a compound that has a hydrophilic moiety and is dissolved or dispersed in water or alkali water, such as a surfactant or a polymer having an acidic group.

The surfactant is not particularly limited, and examples thereof can include an ionic surfactant, a nonionic surfactant, an ionic reactive surfactant, and a nonionic reactive surfactant.

Specific examples of the surfactant include, but are not particularly limited to, anionic surfactants such as sodium polyoxyethylene styrenated phenyl ether sulfate, a sodium polyoxyalkylene branched decyl ether sulfate, an ammonium polyoxyethylene isodecyl ether sulfate, a sodium polyoxyethylene tridecyl ether sulfate, a sodium polyoxyethylene lauryl ether sulfate, an ammonium polyoxyethylene lauryl ether sulfate, a sodium polyoxyethylene alkyl ether sulfate, an ammonium polyoxyethylene oleyl cetyl ether sulfate, a sodium polyoxyethylene oleyl cetyl ether sulfate, a polyoxyethylene tridecyl ether phosphate, a polyoxyethylene alkyl (C2-C16) ether phosphate, a polyoxyethylene alkyl (C2-C16) ether phosphate-monoethanolamine salt, a sodium alkyl (C2-C16) phosphate, an alkyl (C2-C16) phosphate-monoethanolamine salt, disodium lauryl sulfosuccinate, a disodium lauryl polyoxyethylene sulfosuccinate, a disodium polyoxyethylene alkyl (C2-C20) sulfosuccinate, a sodium linear alkylbenzene sulfonate, a linear alkylbenzene sulfonate, a sodium alpha-olefin sulfonate, phenolsulfonic acid, sodium dioctyl sulfosuccinate, sodium lauryl sulfate, and a higher fatty acid potassium salt; ionic surfactants such as an alkyl (C8-C20) trimethylammonium chloride, an alkyl (C8-C20) dimethylethylammonium chloride, didecyldimethylammonium chloride, lauryl dimethyl benzyl ammonium chloride, stearyl dimethyl hydroxyethyl ammonium para-toluene sulfonate, stearyl dimethyl aminopropylamide, tributyl benzyl ammonium chloride, lauryl dimethyl aminoacetic acid betaine, laurylamide propyl betaine, cocamidepropyl betaine, octanamide propyl betaine, and lauryl dimethyl amine oxide; nonionic surfactants such as a polyoxyalkylene tridecyl ether, a polyoxyethylene isodecyl ether, a polyoxyalkylene lauryl ether, a polyoxyalkylene alkyl ether, a mixture of a polyoxyalkylene ether and a polyether polyol, a polyether polyol, a polyoxyethylene sulfonated phenyl ether, a polyoxyethylene naphthyl ether, phenoxyethanol, a polyoxyethylene phenyl ether, a polyoxyethylene polyoxypropylene glycol, a polyoxyethylene lauryl ether, a polyoxyethylene oleyl cetyl ether, a polyoxyethylene oleate, a polyoxyethylene distearate, a polyoxyethylene glyceryl isostearate, polyoxyethylene-cured castor oil, coconut fatty acid diethanolamide, polyoxyethylene alkylamine, sorbitan trioleate, sorbitan sesquioleate, sorbitan monooleate, sorbitan monococoate, sorbitan monocaprylate, a polyoxyethylene sorbitan monococoate, a polyoxyethylene sorbitan monostearate, a polyoxyethylene sorbitan monooleate, octyl polyglycoside, a butyl polyglycoside, sucrose benzoate, sucrose acetate, and a sucrose fatty acid ester; anionic reactive surfactants such as an ammonium polyoxyethylene-1-(allyloxymethyl)alkyl ether sulfate and an ammonium polyoxyethylene nonyl propenyl phenyl ether sulfate; and nonionic reactive surfactants such as a polyoxyethylene nonyl propenyl phenyl ether. These surfactants may be used singly, or two or more thereof may be used in combination.

A commercially available product can be used as the surfactant. The commercially available product is not particularly limited, and examples thereof include "NEWCOL series" having an alkyl ether structure and "NEWCOL NT series" (manufactured by Nippon Nyukazai Co., Ltd.), NOIGEN TDS, XL, TDX, SD, and DKS-NL series (manufactured by DKS Co. Ltd.), and EMULMIN series and SANNONIC series (manufactured by Sanyo Chemical Industries, Ltd.). Other examples thereof include "NEWCOL 7XX series" having a polyoxyethylene polycyclic phenyl ether structure (manufactured by Nippon Nyukazai Co., Ltd.) and NOIGEN EA-167 (manufactured by DKS Co. Ltd.)

The "acidic group" of the polymer having the acidic group is not particularly limited, and examples thereof include a carboxyl group, a sulfonic acid group, a sulfinic acid group, a sulfuric acid group, a phosphoric acid group, a phosphonic acid group, a phosphinic acid group, and a phenol group. Among these groups, a carboxyl group is preferable. The ratio of a neutralized salt that is generated when an acid is neutralized with an alkali metal, $NH_3$, or the like in the structure of the acidic group is preferably 30% or less, more preferably 20% or less, and still more preferably 10% or less. When the ratio of the neutralized salt is 30% or less, water resistance tends to be able to be kept high.

The polymer having the acidic group is not particularly limited, and examples thereof include polymers having a polyisoprene skeleton, a polybutadiene skeleton, a polyvinyl skeleton, and a polyacrylate skeleton. Among them, a polymer having a polyacrylate skeleton is preferable. The skeleton of the polymer having the acidic group can be identified by IR measurement.

A commercially available product can be used as the polymer having the acidic group. The commercially available product is not particularly limited, and examples thereof include liquid carboxylic acid-modified acrylic polymers [Z250, manufactured by Daicel-Allnex Ltd.] [CB-3060, CB-3098, and CBB-3060, manufactured by Soken Chemical & Engineering Co., Ltd.], [BR-605, manufactured by Mitsubishi Rayon Co., Ltd.], [ARUFON UC-3000 and UC-3510, manufactured by Toagosei Co., Ltd.], and [LIR-410 manufactured by Kuraray Co., Ltd.].

The polymer having the acidic group may be prepared by synthesis and can be prepared with reference to, for example, Toagosei Annual Research Report, TREND, 1999, No. 2, p. 20-26. Specifically, the polymer having the acidic group can be synthesized, for example, but not particularly limited to, by reacting acrylic acid, a polymerization initiator such as sodium persulfate, and a chain transfer agent such as isopropyl alcohol. An acid value can be controlled by appropriately adjusting the reaction temperature, the amount of the polymerization initiator added, and the amount of the chain transfer agent added.

<Silicone compound (viii)>

Examples of the silicone compound (viii) include silicone oil, a silane coupling agent, a silane compound, silicone rubber, and silicone resin. Among them, silicone oil is preferable because its component easily migrates to surface to highly exhibit the effect of decreasing surface energy.

The silicone compound (viii) is not particularly limited, and examples thereof include a compound having a polyalkylsiloxane such as polydimethylsiloxane or polydiethylsiloxane in its main chain. The silicone compound (viii) may be a compound having polysiloxane structure at a part of its molecular. The silicone compound (viii) may be a compound in which a certain organic group is introduced into polysiloxane structure. Specifically, a compound in which an organic group is introduced into a side chain of polysiloxane, a compound in which an organic group is introduced into both terminals of polysiloxane, a compound in which an organic group is introduced into one terminal of polysiloxane, a compound in which an organic group is introduced into both of a side chain and a terminal of polysiloxane, and the like can be used.

The organic group to be introduced into polysiloxane structure is not particularly limited, and examples thereof include an amino group, a carboxy group, a carbinol group, an aryl group, an alkyl group, a phenyl group, an alkoxycarbonyl group, an alkoxy group, a linear or branched alkyl group substituted with at least one aryl group, and a polyoxyalkylene group (hereinafter also referred to as a polyether group).

Among them, silicone oil having polysiloxane as a main skeleton and having one or more groups selected from the group consisting of an amino group, a polyether group, a carbinol group, and a phenyl group at at least one end and/or side chain is more preferable as the silicone compound (viii). When such a silicone compound (viii) is used, transparency of the photosensitive resin composition layer tends to more improve. A commercially available product of such a silicone compound is not particularly limited, and examples thereof include KF-8000, KF-6000, KF-351, and KF-50 manufactured by Shin-Etsu Chemical Co., Ltd.

When the total amount of the photosensitive resin composition layer is defined as 100% by mass, in the photosensitive resin composition layer, the content of the silicone compound (viii) is preferably 0.1% by mass or more and 5.0% by mass or less, more preferably 0.5% by mass or more and 3.0% by mass or less, and still more preferably 0.5% by mass or more and 2.0% by mass or less based on the total amount of the photosensitive resin composition layer.

Particularly, in the case of using an aromatic vinyl-conjugated diene-aromatic vinyl block copolymer as the thermoplastic elastomer (ii) described above, the refractive index of the silicone compound (viii) is preferably 1.400 or more and 1.700 or less, more preferably 1.450 or more and 1.650 or less, and still more preferably 1.500 or more and 1.600 or less in view of improving the transparency of the photosensitive resin composition layer.

<Other compounds>

The photosensitive resin composition of the present embodiment may comprise a colorant or a pigment, and the like as other compounds. The colorant or the pigment is effective as a coloring approach for improvement in visibility.

Examples of the colorant include, but are not limited to, water-soluble colorants such as basic colorants, acidic colorants, and direct colorants, and water-insoluble colorants such as sulfide colorants, oil-soluble colorants, and dispersed colorants. Particularly, a colorant having an anthraquinone-based, an indigoid-based, or an azo-based structure is preferable, and an azo-based oil-soluble colorant is more preferable, for example.

Examples of the pigment include, but are not limited to, natural pigments, synthetic inorganic pigments, and synthetic organic pigments. Examples of the synthetic organic pigment include azo-based, triphenylmethane-based, quinoline-based, anthraquinone-based, and phthalocyanine-based pigments.

(Dynamic viscoelasticity measurement)

As a result of conducting diligent studies, the present inventors have found that it is important to focus on a storage modulus (G') and a loss modulus (G") of a low-temperature and low-frequency region in a photosensitive resin composition layer constituting a flexographic printing plate and, in particular, to control the sum of G' and G", in view of enhancing halftone printing quality.

In general, a complex modulus G* which correlates with hardness during rest of a flexographic printing plate is represented by $|G*| = \{(G')^2 + (G'')^2\}^{1/2}$. When, of G' and G", a smaller value increases or decreases, the absolute value of the complex modulus has only a small change and poorly correlates with printing. Accordingly, G' + G" which equally reflects changes in both the values of G' and G" has been focused on and found to have good correlation with printing. This indicates that more precise control of G' and G" is necessary during printing.

A convex part of a flexographic printing plate is subjected to stress upon contact with a printing object, and the period of applied stress is short during printing as compared with during rest. The inventors have found that the viscoelasticity (G' and G") of the photosensitive resin composition layer during printing is the viscoelasticity of a region corresponding to -30°C and 2.5 Hz in consideration of the time-temperature law.

As described above, for enhancing chipping resistance during printing, it is preferable that G' + G", which is the sum of G' and G" described above, is 2.0 or more and 18 or less when the photosensitive resin composition layer constituting the flexographic printing raw plate is isolated from the flexographic printing raw plate, molded into a thickness of 1.5 mm, and irradiated with ultraviolet light of 3000 mJ both from an upper face and from a lower face, and the resulting cured product is subjected to dynamic viscoelasticity measurement at -30°C and 2.5 Hz.

When G' + G" is 2.0 or more, halftone chipping and slur can be suppressed even if strong stress is applied to the photosensitive resin composition layer by excessively elevating a printing pressure.

When G' + G" is 18.0 or less, softness can be maintained and ink lay down on a paper package can be improved.

From such viewpoints, G' + G" described above is preferably 2.0 or more and 18.0 or less, more preferably 5.0 or more and 15.0 or less, and especially preferably 8.0 or more and 13.0 or less.

For improving solid quality during printing, it is preferable that the storage modulus G' can also be controlled.

A smaller value of G' facilitates deformation of a convex part of a flexographic printing plate, enhances following properties for a printing base material, and thereby enhances ink lay down even for a rough printing object such as a paper package. On the other hand, a larger value is less likely to cause halftone deformation and improves halftone printing quality.

From such viewpoints, G' is preferably 2.0 or more and 18.0 or less, more preferably 3.0 or more and 15.0 or less, and especially preferably 4.0 or more and 12.0 or less.

For improving printing quality during long-run printing, it is preferable that the loss modulus G" can also be controlled.

A larger value of G" facilitates deformation of a convex part of a flexographic printing plate, enhances following properties for a printing base material, and thereby enhances ink lay down even for a rough printing object such as a paper package. On the other hand, a smaller value facilitates energy release to the outside under a printing pressure and improves wear resistance.

From such viewpoints, G" is preferably 2.0 or more and 15.0 or less, more preferably 2.5 or more and 13 or less, and especially preferably 3.0 or more and 10 or less.

The method for measuring G' and G" by dynamic viscoelasticity measurement at -30°C and 2.5 Hz can be performed by a method described in Examples described later.

The type A durometer hardness of the cured product of the photosensitive resin composition layer constituting the flexographic printing raw plate of the present embodiment is preferably 25° or more and 50° or less.

The type A durometer hardness of the cured product can be determined in the following manner: the photosensitive resin composition layer is isolated from the flexographic printing raw plate, molded into a thickness of 3 mm, and irradiated with ultraviolet light of 3000 mJ both from an upper face and from a lower face, and two resulting cured products are stacked and measured in accordance with JIS K 6253-3 (2012).

Larger type A durometer hardness of the cured product produces more sufficient wear resistance, and smaller type A durometer hardness tends to improve ink lay down on a paper package.

From such viewpoints, the type A durometer hardness is preferably 25° or more and 50° or less, preferably 30° or more and 45° or less, and preferably 35° or more and 43° or less.

(Infrared ablation layer)

The flexographic printing raw plate of the second embodiment may have an infrared ablation layer for the purpose of preparing an arbitrary negative pattern by a CTP (computer to plate) scheme.

The infrared ablation layer can be subjected to lithography processing using infrared light and serves as a mask image when the photosensitive resin composition layer is exposed and cured. At the time when an unexposed part of the photosensitive resin composition layer is washed out after completion of the exposure, this infrared ablation layer is simultaneously removed.

The infrared ablation layer is preferably composed of a binder polymer and an infrared absorber.

Examples of the binder polymer are not particularly limited, and include a polyamide, a polyester, and a copolymer of a monovinyl-substituted aromatic hydrocarbon and a conjugated diene. Especially, a copolymer of a monovinyl-substituted aromatic hydrocarbon such as styrene, $\alpha$-methyl styrene, and vinyltoluene and a conjugated diene such as 1,3-butadiene and isoprene are preferable. When the infrared ablation layer is formed by using such a binder polymer, affinity for the intermediate layer is high and adhesion is thus good.

A larger film thickness of the infrared ablation layer in the flexographic printing raw plate of the present embodiment is preferable in view of securing a light shielding property against ultraviolet light in a step of performing an exposure treatment of the flexographic printing raw plate, and a smaller film thickness is preferable in view of enhancing developing performance. From such viewpoints, the film thickness of the infrared ablation layer is preferably 0.1 $\mu$m or more and 20 $\mu$m or less, more preferably 0.5 $\mu$m or more and 15 $\mu$m or less, and further preferably 1.0 $\mu$m or more and 10 $\mu$m or less.

As for a non-infrared radiation shielding effect of the infrared ablation layer, the optical density of the infrared ablation layer is preferably 2 or more, and more preferably 3 or more. The optical density can be measured using D200-II Transmission Densitometer (manufactured by GretagMacbeth LLC). The optical density is so-called luminous (ISO visual), and the light to be measured is in a wavelength region on the order of 400 to 750 nm.

A simple substance or compound having strong absorption characteristics at a wavelength in a range of usually 750 nm to 2000 nm is used as an infrared absorber. It is preferable that the infrared absorber also serve as a non-infrared radiation shielding substance, though the infrared absorber and the non-infrared radiation shielding substance may be individually added.

It is preferable that the infrared absorber have a high absorbing property in an infrared region and be uniformly dispersible in the infrared ablation layer. Such a substance is not particularly limited, and examples thereof include inorganic pigments such as carbon black, graphite, iron oxide, chromium oxide, and copper chromite; and colorants such as phthalocyanine and substituted phthalocyanine derivatives, cyanine colorant, merocyanine colorant and polymethine colorant, and metal thiolate colorant.

A substance reflecting or absorbing an ultraviolet beam can be used as the non-infrared radiation shielding substance. Preferable examples thereof include, but are not particularly limited to, carbon black, ultraviolet absorbers, and graphite. These infrared absorbers or non-infrared radiation shielding substances may be used singly, or two or more thereof may be mixed and used.

The dispersant contained in the infrared ablation layer is a compound having an adsorbing moiety capable of interacting with a surface functional group of an infrared absorber, and a resin-compatible moiety compatible with a binder polymer.

Examples of the adsorbing moiety of the dispersant include, but are not limited to, an amino group, an amide group, a urethane group, a carboxyl group, a carbonyl group, a sulfone group, and a nitro group. An amino group, an amide group, or a urethane group is preferable.

Examples of the resin-compatible moiety include, but are not limited to, saturated alkyl, unsaturated alkyl, polyether, polyester, poly(meth)acryl, and polyol.

(Intermediate layer)

The flexographic printing raw plate of the second embodiment may have an intermediate layer between the photosensitive resin composition layer and the infrared ablation layer. At the time when an unexposed part of the photosensitive resin composition layer is washed out after completion of the exposure, this intermediate layer is simultaneously removed.

Various functions such as a function of preventing substance diffusion between the photosensitive resin composition layer and the infrared ablation layer (hereinafter, also referred to as a "diffusion blocking function"), a function of protecting the infrared ablation layer, or a function of bonding the photosensitive resin composition layer to the infrared ablation layer can be imparted to the intermediate layer as needed. The intermediate layer preferably has a function of blocking diffusion of oxygen in the atmosphere to the photosensitive resin composition layer (hereinafter, also referred to as an "oxygen blocking property") as the diffusion blocking function. This decreases the amount of oxygen coexisting at the time of ultraviolet curing so that the polymerization reaction becomes less likely to be suppressed. Furthermore, the interface between an unexposed part to be removed in development step S4 and an exposed part on which a pattern is to be formed becomes clear. Variation in the size of a relief image to be formed is thereby reduced, and a stable flexographic printing plate can be provided.

A larger thickness of the intermediate layer in the flexographic printing raw plate of the present embodiment is more preferable in view of inhibiting mass transfer between layers. A smaller thickness is more preferable in view of developing performance. Taking the balance among them into consideration, the thickness of the intermediate layer is preferably 1.0 $\mu$m or more and 30 $\mu$m or less, more preferably 2.0 $\mu$m or more and 20 $\mu$m or less, and still more preferably 2.5 $\mu$m or more and 10 $\mu$m or less.

The intermediate layer may include, but not particularly limited to, a binder polymer, a filler, a crosslinking agent, a silicone oil, a surfactant, a coating aid, or the like.

The binder polymer included in the intermediate layer is not particularly limited, and examples thereof include polyester emulsions, polyurethane emulsions, polyacrylamide emulsions, water-dispersible latex polymers such as polybutadiene latex, natural rubber latex, styrene-butadiene copolymer latex, acrylonitrile-butadiene copolymer latex, polyvinylidene chloride latex, polychloroprene latex, polyisoprene latex, polyurethane latex, methyl methacrylate-butadiene copolymer latex, vinylpyridine polymer latex, butyl polymer latex, Thiokol polymer latex, and acrylate polymer latex, polymers obtained by copolymerizing these polymers with other components such as acrylic acid or methacrylic acid, ethylene-vinyl alcohol copolymers, polymers such as polyvinyl alcohol, polyvinyl acetate, polyvinyl butyral, polyvinylpyrrolidone, polyvinyl chloride, polyvinylidene chloride, polyvinyl fluoride, polyvinylidene fluoride, polyacrylonitrile, polymethyl methacrylate, polyacetal, polycarbonate, polystyrene, polycarbonate, polyethylene, polypropylene, cellulose derivatives, polyester, polyamide, polyimide, polyurethane, silicone rubber, butyl rubber, and isoprene rubber, and copolymers thereof. These binder polymers may be used singly, or two or more thereof may be used in combination.

Among these binder polymers, a binder polymer that is dispersed or dissolved in water or alkali water is preferable for development with an aqueous developer in view of good developing performance.

The filler included in the intermediate layer is not particularly limited, and examples thereof include layered silicate minerals such as silica, kaolinite, dickite, halloysite, talc, pyrophyllite, saponite, hectorite, montmorillonite, beidellite, vermiculite, mica (isinglass), and palagonite, aluminum hydroxide, aluminum oxide, barium sulfate, and potassium titanate. Among these compounds, mica, aluminum hydroxide, or aluminum oxide is preferable in view of development performance and an oxygen blocking property.

A commercially available product of the filler included in the intermediate layer is not particularly limited, and examples thereof include Micromica (synthetic mica) and Somasif (registered trade mark of Katakura & Co-op Agri Corporation, synthetic mica), KUNIPIA manufactured by KUNIMINE INDUSTRIES CO., LTD. (registered trade mark of KUNIMINE INDUSTRIES CO., LTD., montmorillonite), SUMECTON (registered trade mark of KUNIMINE INDUSTRIES CO., LTD.) SA (synthetic saponite); Bengel (registered trade mark of HOJUN Co., Ltd., purified product of natural bentonite) manufactured by HOJUN Co., Ltd., alumisol F-1000, F-3000, 5N, and 10N manufactured by Kawaken Fine Chemicals Co., Ltd., flake alumina powder Serath 00610, 02025, 02050, 05025, 05070, 07070, and 10030 manufactured by KINSEI MATEC CO., LTD., and TISMO D and TISMO N manufactured by Otsuka Chemical Co., Ltd.

[Manufacturing method of flexographic printing raw plate]

The flexographic printing raw plate of the present embodiment is preferably obtained by a method comprising the following steps 1 to 4 in the presented order:

step 1; a step of adding at least a photopolymerizable compound (iii) to an aqueous dispersion containing polymer particles (i) to obtain an aqueous dispersion containing polymer particles (i);
step 2; a step of removing water from the aqueous dispersion containing polymer particles (i) obtained in the step 1 to obtain a mixture comprising the polymer particles (i) and the photopolymerizable compound (iii);
step 3; a step of adding at least a thermoplastic elastomer (ii) to the mixture obtained in the step 2 to obtain a photosensitive resin composition; and
step 4; a step of stacking the photosensitive resin composition obtained in the step 3 on a support to obtain a flexographic printing raw plate.

(Manufacturing method of flexographic printing raw plate: step 1)

The step 1 in the manufacturing method of the flexographic printing raw plate of the present embodiment is not particularly limited as long as the step is of adding at least a photopolymerizable compound (iii) to an aqueous dispersion containing polymer particles (i).

By adding a photopolymerizable compound (iii) to an aqueous dispersion containing polymer particles (i) in advance, the area ratios and storage modulus of the regions (A1) and (A2) can be increased, and halftone chipping and slur can be suppressed.

The mass ratio of the photopolymerizable compound (iii) to be added to the mass of the polymer particles (i) is preferably 0.1 or more and 0.5 or less, more preferably 0.15 or more and 0.4 or less, and especially preferably 0.2 or more and 0.35 or less.

In addition to the photopolymerizable compound (iii), a thermoplastic elastomer (ii), a photopolymerization initiator (iv), a plasticizer (v), a stabilizer (vi), a detergent builder (vii), a silicone compound (viii), and other compounds may be added to the aqueous dispersion containing polymer particles (i).

It is preferable to mix the aqueous dispersion containing polymer particles (i) with these components in advance, because the components can be uniformly dispersed in a step of obtaining a photosensitive resin composition (step 3) described later and no difference in physical properties occurs in the resulting printing plate.

(Manufacturing method of flexographic printing raw plate: step 2)

The step 2 in the manufacturing method of the flexographic printing raw plate of the present embodiment is not particularly limited as long as the step is of removing water from the aqueous dispersion containing polymer particles (i) obtained in the step 1 to obtain a mixture comprising the polymer particles (i) and the photopolymerizable compound (iii).

For a method for removing water, a batch-type dryer such as a kneader or an evaporator may be used, or a continuous dryer such as a devolatilization extruder or a thin-film distiller may be used.

(Manufacturing method of flexographic printing raw plate: step 3)

The step 3 in the manufacturing method of the flexographic printing raw plate of the present embodiment is not particularly limited as long as the step is of adding at least a thermoplastic elastomer (ii) to the mixture obtained in the step 2 to obtain a photosensitive resin composition.

In addition to the thermoplastic elastomer (ii), a photopolymerizable compound (iii), a photopolymerization initiator (iv), a plasticizer (v), a stabilizer (vi), a detergent builder (vii), a silicone compound (viii), and other compounds may be added to the mixture obtained in the step 2.

The mixture supplemented with these components can be kneaded using various known kneading machines such as a kneader, a roll mill, or a screw extruder to prepare a photosensitive resin composition.

[Manufacturing method of flexographic printing raw plate: step 4)

The step 4 in the manufacturing method of the flexographic printing raw plate of the present embodiment is not particularly limited as long as the method involves stacking a photosensitive resin composition layer on a support. This step can be carried out by various methods. Specific examples thereof include the following methods.

First, a photosensitive resin composition layer is obtained by a method of dissolving a starting material of the photosensitive resin composition which is a material of the photosensitive resin composition layer in an appropriate solvent, for example, but not particularly limited to, a solvent such as chloroform, tetrachloroethylene, methyl ethyl ketone, or toluene, mixing the solution, casting it into a mold, and evaporating the solvent, thereby shaping a plate, or a method of kneading the starting material in a kneader, a roll mill, a screw extruder, or the like without the use of a solvent, and then molding the resultant into a desired thickness in a calender roll, a press, or the like, and this layer is laminated with a support to obtain a stack of the support and the photosensitive resin composition layer.

An intermediate layer and an infrared ablation layer may be stacked on the photosensitive resin composition layer as needed. To provide the intermediate layer and the infrared ablation layer on the surface of the photosensitive resin composition layer, for example, but not particularly limited to, a component that constitutes the intermediate layer and a component that constitutes the infrared ablation layer can each be dispersed or dissolved in an appropriate solvent by forced stirring with a stirring blade or ultrasonic stirring, or preliminarily kneaded using an extruder or a kneader and then dispersed or dissolved in an appropriate solvent to obtain a predetermined dispersion or solution, followed by direct coating of the photosensitive resin composition layer with the dispersion or the solution to form an intermediate layer and the infrared ablation layer.

Also, a cover sheet made of, for example, but not particularly limited to, polyester or polypropylene may be provided on the infrared ablation layer.

In another method, a predetermined cover sheet is coated with a material that constitutes the infrared ablation layer to obtain a film having the infrared ablation layer, followed by coating of the infrared ablation layer with a material that constitutes the intermediate layer to obtain a cover film in which the infrared ablation layer and the intermediate layer are stacked on the cover sheet. Thereafter, this cover film can be laminated or pressure-bonded to the photosensitive resin composition layer side of the stack of the support and the photosensitive resin composition layer to form the intermediate layer and the infrared ablation layer on the photosensitive resin composition layer.

The cover film or the support can usually be allowed to adhere to the photosensitive resin composition layer by roll lamination after sheet formation of the photosensitive resin composition layer, laminated, and then pressed by heating to obtain a flexographic printing raw plate with better thickness precision.

[Manufacturing method of a flexographic printing plate]

The flexographic printing plate of the present embodiment is preferably obtained by a method comprising the following steps 1 and 2 in the presented order:

step 1; a step of partially and selectively exposing the photosensitive resin composition layer of the present embodiment through an arbitrary negative pattern to obtain a partially cured product; and
step 2; a step of removing an unexposed part of the photosensitive resin composition layer from the partially cured product obtained in the step 1.

<Manufacturing method of flexographic printing plate: step 1>

In the step 1 of the present embodiment, photosensitive resin composition layer 12 is selectively exposed through an arbitrary negative pattern to form relief layer 12a.

In this respect, light that has passed through the arbitrary negative pattern accelerates curing reaction of the photosensitive resin composition layer, and concavity and convexity of the arbitrary negative pattern is transferred in an inverted manner to the photosensitive resin composition layer. Irradiation with ultraviolet light may be conducted on the entire surface of the flexographic printing raw plate.

Ultraviolet light with a wavelength of 150 to 500 nm can be used as the ultraviolet light, and, particularly, ultraviolet light of 300 to 400 nm can be preferably used.

A light source of ultraviolet light is not particularly limited, and a low pressure mercury lamp, a high pressure mercury lamp, an ultrahigh pressure mercury lamp, a metal halide lamp, a xenon lamp, a zirconium lamp, a carbon arc lamp, a fluorescent lamp for ultraviolet light, or a LED lamp, for example, can be used.

The step 1 can be performed in a state where the plate is attached to a laser cylinder. In general, the plate is removed from a laser apparatus and irradiated using a conventional irradiation unit. In this respect, the exposure method is not particularly limited and can be performed using a known irradiation unit.

The arbitrary negative pattern may be formed by irradiating the infrared ablation layer with infrared light or may be formed by allowing a negative film to adhere onto the photosensitive resin composition layer.

When the flexographic printing raw plate of the present embodiment has an intermediate layer such as an oxygen inhibiting layer or an adhesive layer and the amount of ultraviolet light absorbed in the intermediate layer as an oxygen inhibiting layer is too large to ignore in the pattern exposure step S3, it is preferable to appropriately adjust an ultraviolet dose by taking into consideration in advance the amount of ultraviolet light to be absorbed by the intermediate layer as an oxygen inhibiting layer.

<Manufacturing method of flexographic printing plate: step 2>

The step 2 of the present embodiment is not particularly limited as long as the step of removing an unexposed part of the photosensitive resin composition layer 12. The removal of an un exposed part herein is also referred to as "development".

A conventionally known method can be applied to a development method. Specifically, although the development method is not particularly limited, for example, the flexographic printing raw plate is exposed as described above, and the unexposed part is then washed away with a solvent for solvent development or a developer for water development. Alternatively, an unexposed part heated to 40°C to 200°C is brought into contact with a predetermined absorption layer capable of absorbing the unexposed part and the unexposed part can be removed by removing the absorption layer.

In this respect, when the flexographic printing raw plate has infrared ablation layer 14 and/or intermediate layer 13, these layers can be removed simultaneously therewith.

In the development step S4, an aqueous developer or a solvent-based developer can be used. Among them, an aqueous developer is preferably used in view of environmental harmony.

The solvent-based developer for use in solvent development of the unexposed part is not particularly limited, and examples thereof include esters such as heptylacetate and 3-methoxybutyl acetate; hydrocarbons such as a petroleum fraction, toluene, and decalin; and a mixture of alcohols such as propanol, butanol, and pentanol with a chlorine-based organic solvent such as tetrachloroethylene. Washout of the unexposed part can be carried out by spraying from a nozzle or carried out by brushing with a brush.

The aqueous developer for water development of the unexposed part may be water itself or may be an alkaline aqueous solution or a neutral detergent. Such an aqueous developer is not particularly limited, and a mixture of water with a surfactant such as a nonionic surfactant and an anionic surfactant, a pH adjuster, a cleaning accelerator, and the like, for example, can be used.

Examples of the surfactant include an anionic surfactant, an amphoteric surfactant, and a nonionic surfactant. These surfactants may be used singly, or two or more thereof may be mixed and used.

The anionic surfactant is not particularly limited, and examples thereof include a sulfuric acid ester salt, a higher alcohol sulfuric acid ester, a higher alkyl ether sulfuric acid ester salt, a sulfated olefin, an alkylbenzenesulfonate, an $\alpha$-olefinsulfonate, a phosphoric acid ester salt, and a dithiophosphoric acid ester salt.

The amphoteric surfactant is not particularly limited, and examples thereof include an amino acid type amphoteric surfactant and a betaine type amphoteric surfactant.

The nonionic surfactant is not particularly limited, and examples thereof include polyethylene glycol type surfactants such as a higher alcohol-ethylene oxide adduct, an alkyl phenol-ethylene oxide adduct, a fatty acid-ethylene oxide adduct, a polyhydric alcohol fatty acid ester-ethylene oxide adduct, a higher alkylamine-ethylene oxide adduct, a fatty acid amide-ethylene oxide adduct, and a polypropylene glycol-ethylene oxide adduct; and polyhydric alcohol type surfactants such as a glycerol fatty acid ester, a pentaerythritol fatty acid ester, fatty acid esters of sorbitol and sorbitan, an alkyl ester of a polyhydric alcohol, and fatty acid amides of alkanolamines.

The alkaline aqueous solution contains a pH adjuster.

The pH adjuster may be any of organic and inorganic materials and is preferably a pH adjuster that can adjust pH to 9 or more. The pH adjuster is not particularly limited, and examples thereof include sodium hydroxide, sodium carbonate, potassium carbonate, sodium silicate, sodium metasilicate, and sodium succinate.

Development can also be performed by heat. In the case of heat development, no solvent is used. Instead, the photosensitive resin composition layer and the intermediate layer are brought into contact with an absorbent material after image exposure and then heated at 40°C to 200°C to remove the unexposed part. Examples of the absorption layer of heat development include nonwoven fabric materials, paper materials, fibrous woven fabrics, open cell foams, and porous materials. Among them, the absorption layer is preferably a nonwoven fabric material of any of nylon, polyester, polypropylene, and polyethylene, or a combination of these nonwoven fabric materials. The absorption layer is especially preferably a continuous nonwoven web of nylon or polyester.

The plate may be treated by drying for the purpose of suppressing swelling or whitening of the plate caused by the developer. Examples thereof include, but are not particularly limited to, drying by heat, air drying using an air knife, and a method of removing the developer by absorption to a nonwoven fabric or the like. Examples of the drying by heat include a method of leaving the plate in an oven temperature-controlled to 40°C to 60°C for about 10 minutes to 120 minutes.

Thereafter, post exposure is then conducted as needed to manufacture flexographic printing plate 100. As the post exposure, a method involving irradiating the surface with light having a wavelength of 300 nm or less is exemplified. Light having a wavelength of more than 300 nm may be used in combination for irradiation as needed.

<Manufacturing method of flexographic printing plate: back exposure step>

A back exposure step of irradiating the flexographic printing raw plate with ultraviolet light from the support side may be included as a previous step of the manufacturing step 1 of the flexographic printing raw plate as needed. In back exposure step S1, the entire surface of photosensitive resin composition layer 12 is subjected to ultraviolet light exposure (back exposure) through support 11 of flexographic printing raw plate 10 and cured to form a thin uniform cured layer. In this respect, an exposure method is not particularly limited, and the same light source and exposure unit as in the flexographic printing plate manufacturing step 1 can be used.

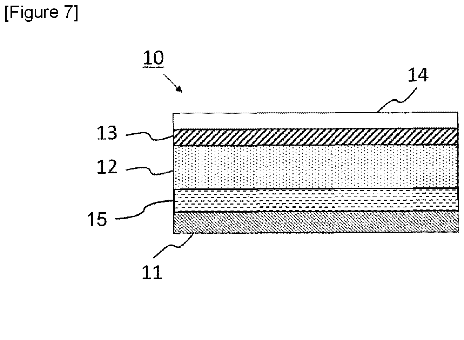

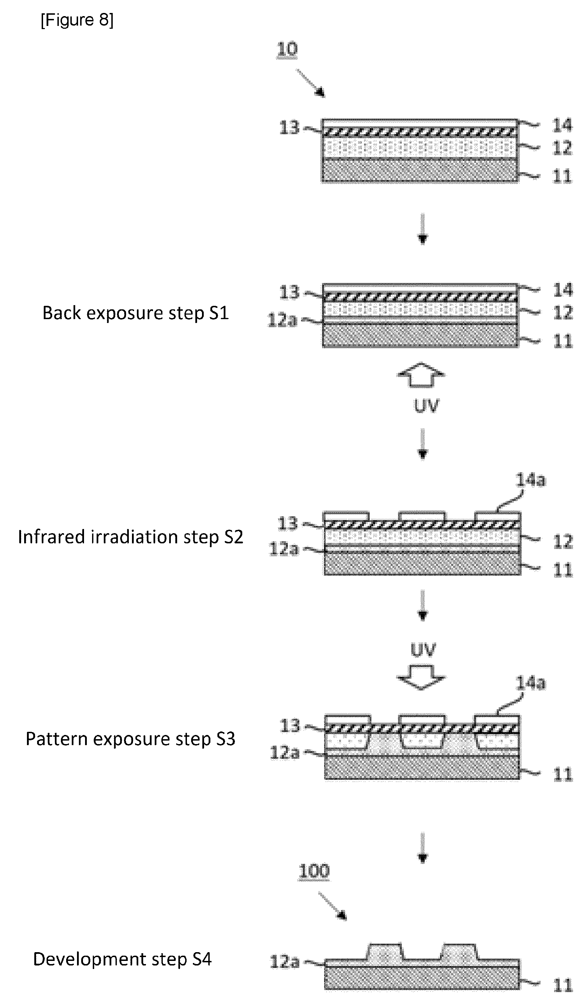

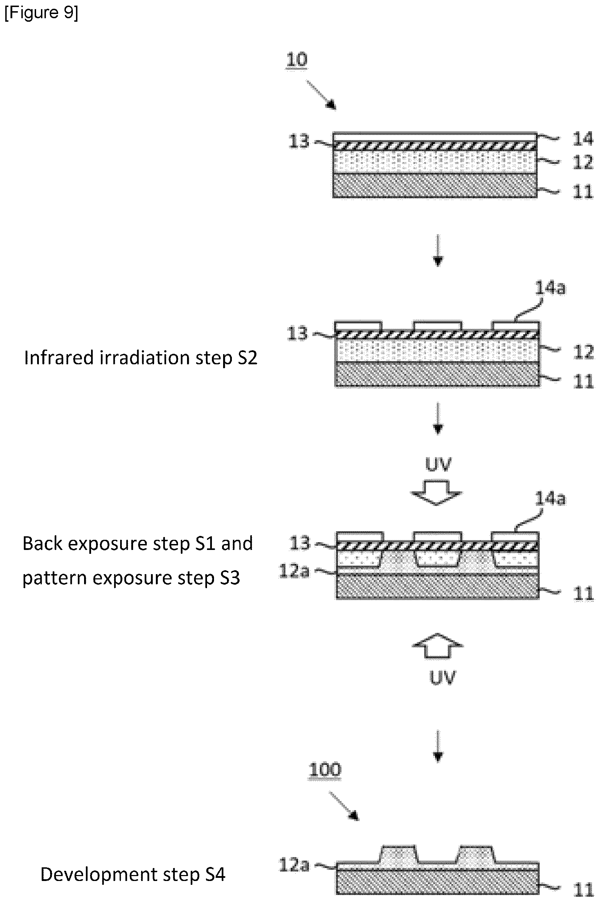

The back exposure step may be conducted before the flexographic printing plate manufacturing step 1, or as shown in Figure 9, the back exposure step and the step 1 may be simultaneously conducted. Figure 9 shows the same as that shown in Figure 8 except for the order of steps.

<Manufacturing method of flexographic printing plate: infrared irradiation step>

In the case of using a flexographic printing raw plate having an infrared ablation layer, an infrared irradiation step of irradiating the infrared ablation layer with infrared light for lithography processing of a pattern may be included as a previous step of the manufacturing step 1 of the flexographic printing raw plate. In infrared irradiation step S2, negative pattern 14a is created in infrared ablation layer 14 by laser lithography (i.e. laser ablation). When the flexographic printing raw plate 10 has a cover film on the infrared ablation layer 14, the cover film is first peeled before infrared irradiation. Thereafter, the infrared ablation layer is subjected to pattern irradiation with infrared light to form an arbitrary negative pattern on the photosensitive resin composition layer. The infrared irradiation step may be a previous step or a post step of the back exposure step.

Preferable examples of the infrared laser include, but are not particularly limited to, ND/YAG laser (for example, 1064 nm) and diode laser (for example, 830 nm). A laser system appropriate for CTP plate making technology is commercially available and is not particularly limited, and diode laser system CDI Spark (ESKO Graphics Co., Ltd.), for example, can be used. This laser system includes a rotary cylindrical drum which holds a flexographic printing raw plate, an IR laser irradiation apparatus, and a layout computer, and image information is directly sent to the laser apparatus from the layout computer.

<Manufacturing method of flexographic printing plate: drying step>

A drying step of drying the flexographic printing raw plate after development may be included as a post step of the manufacturing step 2 of the flexographic printing raw plate as needed. This can suppress reaction swelling or whitening caused by the developer. The drying step is not particularly limited, and examples thereof include drying by heat, air drying using an air knife, and a method of removing the developer by absorption to a nonwoven fabric or the like. Examples of the drying by heat include a method of leaving the plate in an oven temperature-controlled to 40°C to 60°C for about 10 minutes to 120 minutes.

<Manufacturing method of flexographic printing plate: post exposure step>

A post exposure step of further exposing the flexographic printing raw plate from the relief layer side may be included as a post step of the manufacturing step 2 of the flexographic printing raw plate or the drying step as needed. This can suppress stickiness of plate surface. The drying step is not particularly limited, and examples thereof include drying by heat, air drying using an air knife, and a method of removing the developer by absorption to a nonwoven fabric or the like. Examples of the drying by heat include a method of leaving the plate in an oven temperature-controlled to 40°C to 60°C for about 10 minutes to 120 minutes.

[Flexographic printing method]

The flexographic printing method of the present embodiment preferably comprises: a printing plate manufacturing step of manufacturing a printing plate by the manufacturing method of the flexographic printing plate described above; and a printing step of performing printing using the flexographic printing plate obtained in the printing plate manufacturing step. The printing step is not particularly limited as long as the method involves allowing ink to attach to a convex part of the relief layer in the flexographic printing plate, and transferring the ink to a base material.

Examples

Hereinafter, the present invention will be described in detail with reference to specific working examples and comparative examples. However, the present invention is not limited to the following examples at all.

[Manufacturing Example 1: Synthesis of polymer particles (i) of Synthesis Examples 1 to 16]

To a pressure resistant reaction vessel provided with a stirring device and a jacket for temperature adjustment were initially added the materials described in Table 1 ("Initial addition"). The inside temperature was increased to 80°C. Then, the oil-based mixture liquid and the aqueous mixture liquid described in Table 1 were added to the reaction vessel over five hours and six hours, respectively, at a constant flow rate.

Thereafter, the temperature was continuously kept at 80°C for one hour to complete polymerization reaction. Thereafter, the produced copolymer latex was cooled, and its pH was adjusted to 7 by addition of sodium hydroxide. Thereafter, unreacted monomers were removed by a steam stripping method followed by filtration with a 200 mesh metallic mesh, and the solid concentration of the filtrate was finally adjusted to 40% by mass to obtain aqueous dispersions containing polymer particles of Synthesis Examples 1 to 16.

[Manufacturing Example 2: Production of base film (support)]

As a solution for an adhesive layer to coat a support (base film), 55 parts by mass of Tufprene 912 (manufactured by Asahi Kasei Corp., trade name), which is a block copolymer of styrene and 1,3-butadiene, 38 parts by mass of paraffin oil (average carbon number: 33, average molecular weight: 470, and density at 15°C: 0.868), 2.5 parts by mass of 1,9-nonanediol diacrylate, 1.5 parts by mass of 2,2-dimethoxy-phenylacetophenone, 3 parts by mass of EPOXY ESTER 3000M (manufactured by Kyoeisha Chemical Co., Ltd., trade name), and 1.5 parts by mass of VALIFASTYELLOW-3150 (manufactured by ORIENT CHEMICAL INDUSTRIES CO., LTD., trade name) were dissolved in toluene to obtain a solution with a solid content of 25%.

Thereafter, the obtained solution was applied to one side of a polyester film having a thickness of 100 $\mu$m using a knife coater so as to achieve an ultraviolet transmittance (UV transmittance) of 10% followed by drying at 80°C for one minute to obtain a support (base film) having an adhesive layer. The UV transmittance of the support was calculated from transmission intensity measured by UV illuminometer MO-2 model (manufactured by ORC MANUFACTURING CO., LTD., trade name, UV-35 filter) using ultraviolet light exposure apparatus AFP-1500 (manufactured by Asahi Kasei Corp., trade name).

[Manufacturing Example 3: Production of film having infrared ablation layer]

After 65% by mass of Asaflex 810 (manufactured by Asahi Kasei Corp., trade name), which is a block copolymer of styrene and 1,3-butadiene, and 35% by mass of carbon black as an infrared sensitive substance were kneaded with a kneader and cut into a pellet, 90 parts by mass of this pellet and 10 parts by mass of 1,6-hexanediol adipate were dissolved, utilizing ultrasonic waves, in a solvent mixture prepared at a mass ratio of ethyl acetate/butyl acetate/propyleneglycol monomethyl ether acetate = 50/30/20 to prepare a uniform solution with a solid content of 12% by mass.

Thereafter, this solution was applied onto a polyester film to be a cover sheet with a thickness of 100 $\mu$m to achieve an applied amount after drying of 4 to 5 g/m$^2$ using a knife coater followed by drying at 80°C for one minute to obtain a film having an ultraviolet shielding layer (infrared ablation layer) capable of ablating by infrared light. The optical density of the film having the infrared ablation layer measured by DM-500 (manufactured by Dainippon Screen Mfg. Co., Ltd., trade name) was 3 to 4.

[Manufacturing Example 4: Preparation of film having infrared ablation layer and intermediate layer]

To a solution prepared at a mass ratio of ethanol/distilled water = 10/90 were added 95% by mass of water-soluble polyamide resin AQ Nylon T70 (manufactured by Toray Industries, Inc.), and 5% by mass of the polyether-modified silicone oil KF-351A (manufactured by Shin-Etsu Chemical Co., Ltd.) followed by stirring to prepare an intermediate layer coating liquid.

Thereafter, the intermediate layer coating liquid was applied onto the film having the infrared ablation layer produced in Manufacturing Example 4 described above, on the infrared ablation layer side thereof, so that the thickness after drying became 3 $\mu$m using a bar coater. A cover film having an intermediate layer and the infrared ablation layer was obtained by subsequent drying at 100°C for four minutes.

[Manufacturing Example 5: Production of flexographic printing raw plate]

To the aqueous dispersions containing the polymer particles obtained in Manufacturing Example 1 was added the photopolymerizable compound 1 at the mass ratio as described in Table 2 or 3, and drying under reduced pressure was performed at 80°C to obtain mixtures containing the polymer particles described in Examples 1 to 26. The numbers of parts by mass of the polymer particles described in Tables 2 and 3 are each described in the mass of solid content of the polymer particles.

Then, the components described in Table 2, 3, or 4 were mixed therewith at 140°C over 45 minutes using a pressure kneader to obtain photosensitive resin compositions described in Examples 1 to 26 and Comparative Examples 1 to 7. The numbers of parts by mass of the polymer particles described in Table 4 are each described in the mass of solid content of the polymer particles.

Thereafter, the photosensitive resin composition was put into an extrusion molding machine, and extruded and molded from a T-shaped die, and on a face of the resulting photosensitive resin composition, the base film (support) having the adhesive layer obtained in Manufacturing Example 3 described above was laminated so that the adhesive layer contacted the photosensitive resin composition layer. A mold release film (manufactured by Mitsubishi Chemical Corporation, DIAFOIL MRV100) was laminated on the face of the photosensitive resin composition layer opposed from the side on which the support was laminated, to obtain a stack of the support and the photosensitive resin composition layer.

(Manufacturing of flexographic printing raw plates of Examples 1 to 21 and 23 to 26 and Comparative Examples 1 to 7)

The mold release film in the stack of the support and the photosensitive resin composition layer was peeled, and the cover film having the infrared ablation layer obtained in Manufacturing Example 4 described above was laminated so that the infrared ablation layer contacted the photosensitive resin composition layer to obtain each flexographic printing raw plate.

(Manufacturing of flexographic printing raw plate of Example 22)

The mold release film in the stack of the support and the photosensitive resin composition layer was peeled, and the cover film having the infrared ablation layer and the intermediate layer obtained in Manufacturing Example 5 described above was laminated so that the intermediate layer contacted the photosensitive resin composition layer to obtain a flexographic printing raw plate.

[Manufacturing Example 6: Manufacturing of flexographic printing plate]

(Manufacturing of flexographic printing plates of Examples 1 to 23 and Comparative Examples 1 to 6)

The flexographic printing raw plate was exposed from the side of the support (PET coated with an adhesive) using an ultraviolet light exposure apparatus "AFP-1216" (manufactured by Asahi Kasei Corp., trade name) so that a pattern height (RD) after curing was about 0.5 mm.

Thereafter, the cover sheet of the infrared ablation layer was peeled, an image pattern including a solid image of 10 cm square and halftone images of 1 cm square (AM 150 lpi, a total of 20 images at 1% intervals from 1 to 20%) was drawn on the infrared ablation layer using CDI Spark 4260 (manufactured by ESKO Graphics Co., Ltd., trade name), and the infrared ablation layer side was exposed at 8000 mJ under an air atmosphere using the exposure apparatus "AFP-1216".

After exposure, an aqueous solution (aqueous developer) of 1% polyoxyalkylene alkyl ether (NEWCOL 2308: manufactured by Nippon Nyukazai Co., Ltd.) and 1% potassium carbonate was prepared, and an unexposed part was removed by washing (development) at 40°C using a cleaning machine manufactured by Nihon Denshi Seiki Co., Ltd. (JOW-A3-P). After drying at 50°C for 10 minutes, post exposure was performed with an ultraviolet sterilization lamp and an ultraviolet chemical lamp for removal of surface tackiness to obtain a flexographic printing plate.

(Manufacturing of flexographic printing plate of Example 24)

The cover sheet of the infrared ablation layer in the flexographic printing raw plate was peeled, an image pattern including a solid image of 10 cm square and halftone images of 1 cm square (AM 150 lpi, a total of 20 images at 1% intervals from 1 to 20%) was drawn on the infrared ablation layer using CDI Crystal 4835 (manufactured by ESKO Graphics Co., Ltd., trade name), and both faces on the infrared ablation layer side and the support side were exposed using XPS Crystal 4835 (manufactured by ESKO Graphics Co., Ltd., trade name) under conditions set to Main UV Power Density of 311 mW/cm2, Back UV Power Density of 27 mW/cm2, four passes, and a pixel time of 20 seconds.

After exposure, an aqueous solution containing 1% polyoxyalkylene alkyl ether (NEWCOL 2308: manufactured by Nippon Nyukazai Co., Ltd.) and 1% potassium carbonate (aqueous developer) was prepared, and an unexposed part was removed by development at 40°C for 15 minutes using a cleaning machine manufactured by Nihon Denshi Seiki Co., Ltd. (JOW-A3-P). After drying at 50°C for 10 minutes, post exposure was performed with an ultraviolet sterilization lamp and an ultraviolet chemical lamp for removal of surface tackiness to obtain a flexographic printing plate.

(Manufacturing of flexographic printing plate of Example 25)

The flexographic printing raw plate was exposed from the side of the support (PET coated with an adhesive) using an ultraviolet light exposure apparatus "AFP-1216" so that a pattern height (RD) after curing was about 0.5 mm.

Thereafter, the cover sheet of the infrared ablation layer was peeled, an image pattern including a solid image of 10 cm square and halftone images of 1 cm square (AM 150 lpi, a total of 20 images at 1% intervals from 1 to 20%) was drawn on the infrared ablation layer using CDI Spark 4260 (manufactured by ESKO Graphics Co., Ltd., trade name), and the infrared ablation layer side was exposed at 8000 mJ under an air atmosphere using the exposure apparatus "AFP-1216".

After exposure, a double-faced tape was attached to the side subjected to the back exposure mentioned above, which was then fixed to a rotating drum of "AFP-1500" developing machine (manufactured by Asahi Kasei Corp., trade name), and development was conducted at a liquid temperature of 30°C for 10 minutes with 3-methoxybutyl acetate as a developer, followed by drying at 60°C for 2 hours. Post exposure was performed with an ultraviolet sterilization lamp and an ultraviolet chemical lamp for removal of surface tackiness to obtain a flexographic printing plate.

(Manufacturing of flexographic printing plate of Example 26)

A flexographic printing raw plate was obtained in the same manner as in Example 19 described above. Thereafter, the flexographic printing raw plate was exposed from the side of the support (PET coated with an adhesive) using an ultraviolet light exposure apparatus " AFP-1216" so that a pattern height (RD) after curing was about 0.5 mm.

Thereafter, the cover sheet of the infrared ablation layer was peeled, an image pattern including a solid image of 10 cm square and halftone images of 1 cm square (AM 150 lpi, a total of 20 images at 1% intervals from 1 to 20%) was drawn on the infrared ablation layer using CDI Spark 4260 (manufactured by ESKO Graphics Co., Ltd., trade name), and the infrared ablation layer side was exposed at 8000 mJ under an air atmosphere using the exposure apparatus "AFP-1216".

After exposure, the flexographic printing raw plate was heated to 170°C in CYREL(R) FAST TD1000 heat processor and brought into contact with a developing medium to remove an unexposed part. The developing medium was nonwoven polyester.

Post exposure was performed with an ultraviolet sterilization lamp and an ultraviolet chemical lamp for removal of surface tackiness to obtain a flexographic printing plate.

[Measurement of physical properties]

<Dynamic elasticity mapping measurement by AFM>

1. Preparation of sample from flexographic printing plate

A small piece of 1 cm square was cut out of the flexographic printing plate obtained in Manufacturing Example 6 described above, ultrasonically cleaned with ethanol for one hour, and then dried in vacuum for two hours.

Then, the flexographic printing plate was frozen at -180°C, and about 1 $\mu$m of the surface layer was cut with an ultramicrotome (manufactured by Leica) to expose a smooth cross section. The smooth cross section of the flexographic printing plate was used as a measurement sample.

EP 4 528 377 A1

2. Preparation of sample from flexographic printing raw plate

The infrared ablation layer constituting the flexographic printing raw plate obtained in Manufacturing Example 5 described above was wiped with a nonwoven fabric using a solvent such as acetone. Thereafter, a pressure of 50 kg/cm$^2$ was applied to the obtained stack of the support and the photosensitive resin composition layer under a condition of 120°C for four minutes in a press to thereby recover the photosensitive resin composition layer coming out of the support.

Then, the photosensitive resin composition was sandwiched between mold release films, and a pressure of 200 kg/cm$^2$ was applied thereto under a condition of 120°C for four minutes in a press using a 1.5 mm spacer to obtain a photosensitive resin composition sheet having the photosensitive resin composition layer with a thickness of 1.5 mm. Thereafter, both faces of the photosensitive resin composition sheet were entirely exposed to ultraviolet light of 3000 mJ/cm$^2$ per face using the exposure apparatus "AFP-1216".

Subsequently, a small piece of 1 cm square was cut out of the cured product, ultrasonically cleaned with ethanol for one hour, and then dried in vacuum for two hours.

Finally, the cured product was frozen at -180°C, and about 1 $\mu$m of the surface layer was cut with an ultramicrotome (manufactured by Leica) to expose a smooth cross section. The smooth cross section of the cured product was used as a measurement sample.

3. Apparatus, measurement conditions, etc.

Mapping data was obtained by dynamic elasticity mapping measurement by AFM using the following apparatus and measurement conditions.

Apparatus: NanoScope V / Dimension Icon (manufactured by Bruker AXS)

Measurement probe: RTESPA-150-30 (used in Examples 4, 6, 7, 9, 12, 15, 17, 18, 24, 25, and 26 and Comparative Examples 1, 3, 4, 6, and 7)

RTESPA-300-30 (used in the other Examples and Comparative Examples)

Measurement frequency: 2,000 Hz

Measurement atmosphere: 23°C under an air atmosphere

Measurement field of view: 10 $\mu$m $\times$ 10 $\mu$m

The number of measurement points: 4096 points (64 lengthwise $\times$ 64 crosswise) per field of view
Five fields of view per Example

Measurement mode: AFM-DMA mode
Poisson ratio: 0.5

4. Extraction of each region and calculation of characteristic value

Regions (A1) and (A2) were extracted by binarization in which a data point for a storage modulus of 100 MPa or more and 500 MPa or less was defined as "1" and other data points were defined as "0".

Then, the area ratios of the regions (A1) and (A2) were calculated by dividing the number of data points of each of the extracted regions (A1) and (A2) by the total number of measurement data.

Finally, the average storage modulus and the average loss modulus of the regions (A1) and (A2) were determined by dividing the respective sums of the storage modulus and the loss modulus, respectively, of each of the extracted regions (A1) and (A2) by the number of data points of each of the extracted regions (A1) and (A2).

Likewise, regions (B1) and (B2) were extracted by binarization in which a data point for a storage modulus of 3 MPa or more and 15 MPa or less was defined as "1" and other data points were defined as "0".

Then, the area ratios of the regions (B1) and (B2) were calculated by dividing the number of data points of each of the extracted regions (B1) and (B2) by the total number of measurement data.

Finally, the average storage modulus and the average loss modulus of the regions (B1) and (B2) were determined by dividing the respective sums of the storage modulus and the loss modulus, respectively, of each of the extracted regions (B1) and (B2) by the number of data points of each of the extracted regions (B1) and (B2).

Likewise, regions (C1) and (C2) were extracted by binarization in which a data point for a storage modulus of more than 15 MPa and less than 100 MPa was defined as "1" and other data points were defined as "0".

Then, the area ratios of the regions (C1) and (C2) were calculated by dividing the number of data points of each of the extracted regions (C1) and (C2) by the total number of measurement data.

Finally, the average storage modulus and the average loss modulus of the regions (C1) and (C2) were

35

determined by dividing the respective sums of the storage modulus and the loss modulus, respectively, of each of the extracted regions (C1) and (C2) by the number of data points of each of the extracted regions (C1) and (C2).

The sum of the respective area ratios of the regions described in Tables 5 to 8 is not always 100%. In the presence of a data point for a storage modulus of less than 3 MPa or more than 500 MPa, the sum of the respective area ratios of the regions is not 100%. For example, in Comparative Example 2 described in Table 6, the sum of the area ratios of the region (B1) and the region (C1) was 47%, whereas the sum of the respective area ratios of the regions was not 100% because the storage modulus of the remaining data points were more than 500 MPa.

5. Extraction of region (a1) by opening treatment

The binarized mapping data of the region (A1) extracted by the method described above is subjected to opening treatment by morphological operation as described below.

First, erosion treatment is performed as follows. The target pixel data and its 8-neighbor data are summed. The target data is given "1" when the sum is 6 or more, and given "0" when the sum is 5 or less (erosion treatment using 8 neighbors and a threshold of 3).

Subsequently, dilation treatment is performed as follows. The target pixel data and its 8-neighbor data are summed. The target data is given "1" when the sum is 3 or more, and given "0" when the sum is 2 or less (dilation treatment using 8 neighbors and a threshold of 3).

The new data point of "1" obtained by the image processing operation described above is defined as a region (a1).

The binarization treatment and the opening treatment described above can be performed using known software such as ImageJ, Excel, or Open Source Computer Vision Library (OpenCV).

The results of the dynamic elasticity mapping measurement by AFM are shown in Tables 5 to 8 below.

<Measurement of glass transition temperature (Tg)>

1. Preparation of sample

First, an aqueous dispersion of polymer particles was dried in an oven of 100°C to obtain a dried product of the polymer particles.

Then, the dried product of the polymer particles was sandwiched between mold release films, and a pressure of 200 kg/cm$^2$ was applied thereto under a condition of 160°C for four minutes in a press using a 1.0 mm spacer to obtain a sheet of the polymer particles with a thickness of 1.0 mm.

Likewise, a thermoplastic elastomer was sandwiched between mold release films, and a pressure of 200 kg/cm$^2$ was applied thereto under a condition of 160°C for four minutes in a press using a 1.0 mm spacer to obtain a sheet of the thermoplastic elastomer with a thickness of 1.0 mm.

The mold release films were peeled from the obtained samples, and the resultants were molded into circles with a diameter of 8 mm using a hole punch.

2. Apparatus, measurement conditions, etc.

The dynamic viscoelasticity of the polymer particles and the thermoplastic elastomer was measured using an apparatus and measurement conditions given below. The measurement was performed from the low temperature side, and the peak temperature of tan$\delta$ observed first was regarded as a glass transition temperature (Tg).

Apparatus: Discovery Hybrid Rheometer 2 (manufactured by TA Instruments Japan Inc., trademark)
Measurement plate: Parallel plate with a diameter of 8 mm
Normal stress: 1.0 N
Sensitivity: 0.3 N
Strain in direction of rotation: 0.1%
Measurement start temperature: -120°C
Measurement end temperature: 30°C
Temperature elevation rate: 5°C/min
Measurement frequency: 1 Hz

If no sheet can be obtained by the measurement sample preparation method described above, the glass transition temperature Tg may be measured by DSC in accordance with JIS K 6240 (2011). Specifically, 20 mg of the target compound was weighed and placed on an aluminum sample dish, which was then put in a differential scanning calorimeter (DSC7000X, manufactured by Hitachi High-Tech Science Corp.) where the temperature was lowered to -140°C at a temperature lowering rate of 10°C/min and then kept for one minute. Thereafter, the temperature was elevated to (Tg + 40°C) at a temperature elevation rate of 20°C/min to obtain a DSC curve. The glass transition temperature (Tg) was determined from a temperature at the point of inflection in the obtained DSC curve.

The results of measuring the Tg are shown in Tables 1 to 4.

Commercially available products can be used as the polymer particles and the thermoplastic elastomer. In the case of commercially available products, catalog data of the commercially available products or data described in a known literature may be adopted to the Tg. The unit of the Tg is Celsius (°C).

<Measurement method of number average molecular weight (Mn) by gel permeation column chromatography (GPC)>

1. Preparation of sample

To 0.5 g of the measurement target was added 10 g of tetrahydrofuran, and the measurement target was left for two hours and dissolved while ultrasonic wave was applied thereto. Then, the solution was filtered through a polytetrafluoroethylene membrane filter (pore size: 3 μm, manufactured by ADVANTEC), and the filtrate was used as a measurement sample.

2. Apparatus, measurement conditions, etc.

GPC measurement of the emulsion compound was carried out using an apparatus and measurement conditions given below. When the obtained GPC chart is bimodal, the largest number average molecular weight is adopted in the present embodiment.

Apparatus: HLC-8220 GPC manufactured by Tosoh Corp.
Column: the following four columns were connected in series for separation.

TSKgel GMH XL manufactured by Tosoh Corp.
TSKgel GMH XL manufactured by Tosoh Corp.
TSKgel GMH XLL manufactured by Tosoh Corp.
TSKgel GMH XLL manufactured by Tosoh Corp.

Column temperature: 40°C
Solvent: tetrahydrofuran
Flow rate: 1 mL/min
Detector: RI
Calibration curve: standard polystyrene

The results of measuring the number average molecular weight (Mn) by the gel permeation column chromatography (GPC) are shown in the list of the materials used in Table 1 in the paragraph 0311.

<Measurement of dynamic viscoelasticity>

1. Preparation of sample from flexographic printing raw plate

The infrared ablation layer constituting the flexographic printing raw plate obtained in Manufacturing Example 5 described above was wiped with a nonwoven fabric using a solvent such as acetone. Thereafter, a pressure of 50 kg/cm$^2$ was applied to the obtained stack of the support and the photosensitive resin composition layer under a condition of 120°C for four minutes in a press to thereby recover the photosensitive resin composition layer coming out of the support.

Then, the photosensitive resin composition was sandwiched between mold release films, and a pressure of 200 kg/cm$^2$ was applied thereto under a condition of 120°C for four minutes in a press using a 1.5 mm spacer to obtain a photosensitive resin composition sheet having the photosensitive resin composition layer with a thickness of 1.5 mm. Thereafter, both faces of the photosensitive resin composition sheet were entirely exposed to ultraviolet light of 3000 mJ/cm$^2$ per face using the exposure apparatus "AFP-1216".

The mold release films were peeled from the obtained sample, and the cured product with a thickness of 1.5 mm was molded into a circle with a diameter of 8 mm using a hole punch.

2. Apparatus, measurement conditions, etc.

The dynamic viscoelasticity of the cured product of the photosensitive resin composition was measured using the following apparatus and measurement conditions.

Apparatus: Discovery Hybrid Rheometer 2 (manufactured by TA Instruments Japan Inc., trademark)
Measurement plate: Parallel plate with a diameter of 8 mm
Normal stress: 5 N
Sensitivity: 0.1 N
Strain in direction of rotation: 0.1%
Measurement temperature: -30°C
Measurement frequency: 2.5 Hz

The results of measuring the dynamic viscoelasticity are shown in Tables 7 and 8 below.

[Characteristic evaluation]

<Printing test>

A flexographic printing test was conducted under (Printing conditions) given below using the flexographic printing plate obtained in each of Examples and Comparative Examples.
First, a printing pressure at which the entire surface of an image started to be inked was defined as a reference printing pressure (kiss touch), and prints were recovered after 100 m printing and after 100000 m printing.
Then, the flexographic printing plate was replaced with a fresh one, which was then pushed in by 100 μm from the reference printing pressure, and prints were recovered after 100 m printing and after 100000 m printing.

(Printing conditions)

Flexographic printer: AI-3 type flexographic printer (manufactured by Iyokikai Seisakusho Co., Ltd.)
Printing object: NPi Form Paper (manufactured by Nippon Paper Industries Co., Ltd., trademark)
Ink: Indigo Process PR-1003 (manufactured by Sakata Inx Corp.)
Anilox roll: 800 lpi (cell volume: 3.8 $cm^3/m^2$)
Cushion tape: DuploFLEX 5.2 (manufactured by Lohmann GmbH & Co. KG, trademark)
Printing rate: 200 m/min
Temperature of printing room: 23°C
Relative humidity of printing room: 50%

<Halftone evaluation>

The halftone image ratios (halftone image ratio = halftone ink density / solid ink density ) of the prints obtained in <Printing test> described above were measured using eXact (manufactured by X-Rite, Inc.).
Then, the printed part of the halftone having a halftone image ratio of 10% in the prints was observed in a 5 mm × 5 mm field of view at a magnification of 40× in a microscope (manufactured by Keyence Corp., VHX-1000), and the number of halftone dots having poor printing (missing dot or slur) was counted and evaluated according to an evaluation scale given below. Those given a score of 3 or more on the following evaluation scale can be practically used without any problem.

(Evaluation scale)

5: No halftone dot has poor printing.
4: One or more and two or less halftone dots have poor printing.
3: Four or more and nine or less halftone dots have poor printing.
2: Ten or more and 19 or less halftone dots have poor printing.
1: Twenty or more halftone dots have poor printing.

<Ink lay down evaluation>

The ink density of the solid part in the prints obtained in <Printing test> described above was measured using eXact (manufactured by X-Rite, Inc.). An average value from measurement at seven points was used as the ink density.

Those given a score of 3 or more on the following evaluation scale can be practically used without any problem.

5: The ink density of the solid part is 0.95 or more.
4: The ink density of the solid part is 0.9 or more and less than 0.95.
3: The ink density of the solid part is 0.85 or more and less than 0.9.
2: The ink density of the solid part is 0.8 or more and less than 0.85.
1: The ink density of the solid part is less than 0.8.

The results of each evaluation described above are shown in Table 9 below.

[Table 1]

| | | | Mn | Synthesis Example 1 | Synthesis Example 2 | Synthesis Example 3 | Synthesis Example 4 | Synthesis Example 5 | Synthesis Example 6 | Synthesis Example 7 | Synthesis Example 8 | Synthesis Example 9 | Synthesis Example 10 | Synthesis Example 11 | Synthesis Example 12 | Synthesis Example 13 | Synthesis Example 14 | Synthesis Example 15 | Synthesis Example 16 |
|---|---|---|---|---|---|---|---|---|---|---|---|---|---|---|---|---|---|---|---|
| Initial addition | Reactive emulsifier | ADEKA REASOAP SE1025 | | 5.2 | 5.2 | 5.2 | 5.2 | 6 | 4.4 | 3.6 | 4.4 | 5.2 | 6 | 6.8 | 6 | 6.8 | 7.6 | 2 | 2 |
| | Water | | | 325 | 325 | 325 | 325 | 375 | 275 | 225 | 275 | 325 | 375 | 425 | 375 | 425 | 475 | 125 | 125 |
| Oil-based mixture | Conjugated diene | 1, 3-Butadiene | 54 | 100 | 100 | 100 | 100 | 100 | 100 | 100 | 100 | 100 | 100 | 100 | 100 | 100 | 100 | 60 | 20 |
| | Aromatic vinyl | Styrene | 104 | 80 | 80 | 80 | 80 | 120 | 40 | 40 | 80 | 40 | 80 | 120 | 40 | 80 | 120 | 10 | 45 |
| | Monobasic acid monomer | AA | 72 | 5 | 5 | 5 | 5 | 5 | 5 | 5 | 5 | 5 | 5 | 5 | 5 | 5 | 10 | 2 | 2 |
| | | MAA | 86 | 15 | 15 | 15 | 15 | 15 | 10 | 10 | 10 | 15 | 15 | 20 | 15 | 20 | 20 | 5 | 5 |
| | (Meth) acrylic acid ester | BA | 128 | | | | | | | | | | | | | | | 23 | 28 |
| | | 2-EHA | 184 | 60 | | | | 60 | 65 | 25 | 25 | 100 | 100 | 95 | 140 | 135 | 130 | | |
| | | LA | 240 | | 60 | | | | | | | | | | | | | | |
| | | ISTA | 324 | | | 60 | | | | | | | | | | | | | |
| | | MPE400A | 470 | | | | 60 | | | | | | | | | | | | |
| | Chain transfer agent | t-Dodecyl mercaptan | | 5.2 | 5.2 | 5.2 | 5.2 | 6 | 4.4 | 3.6 | 4.4 | 5.2 | 6 | 6.8 | 6 | 6.8 | 7.6 | 2 | 2 |
| Aqueous mixture | Reactive emulsifier | ADEKA REASOAP SE1025 | | 5.2 | 5.2 | 5.2 | 5.2 | 6 | 4.4 | 3.6 | 4.4 | 5.2 | 6 | 6.8 | 6 | 6.8 | 7.6 | 2 | 2 |
| | Additive | Sodium peroxodisulfate | | 3.1 | 3.1 | 3.1 | 3.1 | 3.6 | 2.6 | 2.2 | 2.6 | 3.1 | 3.6 | 4.1 | 3.6 | 4.1 | 4.6 | 1.2 | 1.2 |
| | | Sodium hydroxide | | 0.5 | 0.5 | 0.5 | 0.5 | 0.6 | 0.4 | 0.4 | 0.4 | 0.5 | 0.6 | 0.7 | 0.6 | 0.7 | 0.8 | 0.2 | 0.2 |
| | Water | | | 73 | 73 | 73 | 73 | 84 | 62 | 50 | 62 | 73 | 84 | 95 | 84 | 95 | 106 | 28 | 28 |
| Glass transition temperature Tg / °C | | | | -25 | -17 | -16 | -31 | -12 | -43 | -38 | -20 | -42 | -29 | -16 | -44 | -30 | -18 | -57 | 2 |

EP 4 528 377 A1

40

[Table 2]

| | Mixture containing polymer particles | | Thermoplastic elastomer | Photopolymerizable compound | | Plasticizer | Photopolymerization initiator | Stabilizer | Tg of polymer particles /°C | Tg of thermoplastic elastomer/°C |
| | Polymer particles | Photopolymerizable compound 1 | | Photopolymerizable compound 2 | Photopolymerizable compound 3 | | | | | |
|---|---|---|---|---|---|---|---|---|---|---|
| The number of parts for addition | 20 | 5 | 30 | 5 | 5 | 32 | 2 | 1 | | |
| Example 1 | Synthesis Example 1 | 1.9ND | TR2827 | BAC-45 | 1.6HX-A | LBR-352 | Irg651 | BHT | -25 | -88 |
| Example 2 | Synthesis Example 2 | 1.9ND | TR2827 | BAC-45 | 1.6HX-A | LBR-352 | Irg651 | BHT | -17 | -88 |
| Example 3 | Synthesis Example 3 | 1.9ND | TR2827 | BAC-45 | 1.6HX-A | LBR-352 | Irg651 | BHT | -16 | -88 |
| Example 4 | Synthesis Example 4 | 1.9ND | TR2827 | BAC-45 | 1.6HX-A | LBR-352 | Irg651 | BHT | -31 | -88 |
| Example 5 | Synthesis Example 5 | 1.6HX-A | TR2827 | BAC-45 | 1.9ND | LBR-352 | Irg651 | BHT | -12 | -88 |
| Example 6 | Synthesis Example 6 | 1.9ND | TR2827 | BAC-45 | 1.6HX-A | LBR-352 | Irg651 | BHT | -43 | -88 |
| Example 7 | Synthesis Example 7 | 1.9ND | TR2827 | BAC-45 | DCP-A | LBR-352 | Irg651 | BHT | -38 | -88 |
| Example 8 | Synthesis Example 8 | 1.9ND | TR2787 | BAC-45 | 1.6HX-A | LBR-352 | Irg651 | BHT | -20 | -86 |
| Example 9 | Synthesis Example 9 | 1.6HX-A | TR2827 | BAC-45 | 1.9ND | LBR-352 | Irg651 | BHT | -42 | -88 |
| Example 10 | Synthesis Example 10 | 1.9ND | TR2827 | BAC-45 | TMP | LBR-352 | Irg651 | BHT | -29 | -88 |
| Example 11 | Synthesis Example 11 | 1.9ND | T-315 | BAC-45 | 1.6HX-A | LBR-352 | Irg651 | BHT | -16 | -69 |

(continued)

| | Mixture containing polymer particles | | Thermoplastic elastomer | Photopolymerizable compound | | Plasticizer | Photopolymerization initiator | Stabilizer | Tg of polymer particles /°C | Tg of thermoplastic elastomer/°C |
|---|---|---|---|---|---|---|---|---|---|---|
| | Polymer particles | Photopolymerizable compound 1 | | Photopolymerizable compound 2 | Photopolymerizable compound 3 | | | | | |
| The number of parts for addition | 20 | 5 | 30 | 5 | 5 | 32 | 2 | 1 | | |
| Example 12 | Synthesis Example 12 | DCP-A | TR2827 | BAC-45 | S | Ricon156 | Irg651 | BHT | -44 | -88 |
| Example 13 | Synthesis Example 13 | 1.9ND | TR2827 | CN307 | 1.6HX-A | LBR-352 | Irg651 | BHT | -30 | -88 |
| Example 14 | Synthesis Example 14 | 1.9ND | TR2827 | CN9014NS | 1.6HX-A | LBR-352 | Irg651 | BHT | -18 | -88 |
| Example 15 | Synthesis Example 1 | S | TR2827 | 1.9ND | 1.6HX-A | LBR-352 | Irg651 | BHT | -25 | -88 |

[Table 3]

| | Polymer particle mixture | | Thermoplastic elastomer | Photopolymerizable compound | | Plasticizer | Photopolymerization initiator | Stabilizer | Detergent builder | Total number of parts |
| | Polymer particles | Photopolymerizable compound 1 | | Photopolymerizable compound 2 | Photopolymerizable compound 3 | | | | | |
| Constituent material name | Production Example 1 (Tg: -25°C) | 1.9ND | TR2827 (Tg: -88°C) | BAC-45 | 1.6HX-A | LBR-352 | Irg651 | BHT | EMAL 0 | |
| Example 1 | 20 | 5 | 30 | 5 | 5 | 32 | 2 | 1 | | 100 |
| Example 16 | 30 | 10 | 30 | 5 | 5 | 15 | 4 | 1 | | 100 |
| Example 17 | 10 | 3 | 50 | 5 | 7 | 20 | 4 | 1 | | 100 |
| Example 18 | 3 | 1 | 30 | 5 | 7 | 50 | 3 | 1 | | 100 |
| Example 19 | 20 | 5 | 30 | 1 | 10 | 30 | 3 | 1 | | 100 |
| Example 20 | 20 | 5 | 30 | 10 | 5 | 25 | 3 | 1 | 1 | 100 |
| Example 21 | 20 | 5 | 30 | 15 | 5 | 20 | 3 | 1 | 1 | 100 |
| Example 22 | 20 | 5 | 30 | 20 | 5 | 15 | 3 | 1 | 1 | 100 |
| Example 23 | 20 | 3 | 25 | 3 | 8 | 35 | 5 | 1 | | 100 |
| Example 24 | 20 | 5 | 55 | 3 | 3 | 10 | 3 | 1 | | 100 |
| Example 25 | 20 | 3 | 25 | 5 | 3 | 40 | 3 | 1 | | 100 |
| Example 26 | 20 | 5 | 40 | 5 | 5 | 20 | 4 | 1 | | 100 |

EP 4 528 377 A1

43

[Table 4]

| | | Polymer particles | Thermoplastic elastomer | Photopolymerizable compound | | | Plasticizer | Photopoly merization initiator | Stabilizer | Detergent builder |
|---|---|---|---|---|---|---|---|---|---|---|
| | | | | Photopolymeriz able compound 1 | Photopolymeriz able compound 2 | Photopolymeri zable compound 3 | | | | |
| Comparative Example 1 | Added material name | Production Example 15 (Tg: -57°C) | TR2827 (Tg: -88°C) | BAC-45 | 1.9ND | 1.6HX-A | LBR-352 | Irg651 | BHT | |
| | The number of parts for addition | 20 | 30 | 5 | 5 | 5 | 32 | 2 | 1 | |
| Comparative Example 2 | Added material name | Production Example 16 (Tg: 2°C) | TR2827 (Tg: -88°C) | 1.9ND | | | B3000 | Irg651 | BHT | EMAL 0 |
| | The number of parts for addition | 30 | 20 | 15 | | | 30 | 2 | 1 | 2 |
| Comparative Example 3 | Added material name | | TR2827 (Tg: -88°C) | BAC-45 | 1.9ND | 1.6HX-A | LBR-352 | Irg651 | BHT | |
| | The number of parts for addition | | 50 | 5 | 5 | 5 | 32 | 2 | 1 | |

(continued)

| | | Polymer particles | Thermoplastic elastomer | Photopolymerizable compound | | | Plasticizer | Photopolymerization initiator | Stabilizer | Detergent builder |
| --- | --- | --- | --- | --- | --- | --- | --- | --- | --- | --- |
| | | | | Photopolymerizable compound 1 | Photopolymerizable compound 2 | Photopolymerizable compound 3 | | | | |
| Comparative Example 4 | Added material name | LX111NF (Tg: -82°C) | | BAC-45 | TMP | | B3000 | Irg651 | MEHQ | |
| | The number of parts for addition | 60 | | 15 | 5 | | 15 | 5 | 0.1 | |
| Comparative Example 5 | Added material name | SX1503A (Tg: -26°C) | | BAC-45 | TMP | | B3000 | Irg651 | MEHQ | |
| | The number of parts for addition | 60 | | 15 | 5 | | 15 | 5 | 0.1 | |
| Comparative Example 6 | Added material name | LX111NF (Tg: -82°C) | BR1220 (Tg: -102°C) | BAC-45 | TMP | IB-X | PW-32 | Irg651 | MEHQ | EMAL 0 |
| | The number of parts for addition | 35 | 20 | 10 | 10 | 3 | 15 | 3 | 0.2 | 4 |

| | | Polymer particles | Thermoplastic elastomer | Photopolymerizable compound | | | Plasticizer | Photopoly merization initiator | Stabilizer | Detergent builder |
|---|---|---|---|---|---|---|---|---|---|---|
| | | | | Photopolymeriz able compound 1 | Photopolymeriz able compound 2 | Photopolymeri zable compound 3 | | | | |
| Comparative Example 7 | Added material name | LX111NF (Tg: -82°C) | BR1220 (Tg: -102°C) | 1.9ND | IB-X | DCP | | Irg651 | | EMAL 0 |
| | The number of parts for addition | 30 | 10 | 8 | 2.5 | 1.5 | | 4.5 | | 2 |

[Table 5]

| | Region (A1) | | | | Region (B1) | | | | Region (C1) | | | | (A1/B1) Area ratio | (A1'/A1) Area ratio | (B1'/B1) Area ratio | (C1/B1) Area ratio | Opening treatment (a2/a1) Area ratio |
|---|---|---|---|---|---|---|---|---|---|---|---|---|---|---|---|---|---|
| | Area ratio | Average storage modulus / MPa | Average loss modulus / MPa | tan$\delta$ | Area ratio | Average storage modulus / MPa | Average loss modulus / MPa | tan$\delta$ | Area ratio | Average storage modulus / MPa | Average loss modulus / MPa | tan$\delta$ | | | | | |
| Example 1 | 22% | 211 | 137 | 0.65 | 36% | 11 | 6 | 0.55 | 42% | 26 | 15 | 0.59 | 0.61 | 65% | 62% | 1.17 | 99% |
| Example 2 | 25% | 298 | 155 | 0.52 | 46% | 10 | 4 | 0.42 | 29% | 20 | 9 | 0.46 | 0.54 | 34% | 51% | 0.63 | 90% |
| Example 3 | 26% | 303 | 155 | 0.51 | 42% | 9 | 4 | 0.41 | 32% | 32 | 14 | 0.45 | 0.62 | 18% | 43% | 0.76 | 92% |
| Example 4 | 22% | 188 | 147 | 0.78 | 41% | 11 | 7 | 0.68 | 37% | 27 | 19 | 0.72 | 0.54 | 60% | 63% | 0.90 | 91% |
| Example 5 | 29% | 461 | 157 | 0.34 | 47% | 6 | 1 | 0.24 | 24% | 23 | 6 | 0.28 | 0.62 | 5% | 22% | 0.51 | 90% |
| Example 6 | 14% | 139 | 99 | 0.71 | 39% | 10 | 6 | 0.61 | 47% | 21 | 14 | 0.65 | 0.36 | 82% | 50% | 1.21 | 99% |
| Example 7 | 18% | 161 | 109 | 0.68 | 42% | 11 | 6 | 0.58 | 40% | 29 | 18 | 0.62 | 0.43 | 77% | 64% | 0.95 | 99% |
| Example 8 | 23% | 303 | 161 | 0.53 | 44% | 14 | 5 | 0.36 | 33% | 46 | 16 | 0.35 | 0.52 | 22% | 84% | 0.75 | 97% |
| Example 9 | 16% | 191 | 134 | 0.70 | 43% | 5 | 3 | 0.60 | 41% | 32 | 20 | 0.64 | 0.37 | 73% | 13% | 0.95 | 99% |
| Example 10 | 20% | 244 | 139 | 0.57 | 49% | 14 | 7 | 0.47 | 31% | 30 | 15 | 0.51 | 0.41 | 50% | 79% | 0.63 | 98% |
| Example 11 | 33% | 311 | 96 | 0.31 | 57% | 7 | 2 | 0.25 | 10% | 45 | 9 | 0.20 | 0.58 | 22% | 26% | 0.18 | 14% |
| Example 12 | 8% | 139 | 92 | 0.66 | 41% | 3 | 2 | 0.56 | 51% | 33 | 20 | 0.60 | 0.20 | 88% | 2% | 1.24 | 95% |
| Example 13 | 20% | 234 | 129 | 0.55 | 48% | 11 | 5 | 0.45 | 32% | 29 | 14 | 0.49 | 0.42 | 55% | 58% | 0.67 | 97% |

| | Region (A1) | | | | Region (B1) | | | | Region (C1) | | | | (A1/B1) Area ratio | (A1'/A1) Area ratio | (B1'/B1) Area ratio | (C1/B1) Area ratio | Opening treatment (a2/a1) Area ratio |
|---|---|---|---|---|---|---|---|---|---|---|---|---|---|---|---|---|---|
| | Area ratio | Average storage modulus / MPa | Average loss modulus / MPa | $\tan\delta$ | Area ratio | Average storage modulus / MPa | Average loss modulus / MPa | $\tan\delta$ | Area ratio | Average storage modulus / MPa | Average loss modulus / MPa | $\tan\delta$ | | | | | |
| Example 14 | 24% | 265 | 111 | 0.42 | 51% | 9 | 3 | 0.32 | 25% | 26 | 9 | 0.36 | 0.47 | 46% | 42% | 0.49 | 98% |
| Example 15 | 16% | 170 | 88 | 0.52 | 62% | 13 | 4 | 0.32 | 22% | 23 | 7 | 0.31 | 0.26 | 88% | 78% | 0.35 | 99% |

[Table 6]

| | Region (A1) | | | | Region (B1) | | | | Region (C1) | | | | (A1/B1) Area ratio | (A1'/A1) Area ratio | (B1'/B1) Area ratio | (C1/B1) Area ratio | Opening treatment (a2/a1) Area ratio |
|---|---|---|---|---|---|---|---|---|---|---|---|---|---|---|---|---|---|
| | Area ratio | Average storage modulus/ MPa | Average loss modulus/ MPa | tan$\delta$ | Area ratio | Average storage modulus/ MPa | Average loss modulus/ MPa | tan$\delta$ | Area ratio | Average storage modulus/ MPa | Average loss modulus/ MPa | tan$\delta$ | | | | | |
| Example 16 | 35% | 323 | 178 | 0.55 | 35% | 10 | 5 | 0.45 | 30% | 52 | 27 | 0.52 | 1.00 | 19% | 51% | 0.86 | 38% |
| Example 17 | 8% | 198 | 109 | 0.55 | 51% | 11 | 5 | 0.48 | 41% | 44 | 22 | 0.49 | 0.16 | 69% | 63% | 0.80 | 99% |
| Example 18 | 3% | 166 | 75 | 0.45 | 62% | 12 | 4 | 0.35 | 35% | 43 | 17 | 0.39 | 0.05 | 74% | 74% | 0.56 | 99% |
| Example 19 | 22% | 212 | 70 | 0.33 | 36% | 12 | 3 | 0.23 | 42% | 89 | 24 | 0.27 | 0.61 | 58% | 77% | 1.17 | 96% |
| Example 20 | 20% | 207 | 126 | 0.61 | 41% | 11 | 4 | 0.36 | 39% | 46 | 16 | 0.35 | 0.49 | 63% | 59% | 0.95 | 97% |
| Example 21 | 23% | 221 | 148 | 0.67 | 45% | 12 | 7 | 0.57 | 32% | 57 | 35 | 0.61 | 0.51 | 55% | 71% | 0.71 | 97% |
| Example 22 | 17% | 244 | 144 | 0.59 | 51% | 11 | 5 | 0.49 | 32% | 72 | 38 | 0.53 | 0.33 | 50% | 61% | 0.63 | 97% |
| Example 23 | 13% | 201 | 131 | 0.65 | 38% | 10 | 6 | 0.55 | 49% | 89 | 53 | 0.59 | 0.34 | 65% | 53% | 1.29 | 52% |
| Example 24 | 22% | 170 | 102 | 0.60 | 65% | 13 | 7 | 0.50 | 13% | 21 | 11 | 0.54 | 0.34 | 76% | 82% | 0.20 | 94% |
| Example 25 | 28% | 155 | 91 | 0.59 | 64% | 5 | 2 | 0.49 | 8% | 19 | 10 | 0.53 | 0.44 | 86% | 13% | 0.13 | 46% |
| Example 26 | 19% | 198 | 113 | 0.57 | 63% | 8 | 4 | 0.47 | 18% | 29 | 15 | 0.51 | 0.30 | 66% | 22% | 0.29 | 99% |
| Comparative Example 1 | 0% | - | - | - | 33% | 12 | 4 | 0.33 | 67% | 19 | 5 | 0.26 | 0.00 | - | 70% | 2.03 | - |
| Comparative Example 2 | 0% | - | - | - | 42% | 9 | 2 | 0.27 | 5% | 22 | 6 | 0.29 | 0.00 | - | 72% | 0.12 | - |
| Comparative Example 3 | 0% | - | - | - | 100% | 7 | 2 | 0.29 | 0% | - | - | - | 0.00 | - | 21% | 0.00 | - |
| Comparative Example 4 | 0% | - | - | - | 86% | 8 | 2 | 0.25 | 14% | 45 | 9 | 0.20 | 0.00 | - | 33% | 0.16 | - |
| Comparative Example 5 | 88% | 354 | 106 | 0.30 | 0% | - | - | - | 12% | 58 | 15 | 0.25 | - | 7% | - | - | 0% |
| Comparative Example 6 | 0% | - | - | - | 58% | 8 | 4 | 0.50 | 42% | 25 | 5 | 0.20 | 0.00 | - | 30% | 0.72 | - |
| Comparative Example 7 | 0% | - | - | - | 21 % | 14 | 5 | 0.36 | 79% | 21 | 8 | 0.38 | 0.00 | - | 92% | 3.76 | - |

[Table 7]

| | Dynamic viscoelasticity mapping measurement by AFM | | | | | | | | | | | | | Dynamic viscoelasticity measurement | | |
| | Region (A2) | | | | Region (B2) | | | | Region (C2) | | | | (A2/B2) Area ratio | (C2/B2) Area ratio | Storage modulus G' / MPa | Loss modulus G" / MPa | G'+G" / MPa |
| | Area ratio | Average storage modulus / MPa | Average loss modulus / MPa | tanδ | Area ratio | Average storage modulus / MPa | Average loss modulus / MPa | tanδ | Area ratio | Average storage modulus / MPa | Average loss modulus / MPa | tanδ | | | | | |
|---|---|---|---|---|---|---|---|---|---|---|---|---|---|---|---|---|---|
| Example 1 | 20% | 200 | 134 | 0.67 | 36% | 10 | 6 | 0.58 | 44% | 24 | 15 | 0.61 | 0.56 | 1.22 | 7.8 | 3.6 | 11.4 |
| Example 2 | 26% | 283 | 152 | 0.54 | 44% | 9 | 4 | 0.44 | 30% | 19 | 9 | 0.48 | 0.59 | 0.68 | 10.8 | 3.9 | 14.7 |
| Example 3 | 27% | 287 | 151 | 0.53 | 40% | 8 | 4 | 0.43 | 33% | 30 | 14 | 0.47 | 0.68 | 0.83 | 11.1 | 3.9 | 15.0 |
| Example 4 | 24% | 178 | 143 | 0.80 | 43% | 10 | 7 | 0.72 | 33% | 25 | 19 | 0.75 | 0.56 | 0.77 | 7.9 | 4.5 | 12.4 |
| Example 5 | 27% | 437 | 153 | 0.35 | 46% | 6 | 1 | 0.25 | 27% | 21 | 6 | 0.29 | 0.59 | 0.59 | 18.0 | 4.0 | 22.1 |
| Example 6 | 12% | 132 | 97 | 0.73 | 41% | 9 | 6 | 0.64 | 47% | 20 | 13 | 0.68 | 0.29 | 1.15 | 4.1 | 2.1 | 6.2 |
| Example 7 | 16% | 153 | 107 | 0.70 | 40% | 10 | 6 | 0.61 | 44% | 27 | 17 | 0.64 | 0.40 | 1.10 | 5.7 | 2.7 | 8.4 |
| Example 8 | 21% | 287 | 157 | 0.55 | 45% | 13 | 5 | 0.38 | 34% | 43 | 16 | 0.36 | 0.47 | 0.76 | 10.2 | 3.3 | 13.5 |
| Example 9 | 17% | 181 | 131 | 0.72 | 42% | 5 | 3 | 0.63 | 41% | 30 | 20 | 0.67 | 0.40 | 0.98 | 6.4 | 3.2 | 9.7 |
| Example 10 | 20% | 231 | 136 | 0.59 | 47% | 13 | 6 | 0.50 | 33% | 28 | 15 | 0.53 | 0.43 | 0.70 | 8.8 | 3.5 | 12.3 |
| Example 11 | 35% | 295 | 94 | 0.32 | 55% | 6 | 2 | 0.26 | 10% | 42 | 9 | 0.21 | 0.64 | 0.18 | 2.0 | 0.4 | 2.4 |
| Example 12 | 8% | 132 | 90 | 0.68 | 39% | 3 | 2 | 0.59 | 53% | 31 | 19 | 0.62 | 0.21 | 1.36 | 4.0 | 1.9 | 5.9 |
| Example 13 | 22% | 222 | 126 | 0.57 | 45% | 10 | 5 | 0.47 | 33% | 27 | 14 | 0.51 | 0.49 | 0.73 | 8.9 | 3.5 | 12.3 |

(continued)

| | Dynamic viscoelasticity mapping measurement by AFM | | | | | | | | | | | | | | Dynamic viscoelasticity measurement | | |
| --- | --- | --- | --- | --- | --- | --- | --- | --- | --- | --- | --- | --- | --- | --- | --- | --- | --- |
| | Region (A2) | | | | Region (B2) | | | | Region (C2) | | | | (A2/B2) Area ratio | (C2/B2) Area ratio | Storage modulus G' / MPa | Loss modulus G" / MPa | G'+G" / MPa |
| | Area ratio | Average storage modulus / MPa | Average loss modulus / MPa | tanδ | Area ratio | Average storage modulus / MPa | Average loss modulus / MPa | tanδ | Area ratio | Average storage modulus / MPa | Average loss modulus / MPa | tanδ | | | | | |
| Example 14 | 25% | 251 | 109 | 0.43 | 48% | 8 | 3 | 0.34 | 27% | 24 | 9 | 0.37 | 0.52 | 0.56 | 10.5 | 3.0 | 13.5 |
| Example 15 | 17% | 161 | 86 | 0.54 | 63% | 12 | 4 | 0.34 | 22% | 21 | 7 | 0.32 | 0.27 | 0.35 | 5.7 | 1.7 | 7.4 |

[Table 8]

| | Dynamic viscoelasticity mapping measurement by AFM | | | | | | | | | | | | | | Dynamic viscoelasticity measurement | | |
| | Region (A2) | | | | Region (B2) | | | | Region (C2) | | | | (A2/B2) Area ratio | (C2/B2) Area ratio | Storage modulus G' / MPa | Loss modulus G'' / MPa | G'+G'' / MPa |
| | Area ratio | Average storage modulus / MPa | Average loss modulus / MPa | tanδ | Area ratio | Average storage modulus / MPa | Average loss modulus / MPa | tanδ | Area ratio | Average storage modulus / MPa | Average loss modulus / MPa | tanδ | | | | | |
|---|---|---|---|---|---|---|---|---|---|---|---|---|---|---|---|---|---|
| Example 16 | 33% | 306 | 174 | 0.57 | 32% | 9 | 4 | 0.47 | 35% | 49 | 26 | 0.54 | 1.03 | 1.09 | 17.3 | 6.8 | 24.1 |
| Example 17 | 9% | 188 | 107 | 0.57 | 46% | 10 | 5 | 0.51 | 45% | 41 | 21 | 0.51 | 0.20 | 0.98 | 5.7 | 2.3 | 8.0 |
| Example 18 | 3% | 157 | 73 | 0.46 | 65% | 11 | 4 | 0.37 | 32% | 40 | 16 | 0.41 | 0.05 | 0.49 | 3.5 | 1.1 | 4.6 |
| Example 19 | 24% | 201 | 68 | 0.34 | 36% | 11 | 3 | 0.24 | 40% | 83 | 23 | 0.28 | 0.67 | 1.11 | 12.2 | 2.6 | 14.8 |
| Example 20 | 19% | 196 | 124 | 0.63 | 38% | 10 | 4 | 0.38 | 43% | 43 | 16 | 0.36 | 0.50 | 1.13 | 8.5 | 2.9 | 11.4 |
| Example 21 | 24% | 210 | 145 | 0.69 | 43% | 11 | 7 | 0.60 | 33% | 53 | 34 | 0.63 | 0.56 | 0.77 | 10.2 | 4.8 | 15.0 |
| Example 22 | 18% | 231 | 141 | 0.61 | 48% | 10 | 5 | 0.52 | 34% | 67 | 37 | 0.55 | 0.38 | 0.71 | 9.9 | 4.2 | 14.1 |
| Example 23 | 12% | 191 | 128 | 0.67 | 40% | 9 | 5 | 0.58 | 48% | 83 | 51 | 0.61 | 0.30 | 1.20 | 9.5 | 4.4 | 13.9 |
| Example 24 | 20% | 161 | 100 | 0.62 | 63% | 12 | 6 | 0.53 | 17% | 20 | 11 | 0.56 | 0.32 | 0.27 | 6.2 | 2.6 | 8.8 |
| Example 25 | 25% | 147 | 89 | 0.61 | 66% | 5 | 2 | 0.52 | 9% | 18 | 10 | 0.55 | 0.38 | 0.14 | 5.9 | 2.5 | 8.4 |
| Example 26 | 17% | 188 | 110 | 0.59 | 62% | 7 | 4 | 0.50 | 21% | 27 | 14 | 0.53 | 0.27 | 0.34 | 6.0 | 2.4 | 8.5 |
| Comparative Example 1 | 0% | - | - | - | 31% | 11 | 4 | 0.35 | 69% | 18 | 5 | 0.27 | 0.00 | 2.23 | 3.5 | 1.1 | 4.6 |
| Comparative Example 2 | 0% | - | - | - | 40% | 9 | 2 | 0.27 | 6% | 21 | 7 | 0.29 | 0.00 | - | 37.2 | 11.1 | 48.3 |
| Comparative Example 3 | 0% | - | - | - | 100% | 6 | 2 | 0.30 | 0% | - | - | - | 0.00 | 0.00 | 0.7 | 0.1 | 0.8 |
| Comparative Example 4 | 0% | - | - | - | 88% | 7 | 2 | 0.26 | 12% | 42 | 9 | 0.21 | 0.00 | 0.14 | 2.0 | 0.4 | 2.4 |
| Comparative Example 5 | 90% | 336 | 101 | 0.30 | 0% | - | - | - | 10% | 54.114 | 14 | 0.26 | - | - | 2.0 | 0.4 | 2.4 |
| Comparative Example 6 | 0% | - | - | - | 61% | 7 | 4 | 0.54 | 39% | 23.325 | 5 | 0.21 | 0.00 | 0.64 | 2.7 | 1.4 | 4.1 |

(continued)

| | Dynamic viscoelasticity mapping measurement by AFM | | | | | | | | | | | | | (A2/B2) Area ratio | (C2/B2) Area ratio | Dynamic viscoelasticity measurement | | |
| | Region (A2) | | | | Region (B2) | | | | Region (C2) | | | | | | | Storage modulus G' / MPa | Loss modulus G" / MPa | G'+G"/ MPa |
| | Area ratio | Average storage modulus / MPa | Average loss modulus / MPa | tanδ | Area ratio | Average storage modulus / MPa | Average loss modulus / MPa | tanδ | Area ratio | Average storage modulus / MPa | Average loss modulus / MPa | tanδ | | | | | | |
| Comparative Example 7 | 0% | - | - | - | 19% | 13 | 5 | 0.39 | 81% | 19.593 | 8 | 0.40 | 0.00 | 4.26 | 2.7 | 1.4 | 4.1 |

[Table 9]

| | After 100 m printing | | | | After 100000 m printing | | | |
|---|---|---|---|---|---|---|---|---|
| | Reference printing pressure (Kiss touch) | | Reference printing pressure + 100 μm | | Reference printing pressure (Kiss touch) | | Reference printing pressure + 100 μm | |
| | Solid | Halftone | Solid | Halftone | Solid | Halftone | Solid | Halftone |
| Example 1 | 4 | 5 | 4 | 5 | 3 | 5 | 4 | 4 |
| Example 2 | 4 | 4 | 5 | 4 | 4 | 3 | 4 | 3 |
| Example 3 | 4 | 4 | 5 | 3 | 4 | 3 | 5 | 3 |
| Example 4 | 5 | 4 | 5 | 4 | 4 | 3 | 5 | 3 |
| Example 5 | 3 | 4 | 4 | 4 | 3 | 4 | 3 | 4 |
| Example 6 | 4 | 4 | 5 | 4 | 4 | 4 | 5 | 3 |
| Example 7 | 5 | 5 | 5 | 5 | 5 | 5 | 5 | 4 |
| Example 8 | 4 | 5 | 5 | 5 | 3 | 4 | 4 | 3 |
| Example 9 | 5 | 5 | 5 | 4 | 5 | 5 | 5 | 3 |
| Example 10 | 4 | 5 | 5 | 5 | 4 | 5 | 4 | 4 |
| Example 11 | 4 | 4 | 3 | 3 | 3 | 3 | 3 | 3 |
| Example 12 | 5 | 4 | 5 | 3 | 4 | 3 | 5 | 3 |
| Example 13 | 4 | 5 | 5 | 4 | 4 | 5 | 5 | 3 |
| Example 14 | 4 | 5 | 5 | 4 | 3 | 3 | 3 | 3 |
| Example 15 | 3 | 5 | 4 | 4 | 3 | 3 | 3 | 3 |
| Example 16 | 3 | 4 | 4 | 4 | 3 | 4 | 4 | 4 |
| Example 17 | 5 | 4 | 5 | 3 | 4 | 4 | 5 | 3 |
| Example 18 | 4 | 4 | 4 | 4 | 4 | 3 | 4 | 3 |
| Example 19 | 3 | 5 | 4 | 4 | 3 | 4 | 3 | 3 |
| Example 20 | 4 | 5 | 5 | 4 | 4 | 5 | 4 | 4 |
| Example 21 | 5 | 5 | 5 | 5 | 4 | 5 | 5 | 5 |
| Example 22 | 5 | 5 | 5 | 5 | 4 | 4 | 5 | 4 |
| Example 23 | 4 | 5 | 5 | 4 | 4 | 4 | 4 | 3 |
| Example 24 | 4 | 5 | 5 | 5 | 4 | 4 | 4 | 3 |
| Example 25 | 3 | 5 | 4 | 4 | 3 | 4 | 4 | 3 |
| Example 26 | 4 | 5 | 4 | 4 | 3 | 4 | 4 | 4 |
| Comparative Example 1 | 3 | 4 | 4 | 1 | 3 | 1 | 2 | 1 |
| Comparative Example 2 | 2 | 4 | 2 | 4 | 1 | 3 | 1 | 1 |
| Comparative Example 3 | 4 | 4 | 5 | 1 | 3 | 2 | 2 | 1 |
| Comparative Example 4 | 4 | 3 | 4 | 1 | 2 | 2 | 1 | 1 |
| Comparative Example 5 | 2 | 4 | 3 | 3 | 2 | 2 | 1 | 1 |
| Comparative Example 6 | 3 | 3 | 4 | 2 | 2 | 2 | 2 | 1 |
| Comparative Example 7 | 1 | 4 | 2 | 4 | 1 | 2 | 1 | 1 |

(Component)

The following was used as each component described in Tables 1 to 4.

<Reactive emulsifier>

ADEKA REASOAP SE1025: ammonium salt of (α-sulfo(1-nonylphenoxy)methyl-2-(2-propenyloxy)ethoxy-poly(oxy-1,2-ethanediyl), manufactured by ADEKA Corporation

<Monobasic acid monomer>

AA: acrylic acid, manufactured by Mitsubishi Chemical Corporation
MAA: methacrylic acid, manufactured by Mitsubishi Chemical Corporation

<(Meth)acrylic acid ester>

BA: butyl acrylate (Mw: 128), manufactured by Mitsubishi Chemical Corporation
2-EHA: 2-ethylhexyl acrylate (Mw: 184), manufactured by Mitsubishi Chemical Corporation
LA: lauryl acrylate (Mw: 240), manufactured by Osaka Organic Chemical Industry Ltd.
ISTA: isostearyl acrylate (Mw: 324), manufactured by Osaka Organic Chemical Industry Ltd.
MPE400A: methoxy polyethylene glycol acrylate (Mw: 470), manufactured by Osaka Organic Chemical Industry Ltd.

<Polymer particles (i)>

LX111NF: polybutadiene latex (Tg: -82°C), manufactured by Zeon Corp.
SX1503A: acrylonitrile-butadiene copolymer latex (Tg: -26°C), manufactured by Zeon Corp.

<Thermoplastic elastomer (ii)>

TR2827: styrene-butadiene block copolymer (Tg: -88°C), manufactured by JSR Corp.
TR2787: styrene-butadiene block copolymer (Tg: -86°C), manufactured by JSR Corp.
T-315: styrene-butadiene block copolymer (Tg: -69°C), manufactured by Asahi Kasei Corp.
BR1220: polybutadiene rubber (Tg: -102°C), manufactured by Zeon Corp.

<Photopolymerizable compound (iii)>

1.9ND: 1.9-nonanediol dimethacrylate, manufactured by Kyoeisha Chemical Co., Ltd.
1.6HX-A: 1.6-hexanediol acrylate, manufactured by Kyoeisha Chemical Co., Ltd.
DCP-A: dimethyloltricyclodecane diacrylate, manufactured by Kyoeisha Chemical Co., Ltd.
TMP: trimethylolpropane trimethacrylate, manufactured by Kyoeisha Chemical Co., Ltd.
S: n-stearyl methacrylate, manufactured by Kyoeisha Chemical Co., Ltd.
IB-X: isobornyl methacrylate, manufactured by Kyoeisha Chemical Co., Ltd.
DCP: dimethyloltricyclodecane dimethacrylate, manufactured by Kyoeisha Chemical Co., Ltd.
BAC-45: polybutadiene diacrylate (Mn: 4800), manufactured by Osaka Organic Chemical Industry Ltd.
CN307: polybutadiene diacrylate (Mn: 3800), manufactured by Tomoe Engineering Co., Ltd.
CN9014NS: polybutadiene urethane diacrylate (Mn: 8000), manufactured by Tomoe Engineering Co., Ltd.

<Photopolymerization initiator (iv)>

Irg651: benzyl dimethyl ketal, manufactured by BASF Japan Ltd.

<Plasticizer (v)>

LBR-352: liquid polybutadiene, manufactured by Kuraray Co., Ltd.
Ricon156: liquid polybutadiene, manufactured by Tomoe Engineering Co., Ltd.
B3000: liquid polybutadiene, manufactured by Nippon Soda Co., Ltd.
PW-32: liquid paraffin, manufactured by Idemitsu Kosan Co., Ltd.

<Stabilizer (vi)>

BHT: 2,6-di-tert-butyl-p-cresol, manufactured by Tokyo Chemical Industry Co., Ltd.
MEHQ: 4-methoxyphenol, manufactured by Tokyo Chemical Industry Co., Ltd.

<Detergent builder (vii)>

EMAL 0: sodium lauryl sulfate, manufactured by Kao Corp.

Industrial Applicability

The present invention has industrial applicability as a flexographic printing plate for obtaining prints.
The disclosure of Japanese Patent Application No. 2022-081755 filed on May 18, 2022 is incorporated herein by reference in its entirety.
All literatures, patent applications, and technical standards described herein are incorporated herein by reference to the same extent as if each individual literature, patent application, or technical standard is specifically and individually indicated to be incorporated by reference.

Reference Signs List

10: flexographic printing raw plate, 11: support, 12: photosensitive resin composition layer, 12a: relief layer, 13: intermediate layer, 14: infrared ablation layer, 14a: negative pattern, S1: back exposure step, S2: infrared irradiation step, S3: pattern exposure step, S4: development step, 100: flexographic printing plate

**Claims**

1. A flexographic printing plate comprising at least: a support; and a relief layer sequentially stacked,
   wherein in dynamic elasticity mapping measurement by AFM on a cross section obtained by cutting 1 $\mu$m from a surface layer of a face on the side opposite to a face where the relief layer is in contact with the support,
   the cross section has at least:

   a region (A1) having a storage modulus of 100 MPa or more and 500 MPa or less at a frequency of 2,000 Hz; and
   a region (B1) having a storage modulus of 3 MPa or more and 15 MPa or less at a frequency of 2,000 Hz.

2. The flexographic printing plate according to claim 1, wherein

   an area ratio of the region (A1) is 3 area% or more and 35 area% or less based on the total area of the cross section, and
   an area ratio of the region (B1) is 35 area% or more and 65 area% or less based on the total area of the cross section.

3. The flexographic printing plate according to claim 1 or 2, wherein

   in a region (a1) obtained by subjecting the region (A1) to opening treatment by morphological operation,
   a ratio (a1'/a1) of an area of a region (a1') that is constituted by data on continuously adjacent pixels and has an area of 0.1 $\mu$m$^2$ or larger and 10 $\mu$m$^2$ or smaller per region to an area of the region (a1) is 90 area% or more and

56

100 area% or less.

4. The flexographic printing plate according to claim 1 or 2, wherein
a ratio (A1/B1) of the area ratio of the region (A1) to the area ratio of the region (B1) is 0.1 or more and 0.8 or less.

5. The flexographic printing plate according to claim 1 or 2, wherein

in the region (A1),
a ratio (A1'/A1) of an area of a region (A1') having a storage modulus of 100 MPa or more and 250 MPa or less at a frequency of 2,000 Hz to an area of the region (A1) is 50 area% or more and 100 area% or less.

6. The flexographic printing plate according to claim 1 or 2, wherein

in the region (B1),
a ratio (B1'/B1) of an area of a region (B1') having a storage modulus of 10 MPa or more and 15 MPa or less at a frequency of 2,000 Hz to an area of the region (B1) is 50 area% or more and 100 area% or less.

7. The flexographic printing plate according to claim 1 or 2, wherein

an average loss modulus at a frequency of 2,000 Hz in the region (A1) is 50 MPa or more and 250 MPa or less;
$\tan\delta$ ([average loss modulus] / [average storage modulus]) of the region (A1) at the frequency is 0.5 or more and 0.8 or less;
an average loss modulus at a frequency of 2,000 Hz in the region (B1) is 2 MPa or more and 10 MPa or less; and
$\tan\delta$ ([average loss modulus] / [average storage modulus]) of the region (B1) at the frequency is 0.4 or more and 0.7 or less.

8. The flexographic printing plate according to claim 1 or 2, wherein in the dynamic elasticity mapping measurement by AFM, the flexographic printing plate further having

a region (C1) having a storage modulus of more than 15 MPa and less than 100 MPa at a frequency of 2,000 Hz, and
an area ratio of the region (C1) is 25 area% or more and 55 area% or less based on the total area of the cross section.

9. The flexographic printing plate according to claim 8, wherein
a ratio (C1/B1) of the area ratio of the region (C1) to the area ratio of the region (B1) is 0.3 or more and 1.0 or less.

10. The flexographic printing plate according to claim 8 or 9, wherein

an average loss modulus at a frequency of 2,000 Hz in the region (C1) is 10 MPa or more and 50 MPa or less, and
$\tan\delta$ ([average loss modulus] / [average storage modulus]) of the region (C1) at the frequency is 0.45 or more and 0.75 or less.

11. A flexographic printing method comprising a step of performing printing using the flexographic printing plate according to claim 1 or 2.

12. A flexographic printing raw plate comprising at least: a support; and a photosensitive resin composition layer sequentially stacked, wherein under the following <Measurement condition 1>,
the photosensitive resin composition layer has at least a region (A2) having a storage modulus of 100 MPa or more and 500 MPa or less at a frequency of 2,000 Hz and a region (B2) having a storage modulus of 3 MPa or more and 15 MPa or less at 2,000 Hz.
<Measurement condition 1>
the photosensitive resin composition layer is isolated from the stack, molded into a thickness of 1.5 mm, and irradiated with ultraviolet light of 3000 mJ both from an upper face and from a lower face, and dynamic elasticity mapping measurement by AFM is performed on a cross section obtained by cutting 1 $\mu$m of a surface layer of the resulting cured product.

13. The flexographic printing raw plate according to claim 12, wherein

an area ratio of the region (A2) is 3 area% or more and 30 area% or less based on the total area of the cross section, and

an area ratio of the region (B2) is 35 area% or more and 70 area% or less based on the total area of the cross section.

14. The flexographic printing raw plate according to claim 12 or 13, wherein in dynamic viscoelasticity measurement at -30°C and 2.5 Hz,
the cured product has a storage modulus G' (MPa) of 2.0 or more and 18.0 or less.

15. The flexographic printing raw plate according to claim 12 or 13, wherein in dynamic viscoelasticity measurement at -30°C and 2.5 Hz,
the cured product has a storage modulus G' (MPa) and a loss modulus G'' (MPa) that satisfy the following expressions (1) and (2)

$$2.0 \leq G' + G'' \leq 25.0 \text{ expression (1)}$$

$$0.4 \leq G'' \leq 7.0 \text{ expression (2).}$$

16. The flexographic printing raw plate according to claim 12 or 13, wherein

the photosensitive resin composition layer comprises at least: polymer particles (i) having a glass transition temperature of -45°C or higher and - 10°C or lower; a thermoplastic elastomer (ii) having a glass transition temperature of -95°C or higher and -60°C or lower; a photopolymerizable compound (iii); and a photopolymerization initiator (iv), wherein
the polymer particles (i) comprise: an aromatic vinyl compound; and a conjugated diene compound, as monomer units constituting the polymer particles (i), and
the thermoplastic elastomer (ii) comprises: an aromatic vinyl compound; and a conjugated diene compound, as monomer units constituting the thermoplastic elastomer (ii).

17. The flexographic printing raw plate according to claim 16, wherein

the photosensitive resin composition layer comprises
a photopolymerizable compound having a number average molecular weight of 2,000 or more and 8,000 or less.

18. The flexographic printing raw plate according to claim 17, wherein

when the total amount of the photosensitive resin composition layer is defined as 100% by mass,
a content of the polymer particles (i) is 3% by mass or more and 30% by mass or less,
a content of the thermoplastic elastomer (ii) is 25% by mass or more and 55% by mass or less, and
a content of the photopolymerizable compound having a number average molecular weight of 2,000 or more and 8,000 or less is 1% by mass or more and 20% by mass or less.

19. The flexographic printing raw plate according to claim 12 or 13, wherein in the dynamic elasticity mapping measurement by AFM,
the cured product further has a region (C2) having a storage modulus of more than 15 MPa and less than 100 MPa at 2,000 Hz.

20. The flexographic printing raw plate according to claim 19, wherein

in the dynamic elasticity mapping measurement by AFM, in the cured product,
an area ratio of the region (C2) is 20 area% or more and 40 area% or less based on the total area of the cross section.

21. The flexographic printing raw plate according to claim 16, wherein

in the photosensitive resin composition layer,
a mass ratio of the polymer particles (i) to the thermoplastic elastomer (ii) is 0.1 or more and 1.0 or less.

22. The flexographic printing plate according to claim 12 or 13, wherein
a ratio (A2/B2) of the area ratio of the region (A2) to the area ratio of the region (B2) is 0.05 or more and 0.7 or less.

23. The flexographic printing raw plate according to claim 16, wherein
based on 100 parts by mass of the conjugated diene compound monomer unit as monomer units constituting the polymer particles (i), the polymer particles (i) comprise:

40 parts by mass or more and 120 parts by mass or less of an aromatic vinyl compound monomer unit; and
25 parts by mass or more and 140 parts by mass or less of a (meth)acrylic acid ester monomer unit.

24. The flexographic printing raw plate according to claim 16, wherein as a monomer unit constituting the polymer particles (i),

the polymer particles (i) comprise
a (meth)acrylic acid ester monomer unit having a number average molecular weight of 150 or more and 500 or less.

25. A manufacturing method of the flexographic printing raw plate according to claim 12 or 13, comprising the following steps 1 to 4 in the presented order:

step 1; a step of adding at least a photopolymerizable compound (iii) to an aqueous dispersion containing polymer particles (i) to obtain an aqueous dispersion containing polymer particles (i);
step 2; a step of removing water from the aqueous dispersion containing polymer particles (i) obtained in the step 1 to obtain a mixture comprising the polymer particles (i) and the photopolymerizable compound (iii);
step 3; a step of adding at least a thermoplastic elastomer (ii) to the mixture obtained in the step 2 to obtain a photosensitive resin composition; and
step 4; a step of stacking the photosensitive resin composition obtained in the step 3 on a support to obtain a flexographic printing raw plate.

26. A manufacturing method of the flexographic printing plate according to claim 1 or 2, comprising the following steps 1 and 2 in the presented order:

step 1; a step of partially and selectively exposing the photosensitive resin composition layer according to claim 12 or 13 through a negative pattern to obtain a partially cured product; and
step 2; a step of removing an unexposed part of the photosensitive resin composition layer from the partially cured product obtained in the step 1.

27. A printing method comprising:

a printing plate manufacturing step of manufacturing a printing plate by the manufacturing method of a flexographic printing plate according to claim 26; and
a printing step of performing printing using the flexographic printing plate obtained in the printing plate manufacturing step.

[Figure 1]

[Figure 2]

[Figure 3]

[Figure 4]

[Figure 5]

[Figure 6]

[Figure 7]

[Figure 8]

10

13 ‑‑‑ 14
12
11

↓

**Back exposure step S1**

13 ‑‑‑ 14
12a 12
11

⇧
UV

↓

**Infrared irradiation step S2**

14a

13 ‑‑‑
12a 12
11

↓

UV ⇩

**Pattern exposure step S3**

14a

13 ‑‑‑
12a
11

↓

100

**Development step S4**

12a ‑‑‑
11

[Figure 9]

Infrared irradiation step S2

Back exposure step S1 and
pattern exposure step S3

Development step S4

## INTERNATIONAL SEARCH REPORT

International application No.

**PCT/JP2023/017607**

### A. CLASSIFICATION OF SUBJECT MATTER

*G03F 7/004*(2006.01)i; *B41C 1/00*(2006.01)i; *B41M 1/04*(2006.01)i; *B41N 1/00*(2006.01)i; *G03F 7/032*(2006.01)i
FI: G03F7/004 502; G03F7/032; B41N1/00; B41C1/00; B41M1/04

According to International Patent Classification (IPC) or to both national classification and IPC

### B. FIELDS SEARCHED

Minimum documentation searched (classification system followed by classification symbols)

G03F7/004; B41C1/00; B41M1/04; B41N1/00; G03F7/032

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2017/057086 A1 (ASAHI KASEI CORP.) 06 April 2017 (2017-04-06) claims, examples | 1-22, 24-27 |
| Y | | 23 |
| Y | JP 2003-107681 A (ASAHI KASEI CORP.) 09 April 2003 (2003-04-09) paragraphs [0013]-[0018] | 23 |

☐ Further documents are listed in the continuation of Box C.　　☑ See patent family annex.

| | | |
|---|---|---|
| \* | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **11 July 2023** | **25 July 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

INTERNATIONAL SEARCH REPORT
Information on patent family members

International application No.

**PCT/JP2023/017607**

| Patent document cited in search report | | | Publication date (day/month/year) | Patent family member(s) | | | Publication date (day/month/year) |
|---|---|---|---|---|---|---|---|
| WO | 2017/057086 | A1 | 06 April 2017 | US | 2018/0275515 | A1 | |
| | | | | claims, examples | | | |
| | | | | EP | 3358410 | A1 | |
| | | | | CN | 107850845 | A | |
| | | | | TW | 201719284 | A | |
| JP | 2003-107681 | A | 09 April 2003 | (Family: none) | | | |

Form PCT/ISA/210 (patent family annex) (January 2015)

**REFERENCES CITED IN THE DESCRIPTION**

**Patent documents cited in the description**

- WO 2021039106 A
- WO 2017135118 A
- WO 2017057086 A
- WO 2019130784 A
- JP 2022081755 A

**Non-patent literature cited in the description**

- **TAKAHASHI, NAMBA**. Kaimenkasseizai handobukku (Surfactant Handbook. Kobayashi: Kougakutosho Ltd., 1972
- **J. BRANDUP** ; **E.H. IMMERGUT**. POLYMER HANDBOOK. John Willy & Sons, 1989
- **J. BRANDUP** ; **E.H. IMMERGUT**. POLYMER HANDBOOK. John Wiley & Sons, 1989
- Kaitei koubunshigousei no kagaku (Chemistry of polymer synthesis. Otsu: Kagaku-Dojin Publishing Company, INC, 1979
- Toagosei Annual Research Report. *TREND*, 1999, vol. 2, 20-26